(19) Europäisches Patentamt
European Patent Office
Office européen des brevets

(11) **EP 4 603 857 B1**

(12) **EUROPÄISCHE PATENTSCHRIFT**

(45) Veröffentlichungstag und Bekanntmachung des Hinweises auf die Patenterteilung:
**18.03.2026 Patentblatt 2026/12**

(21) Anmeldenummer: **25156118.9**

(22) Anmeldetag: **05.02.2025**

(51) Internationale Patentklassifikation (IPC):
**G01R 33/36** (2006.01)

(52) Gemeinsame Patentklassifikation (CPC):
**G01R 33/3642; G01R 33/3628**

(54) **ZUSATZELEMENT ZUM FOKUSSIEREN EINES ZEITLICH VERÄNDERLICHEN MAGNETFLUSSES FÜR DEN EINBAU IN EINE PROBENAUFNAHME EINES NMR-PROBENKOPFS**

ADDITIONAL ELEMENT FOR FOCUSING A TIME-VARIABLE MAGNETIC FLUX FOR INSTALLATION IN A SAMPLE HOLDER OF AN NMR SAMPLE HEAD

ACCESSOIRE POUR LA FOCALISATION D'UN FLUX MAGNÉTIQUE VARIABLE DANS LE TEMPS À MONTER DANS UN LOGEMENT D'ÉCHANTILLON D'UNE TÊTE D'ÉCHANTILLON RMN

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **15.02.2024 DE 102024201418**

(43) Veröffentlichungstag der Anmeldung:
**20.08.2025 Patentblatt 2025/34**

(73) Patentinhaber: **Bruker Switzerland AG**
**8117 Fällanden (CH)**

(72) Erfinder: **FREYTAG, Nicolas**
**8118 Pfaffhausen (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
- **BASTAWROUS MONICA ET AL: "Lenz Lenses in a Cryoprobe: Boosting NMR Sensitivity Toward Environmental Monitoring of Mass-Limited Samples", vol. 95, no. 2, 28 December 2022 (2022-12-28), pages 1327 - 1334, XP093284844, ISSN: 0003-2700, Retrieved from the Internet <URL:https://pubs.acs.org/doi/pdf/10.1021/acs.analchem.2c04203> [retrieved on 20250606], DOI: 10.1021/acs.analchem.2c04203**
- **SPENGLER NILS ET AL: "Magnetic Lenz lenses improve the limit-of-detection in nuclear magnetic resonance", PLOS ONE, vol. 12, no. 8, 15 August 2017 (2017-08-15), US, pages e0182779, XP093284835, ISSN: 1932-6203, DOI: 10.1371/journal.pone.0182779**
- **WADHWA SAGAR ET AL: "Topologically optimized magnetic lens for magnetic resonance applications", MAGNETIC RESONANCE, vol. 1, no. 2, 12 October 2020 (2020-10-12), pages 225 - 236, XP093284927, ISSN: 2699-0016, DOI: 10.5194/mr-1-225-2020**
- **LIANG JIANYI ET AL: "Broadband stripline Lenz lens achieves 11 x NMR signal enhancement", vol. 14, no. 1, 18 January 2024 (2024-01-18), US, XP093284924, ISSN: 2045-2322, Retrieved from the Internet <URL:https://www.nature.com/articles/s41598-023-50616-0> [retrieved on 20250606], DOI: 10.1038/s41598-023-50616-0**
- **TAJABADI ATAOLLAH M A A S ET AL: "Compact Magnetic Field Amplification by Tuned Lenz Lens", IEEE SENSORS JOURNAL, IEEE, vol. 23, no. 22, 27 July 2023 (2023-07-27), pages 27154 - 27160, XP011953436, ISSN: 1530-437X, [retrieved on 20230727], DOI: 10.1109/JSEN.2023.3297254**

**Beschreibung**

Die Erfindung betrifft ein Zusatzelement zum Fokussieren eines zeitlich veränderlichen Magnetflusses, für den Einbau in eine Probenaufnahme eines NMR-Probenkopfs,

wobei das Zusatzelement wenigstens bezüglich einer Draufsicht entlang einer Grundrichtung eine Abdeckzone und ein Durchgangsfenster ausbildet, wobei die Abdeckzone das Durchgangsfenster mit oder ohne Unterbrechungen umschließt,

wobei das Zusatzelement ein oder mehrere Abdeckelemente aufweist, die zumindest im Bereich eines Teils ihrer jeweiligen Randkurve oder äußeren Oberfläche elektrisch leitfähig sind, wobei die Gesamtheit der Abdeckelemente eine oder mehrere geschlossene Leiterschleifen ausbildet, die in besagter Draufsicht jeweils eine Leiterschleifenfläche umschließen, wobei die gesamte Überdeckung der einen oder mehreren Leiterschleifenflächen die Abdeckzone bildet, die einen Flächeninhalt $A_{ab\text{-}deck}$ aufweist,

wobei das Zusatzelement im Bereich des Durchgangsfensters elektrisch nicht leitfähig ist,

und wobei das Durchgangsfenster einen Flächeninhalt $A_{fenster}$ aufweist mit $A_{abdeck} \geq 2 * A_{fenster}$.

Ein solches Zusatzelement ist aus der US 2020/0217911 A1 bekannt geworden.

Kernspinresponanz (nuclear magnetic resonance, NMR)-Spektroskopie kann dazu eingesetzt werden, die chemische Zusammensetzung von Messproben zu analysieren. Dazu wird eine Messprobe einem homogenen statischen Magnetfeld ("B0-Feld", zeitlich konstant) eines Hintergrund-Magneten (oft ein supraleitender Hintergrundmagnet) ausgesetzt, und Hochfrequenz(=HF)-Pulse ("B1-Feld", zeitlich veränderlich) werden senkrecht zum statischen Magnetfeld in die Messprobe eingestrahlt und wechselwirken mit den Kernspins der Atome und Moleküle in der Messprobe. Ein resultierendes HF-Signal der Messprobe wird gemessen, und aus dem Messergebnis kann auf die Zusammensetzung der Messprobe geschlossen werden. Für die Messung ist die Messprobe in einem NMR-Probenkopf angeordnet, der einen HF-Resonator oder eine HF-Spule umfasst, und der HF-Resonator oder die HF-Spule umschließt die Messprobe. Der NMR-Probenkopf ragt dabei typischerweise in eine Magnetbohrung des Hintergrundmagneten ein. Für ein gutes Signal-zu-Rausch-Verhältnis (signal to noise ratio, SNR) der NMR-Messung sollten das B0-Feld und das Produkt B1*Q aus B1-Feld pro Einheitsstrom im Bereich der Messprobe und der Güte Q des auf die Messfrequenz abgestimmten Schwingkreises jeweils möglichst groß sein.

NMR-Probenköpfe sind vergleichsweise teure Messinstrumente, und viele Anwender besitzen lediglich einen NMR-Probenkopf, der mit einer Probenaufnahme für einen zylindrischen Körper mit einem bestimmten Durchmesser von in der Regel 5 mm ausgebildet ist ("Standard-Probenkopf"). Üblicherweise wird für eine Messung vorhandenes Probenmaterial mit einem Lösungsmittel verdünnt und in ein längliches Probenröhrchen eingefüllt, meist mit einem Außendurchmesser von 5 mm und einem Innendurchmesser von üblicherweise 4,2 - 4,5 mm ("Standard-Probenröhrchen"), welches in die Probenaufnahme eingesetzt wird. Die Messprobe sollte über eine Länge von in der Regel wenigstens 30 mm, bevorzugt wenigstens 40 mm, im Probenröhrchen stehen, um eine einfache und gute Homogenisierung ("Shimmen") des statischen Magnetfelds zu gewährleisten, und um das aktive Volumen bzw. das field of view der HF-Spule zu befüllen.

In vielen Anwendungsfällen steht jedoch nur wenig Probenmaterial zur Verfügung. Für die Vermessung in einem Standard-Probenkopf mit einem Standard-Probenröhrchen kann das Probenmaterial mit dem Lösungsmittel stark verdünnt werden, um das Standard-Probenröhrchen ausreichend zu befüllen. In diesem Fall wird nur ein vergleichsweise schwaches Messsignal mit einem geringen Signal-zu-Rausch-Verhältnis von der Messprobe erhalten.

Die Bruker Corporation, Billerica, MA, USA, bietet unter https://store.bruker.com/products/match-nmr-tube abgerufen am 3.1.2024 unter der Bezeichnung "MATCH NMR Tubes" spezielle dünne Probenröhrchen ("Kapillaren") an, die einen kleineren Außendurchmesser (zB 2,0 mm) und einen kleineren Innendurchmesser (zB 1,6 mm) besitzen als Standard-Probenröhrchen, und entsprechend mit einem geringen Volumen einer flüssigen Messprobe eine gewünschte befüllte Länge des dünnen Probenröhrchens einrichten können (zB mit den vorgenannten Maßen eine befüllte Länge von 40 mm mit einem Probenvolumen von 80 µl). Die dünnen Probenröhrchen werden in einer Halterung mit der Bezeichnung "MATCH Insert Assembly" angeordnet, und die Halterung kann in der Probenaufnahme eines Standard-Probenkopf angeordnet werden. Die dünnen Probenröhrchen können das Shimmen von Messproben bei geringem Probenvolumen erleichtern und erlauben die Füllhöhe zu reduzieren ohne die Homogenisierung des statischen Magnetfeldes im Field of View negativ zu beeinträchtigen, jedoch bleibt das Signal-zu-Rausch-Verhältnis vergleichbar zu dem bei Verdünnung in einem Standard NMR Röhrchen. Zudem sind die dünnen Probenröhrchen mechanisch empfindlich, insbesondere gegenüber Biegebelastung und Belastungen mit Gewicht, und erfordern eine sorgfältige Handhabung.

Aus der US 2020/0217911 A1 ist es bekannt geworden, ein Zusatzelement in einen HF-Resonator bzw. dessen HF-Spule einzusetzen, mit dem das B1-Feld in der HF-Spule des NMR-Probenkopfes in einen mittleren Bereich in der HF-Spule fokussiert werden kann. Das Zusatzelement wird auch als Lenz-Linse bezeichnet. Die Lenz-Linse umfasst ein oder mehrere Abdeckelemente aus Metall, durch die ein oder mehrere geschlossene Leiterschleifen eingerichtet werden. Mit den Abdeckelementen werden in Draufsicht entlang einer Grundrichtung, die der Richtung des B1-Felds entspricht, eine Abdeckzone und ein Durchgangsfenster eingerichtet. Der induzierte Stromfluss in den Leiterschleifen ist innen um das Durchgangsfenster herum umgekehrt zum Außenbereich. Aus der Abdeckzone wird das B1-Feld verdrängt, und zumindest teilweise in das Durchgangsfenster im mittleren Bereich der HF-Spule fokussiert. Dadurch kann ein stärkeres B1-Feld in dem mittleren Bereich, wo die Messprobe angeordnet wird, erreicht werden. Dadurch soll das Signal-zu-Rausch-Verhältnis bei NMR-Messungen mit einem herkömmlichen NMR-Probenkopf verbessert werden. In einer Ausführungsform sind Abdeckelemente in Ebenen angeordnet, die in Grundrichtung übereinander liegen, wobei in jeder Ebene zwei halb-lochscheibenförmige Abdeckelemente angeordnet sind, zwischen deren radialen Kanten jeweils ein Spalt liegt, und wobei die Spalten der verschiedenen Ebenen fluchten; entsprechend stellen sich in den übereinander liegenden Abdeckelementen jeweils gleichgerichtete Ströme ein, so dass diese Abdeckelemente keine nennenswerte kapazitive Kopplung aufweisen.

Durch die in der US 2020/0217911 A1 vorgeschlagenen Lenz-Linse werden in den Abdeckelementen Gegenströme induziert, deren zugehöriges Magnetfeld dem äußeren, zeitlich veränderlichen B1-Feld entgegengesetzt ist. Dadurch wird effektiv die Induktivität der HF-Spule oder des HF-Resonators des NMR-Probenkopfs um die Gegeninduktivität M verringert. Der Mess-Schwingkreis des NMR-Probenkopfes, zu dem die HF-Spule gehört, erfährt mit der Lenz-Linse daher eine Frequenzverschiebung FV (Frequenzerhöhung) bezüglich seiner Basis-Resonanzfrequenz ohne die Lenz-Linse. Je stärker die Fokussierung des B1-Feldes durch die Lenz-Linse, desto stärker ist die Frequenzverschiebung.

Üblicherweise verfügt ein NMR-Probenkopf über eine Abstimmeinrichtung, mit der die Basis-Resonanzfrequenz einer Eigenresonanz des elektrischen Mess-Schwingkreises in einem begrenzten Abstimmbereich verändert werden kann, um einen gewünschten Kern in einer konkreten Messprobe zu vermessen. Der Abstimmbereich der Abstimmeinrichtung ist typischerweise kleiner als 20 MHz für Messung von Protonen und im Bereich von 1-2 MHz für Messkerne bei tiefen Resonanzfrequenzen (von besonderem Interesse sind z. B. Stickstoff, Kohlenstoff, oder Phosphor). Bei hinreichend kleiner Frequenzverschiebung durch die Lenz-Linse kann die Abstimmeinrichtung die Frequenzverschiebung noch kompensieren. Wird die Frequenzverschiebung durch die Lenz-Linse jedoch zu groß, kann die Vermessung der Messprobe nicht mehr mit der vorhandenen Abstimmeinrichtung mit dem vorhandenen NMR-Probenkopf erfolgen. Dadurch wird die erreichbare SNR-Verbesserung mit der Lenz-Linse bei Nutzung eines vorhandenen NMR-Probenkopfs begrenzt. Würde das B1-Feld aus dem Bereich der Probenaufnahme eines NMR-Probenkopfs signifikant verdrängt respektive fokussiert (z. B. mit einem Faktor von 3 oder mehr), wären Frequenzverschiebungen von bis zu 50 MHz zu erwarten, die nicht mehr kompensiert werden können. Entsprechend kann mit einer Lenz-Linse gemäß US 2020/0217911 A1 nur ein vergleichsweise kleiner Teil des von der HF-Spule oder HF-Resonators erzeugten B1-Feldes fokussiert werden, und entsprechend auch nur eine vergleichsweise begrenzte Verbesserung des SNR erreicht werden.

Aus der US 4 680 549 A ist eine MRI-Apparatur bekannt geworden, umfassend eine erste, größere HF-Spule zum Senden und Empfangen von Signalen in und aus einem Zielbereich, und eine zweite, kleinere HF-Spule zum Empfangen von Signalen aus einem Teilstück des Zielbereichs.

Die EP 1 707 976 A1 beschreibt eine weitere MRI-Apparatur, wobei zwischen einer Körperspule und einem Untersuchungsobjekt eine Hilfsspule angeordnet ist. Wenn HF-Pulse von der Körperspule ausgesandt werden, fließt ein induzierter Strom durch die Hilfsspule und erzeugt ein Magnetfeld.

J. P. Vallée, Fundamentals of Cosmic Physics, Vol. 19, pp. 319-422 (1998), beschreibt im dortigen Abschnitt 2.2 ein magnetisches Dipolfeld.

Aufgabe der Erfindung

Es ist Aufgabe der Erfindung, ein Zusatzelement zur Verfügung zu stellen, mit dem das Signal-zu-Rauschverhältnis mit Messproben geringen Volumens bei Vermessung in einem vorhandenen NMR-Probenkopf weiter verbessert werden kann.

Beschreibung der Erfindung

Diese Aufgabe wird erfindungsgemäß gelöst durch ein Zusatzelement der eingangs genannten Art, das dadurch gekennzeichnet ist,

dass das Zusatzelement wenigstens eine kapazitiv wirkende Struktur umfasst, so dass das Zusatzelement einen elektrischen Schwingkreis umfassend das eine oder die mehreren Abdeckelemente ausbildet, mit einer Eigenresonanz einer Resonanzfrequenz RF,
mit

$$5 \text{ MHz} \leq RF \leq 3000 \text{ MHz}.$$

Die Erfindung schlägt vor, ein Zusatzelement einzusetzen, welches zum einen nach Art einer Lenz-Linse einen zeitlich veränderlichen Magnetfluss (also das B1-Feld) aus der Abdeckzone (zumindest zu einem großen Teil) in das Durchgangsfenster fokussieren kann, und zum anderen einen elektrischen Schwingkreis einrichtet, der eine Eigenresonanz mit einer Resonanzfrequenz in einem Bereich zwischen 5 MHz und 3000 MHz hat ("selbstresonante Struktur"). Um einen solchen elektrischen Schwingkreis einzurichten, umfasst das Zusatzelement wenigstens eine kapazitiv wirkende Struktur (auch kurz kapazitive Struktur genannt), beispielsweise einen Flächenkondensator zwischen gegenüberliegenden Kopplungsflächen eines Abdeckelements oder mehrerer Abdeckelemente.

Der durch das Zusatzelement eingerichtete Schwingkreis kann mit einem Mess-Schwingkreis des HF-Resonators oder der HF-Spule des NMR-Probenkopfs koppeln, wofür typischerweise das Zusatzelement in der Probenaufnahme innerhalb der HF-Spule oder des HF-Resonators des NMR-Probenkopfs angeordnet wird. Die Kopplung bewirkt eine Aufspaltung der Eigenresonanz des elektrischen Mess-Schwingkreises in eine untere Mode und eine obere Mode. Die untere Mode hat eine untere Modenresonanzfrequenz MRF1, die um eine Frequenzverschiebung RF1 niedriger ist als die ungekoppelte Resonanzfrequenz, und die obere Mode hat eine obere Modenresonanzfrequenz MRF2, die um eine Frequenzverschiebung RF2 höher ist als die ungekoppelte Resonanzfrequenz des Mess-Schwingkreises.

Zugleich bewirkt die Präsenz des Zusatzelements in der HF-Spule des HF-Resonators des NMR-Probenkopfs aufgrund der Verdrängung des zeitlich veränderlichen Magnetflusses eine Frequenzverschiebung FV, nämlich eine Frequenzerhöhung um FV der Resonanzfrequenz des Mess-Schwingkreises.

Wird nun eine NMR-Messung an einer Messprobe mittels der unteren Mode durchgeführt, kann die zugehörige Frequenzverschiebung RF1 die Frequenzverschiebung FV zumindest teilweise kompensieren; bevorzugt erfolgt die Kompensation im Wesentlichen exakt (z. B. mit einer Differenz |FV - RF1| von 10 MHz oder weniger, bevorzugt 5 MHz oder weniger, besonders bevorzugt 2,5 MHz oder weniger, ganz besonders bevorzugt 1 MHz oder weniger), was insbesondere durch eine geeignete Geometrie des Zusatzelements in Hinblick auf den vorgesehenen NMR-Probenkopf und die Wahl der Eigenresonanz des Zusatzelementes erreicht werden kann. Bei einem gegebenen Abstimmbereich einer Abstimmeinrichtung des NMR-Probenkopfs für die Resonanz des Mess-Schwingkreises kann dann auch eine vergleichsweise große (und bei ausreichend guter Kompensation im Prinzip beliebig große) Frequenzverschiebung FV hingenommen werden, wodurch eine stärkere Fokussierung des zeitlich veränderlichen Magnetflusses zugänglich wird, und damit auch eine stärkere Verbesserung des Signal-zu-Rauschverhältnisses im Vergleich zu einer herkömmlichen Lenz-Linse.

Das erfindungsgemäße Zusatzelement fungiert sowohl als Lenz-Linse (also ein passiv den zeitlich veränderlichen magnetischen Fluss fokussierendes Element) und als Schwingkreis, der durch bei Kopplung mit dem Mess-Schwingkreis eine Resonanzaufspaltung bewirkt.

Mittels der Abdeckzone bzw. den Abdeckelementen und dem Durchgangsfenster wird erreicht, dass ein entlang der Grundrichtung gerichteter, zeitlich veränderlicher Magnetfluss (B1-Feld) aus dem Bereich der Abdeckzone verdrängt werden kann und (zumindest großteils) im Bereich des Durchgangsfensters fokussiert werden kann. Hierbei gilt erfindungsgemäß $A_{abdeck} \geq 2*A_{fenster}$; ein zeitlich veränderlicher Magnetfluss ohne Zusatzelement, der sich über $A_{abdeck}+A_{fenster}$ verteilen würde und mit dem Zusatzelement auf $A_{fenster}$ fokussiert würde, würde sich auf eine um einen Faktor 3 kleinere Fläche verteilen und entsprechend verstärkt. Typischerweise wird durch das Zusatzelement (im Bereich des Durchgangsfensters) eine Verstärkung des B1-Felds um einen Faktor 5 oder mehr im Rahmen der Erfindung erreicht.

Bevorzugt ist $A_{abdeck} \geq 3*A_{fenster}$, besonders bevorzugt $A_{abdeck} \geq 5*A_{fenster}$, ganz besonders bevorzugt $A_{abdeck} \geq 10*A_{fenster}$.

Durch das eine oder die mehreren Abdeckelemente werden ein oder mehrere geschlossene Leiterschleifen eingerichtet, aus denen der zeitlich veränderliche Magnetfluss verdrängt wird, und (zumindest größtenteils) in das Durchgangsfenster fokussiert wird. Dabei ist ein (ohmscher) innerer Stromfluss am Rand des Durchgangsfensters umgekehrt zum (ohmschen) äußeren Stromfluss außen am Abdeckelement oder den Abdeckelementen. Man beachte, dass ein jeweiliges Abdeckelement nicht vollständig elektrisch leitfähig eingerichtet werden muss, sondern eine elektrische Leitfähigkeit im Bereich einer Randkurve oder einer äußeren Oberfläche genügt. Typischerweise wird ein Abdeckelement durch einen oder mehrere zylindrische metallische Körper und/oder ein oder mehrere Metallplatten ausgebildet; es sind aber auch ringartige Geometrien, etwa Metallplatten mit Löchern, möglich. Es sei auch angemerkt, dass im Allgemeinen ein jeweiliges Abdeckelement für sich, also durch sein Leitermaterial mit ohmschen Widerstand, in Draufsicht entlang der Grundrichtung jeweils nur unvollständig das Durchgangsfensters umgreift. Das Durchgangsfenster ist elektrisch nicht leichtfähig; typischerweise wird das Durchgangsfenster einfach durch eine Ausnehmung oder einen Durchbruch gebildet und ist "leer"; es kann aber auch teilweise oder vollständig von einem Dielektrikum eingenommen sein.

Der durch das Zusatzelement eingerichtete elektrische Schwingkreis hat erfindungsgemäß eine Resonanzfrequenz RF mit $5 \text{ MHz} \leq RF \leq 3000 \text{ MHz}$. Mit einer solchen Resonanzfrequenz kann bei üblichen HF-Resonatoren bzw.

üblichen NMR-Probenköpfen eine Aufspaltung der Eigenresonanz des elektrischen Mess-Schwingkreises des NMR-Probenkopfs erreicht werden, bei der die Resonanzverschiebung RF1 der unteren Mode betragsmäßig ungefähr im Bereich der Frequenzverschiebung FV durch das Zusatzelement bei einer signifikanten Fokussierung (insbesondere mit einem Faktor 3 oder mehr) des zeitlich veränderlichen Magnetflusses liegt. Bevorzugt ist RF $\leq$ 2500 MHz; weiterhin ist bevorzugt RF $\geq$ 400 MHz, besonders bevorzugt RF $\geq$ 500 MHz. Typischerweise ist RF > BRF, mit BRF Basis-Resonanzfrequenz des NMR-Probenkopfs bzw. der Messanordnung (ohne Zusatzelement). Man beachte, dass die Resonanz des Schwingkreises des Zusatzelements typischerweise ein dipolares Feld erzeugt.

Der elektrische Schwingkreis, der durch das Zusatzelement ausgebildet wird, enthält die wenigstens eine kapazitiv wirkende Struktur. Eine solche kapazitiv wirkende Struktur wird typischer Weise durch die Geometrie und Anordnung des oder der Abdeckelemente eingerichtet; es können aber auch alternativ oder zusätzlich ein oder mehrere Kondensatoren über Zuleitungen an das oder die Abdeckelemente angeschlossen werden. Ein zu dem elektrischen Schwingkreis zuordenbarer (Wechsel-)Stromkreis, der die kapazitiv wirkende Struktur enthält, umschließt (in Aufsicht entlang der Grundrichtung) typischerweise das Durchgangsfester vollständig. Man beachte, dass in herkömmlichen Lenz-Linsen keine merklichen kapazitiv wirkenden Strukturen enthalten sind, so dass diese herkömmlichen Lenz-Linsen keine Schwingkreise mit Resonanzfrequenzen im erfindungsgemäßen Frequenzbereich ausbilden können.

Die Zusatzelemente gemäß der Erfindung können mit im Wesentlichen eben angeordneten Abdeckelementen aufgebaut werden. Die Abdeckelemente liegen dann senkrecht zur Grundrichtung. Dadurch kann kostengünstig und kompakt bezüglich (in der Regel nur) der Grundrichtung eine B1-Feldkompression und (in der Regel nur) ein Schwingkreis eingerichtet werden. Die ebenen Abdeckelemente (meist angeordnet in einem oder mehreren Sandwiches) können in einem Glasröhrchen für eine bessere Handhabung angeordnet werden. Alternativ können die Abdeckelemente auch dreidimensional aufgebaut werden. Dann kann relativ einfach auch (wenigstens) eine zweite Eigenresonanz in einer zweiten Orientierung eingerichtet werden (in der auch eine Feldkompression erfolgen kann), falls gewünscht. Zudem kann dann die Grundform des Zusatzelements bereits im Wesentlichen zylinderförmig eingerichtet werden, ähnlich einem herkömmlichen Probenröhrchen, um die Handhabung zu erleichtern.

Bevorzugte Ausführungsformen der Erfindung

*Ausführungsformen betreffend die Stromführung*

Bevorzugt ist eine Ausführungsform des erfindungsgemäßen Zusatzelements, bei der das Zusatzelement so ausgebildet ist, dass bei dieser Eigenresonanz der Strom auf dem Zusatzelements keine Stromknoten aufweist. Mit anderen Worten, die Mode der Eigenresonanz hat keine Stromknoten. In diesem Fall ist eine sehr gute Kopplung des Schwingkreises des Zusatzelements mit dem Mess-Schwingkreis des NMR-Probenkopfs möglich.

Ebenso bevorzugt ist eine Ausführungsform, bei der das Zusatzelement so ausgebildet ist, dass bei dieser Eigenresonanz auf dem Zusatzelement ein Kreisstrom fließt, der das Durchgangsfenster vollständig umschließt. Mit anderen Worten, in der Mode der Eigenresonanz fließt (in Draufsicht entlang der Grundrichtung) ein im Wesentlichen konstanter Wechselstrom um das Durchgangsfenster herum; dabei durchfließt dieser Wechselstrom auch die wenigstens eine kapazitive Struktur. In diesem Fall ist ebenfalls eine sehr gute Kopplung des Schwingkreises des Zusatzelements mit dem Mess-Schwingkreis des NMR-Probenkopfs möglich.

Bei einer vorteilhaften Ausführungsform ist vorgesehen,

dass die wenigstens eine kapazitiv wirkende Struktur zwei einander gegenüberliegende Kopplungsflächen umfasst, die an zwei Abdeckelementen oder an zwei gegenüberliegenden Enden eines Abdeckelements ausgebildet sind, und dass die einander gegenüberliegenden Kopplungsflächen zumindest teilweise überlappen und eine Überlappungsfläche UEF aufweisen, wobei UEF $\geq$ 0,5 mm$^2$, bevorzugt $\geq$ 1,0 mm$^2$. Dadurch kann auf einfache Weise eine kapazitiv wirkende Struktur mit vergleichsweise hoher Kapazität eingerichtet werden. Die Kopplungsflächen sind bevorzugt eben ausgebildet, sie können aber auch gekrümmt ausgebildet sein. Ebene Kopplungsflächen können insbesondere senkrecht zur Grundrichtung liegen (z. B. bei Zusatzelementen mit wenigstens einem Sandwich von Abdeckelementen, siehe unten), sie können aber auch parallel oder in einem schrägen Winkel zur Grundrichtung liegen. Bevorzugt ist weiterhin UEF $\leq$ 300 mm$^2$.

*Ausführungsformen mit Sandwich-Geometrie*

Bevorzugt ist eine Ausführungsform, bei der das Zusatzelement wenigstens ein erstes Sandwich von Abdeckelementen umfasst, wobei das erste Sandwich eine erste Sandwichebene und eine zweite Sandwichebene umfasst,

wobei in der ersten Sandwichebene, die senkrecht zur Grundrichtung liegt, sich ein oder mehrere Abdeckelemente flächig erstrecken, und in der zweiten Sandwichebene, die senkrecht zur Grundrichtung liegt, sich ein oder mehrere Abdeckelemente flächig erstrecken,
wobei die erste Sandwichebene und die zweite Sandwichebene bezüglich der Grundrichtung übereinander liegen, und die Abdeckelemente der ersten Sandwichebene und der zweiten Sandwichebene zumindest teilweise überlappen. Durch die überlappenden Abdeckelemente der ersten Sandwichebene und der zweiten Sandwichebene können Kopplungsflächen bzw. kapazitiv wirkende Strukturen besonders einfach und kompakt eingerichtet werden. Man beachte, dass Zusatzelemente in Sandwich-Geometrie insbesondere gut für die Untersuchung von 1H-Kernen eingesetzt werden können.

In einer vorteilhaften Weiterbildung dieser Ausführungsform ist vorgesehen,

dass in der ersten Sandwichebene das eine oder die mehreren Abdeckelemente umlaufend um das Durchgangsfenster angeordnet sind, und in Umlaufrichtung einander gegenüberliegende Enden des einen oder der mehreren Abdeckelemente jeweils durch einen Unterbrechungsspalt getrennt sind,
dass in der zweiten Sandwichebene das eine oder die mehreren Abdeckelemente umlaufend um das Durchgangsfenster angeordnet sind, und in Umlaufrichtung einander gegenüberliegende Enden des einen oder der mehreren Abdeckelemente jeweils durch einen Unterbrechungsspalt getrennt sind,
und dass die Unterbrechungsspalten der ersten Sandwichebene und der zweiten Sandwichebene in Umlaufrichtung gegeneinander versetzt sind.
Dieser Aufbau ist in der Praxis besonders bewährt, um einen umlaufenden Wechselstromfluss im Schwingkreis des Zusatzelements einzurichten. Ein jeweiliger Unterbrechungsspalt der einen Sandwichebene wird durch einen ununterbrochenen Abschnitt eines Abdeckelements der anderen Sandwichebene überbrückt und umgekehrt. An den überlappenden flächigen Abdeckelementen als Flächenkondensator benachbart vor und hinter einem Unterbrechungsspalt in der einen Sandwichebene kann der Wechselstrom im elektrischen Schwingkreis leicht in die andere Sandwichebene übertreten und dort in dem überbrückenden Abschnitt des Abdeckelements den Unterbrechungsspalt überwinden, und so einen (für Wechselstrom) geschlossenen Stromkreis ausbilden.

Bei einer bevorzugten Untervariante dieser Weiterbildung ist vorgesehen,

dass die erste Sandwichebene genau ein Abdeckelement enthält, welches das Durchgangsfenster umgreift und dessen Enden an einem Unterbrechungsspalt voneinander getrennt sind,
dass die zweite Sandwichebene genau ein Abdeckelement enthält, welches das Durchgangsfenster umgreift und dessen Enden an einem Unterbrechungsspalt voneinander getrennt sind,
und dass die Unterbrechungsspalten der ersten Sandwichebene und der zweiten Sandwichebene in Umlaufrichtung einander gegenüberliegen,
insbesondere wobei das Durchgangsfenster eine lange Seite und eine kurze Seite aufweist und die Unterbrechungsspalten der ersten Sandwichebene und der zweiten Sandwichebene in die kurze Seite des Durchgangsfensters münden.

Man beachte, dass die Messprobe bzw. ein zugehöriger Probenkanal oder Probenraum typischerweise entlang der langen Seite ausgerichtet ist. In dieser Untervariante liegt der Unterbrechungsspalt, der in Hinblick auf eine gewünschte Feldhomogenität eine Störung der Struktur darstellt, am Ende der Messprobe. Da am Ende der Messprobe ohnehin eine lediglich approximative Kompensation der Suszeptibilität erfolgt, hat eine Störung der Struktur hier nicht so große Auswirkungen auf die Linienbreite der Messprobe. Die Bauform ist entsprechend besonders fehlertolerant, insbesondere im Vergleich zu einem Unterbrechungsspalt der als ein Spalt irgendwo in der Mitte des Fensters bzw. in der Mitte der langen Seite liegt. Typischerweise liegt der Unterbrechungsspalt ungefähr, und bevorzugt genau, in der Mitte der jeweiligen kurzen Seite.
Bei einer bevorzugten Weiterbildung ist zwischen den Abdeckelementen der ersten Sandwichebene und der zweiten Sandwichebene eine Schicht eines Dielektrikums angeordnet ist. Unter Dielektrikum wird hier jede schwach oder nicht leitende Substanz verstanden, in der die vorhandenen Ladungsträger nicht frei beweglich sind und die über eine relative Permittivität $\varepsilon_r > 1$ verfügt, unabhängig davon, ob diese Substanz funktionsbestimmend ist oder lediglich als Isolierstoff eingesetzt wird. Über das Dielektrikum kann die Kapazität einer zwischen den Sandwichebenen eingerichteten kapazitiven Struktur beeinflusst werden.
Wenn die Schicht eine homogene Dicke aufweist und in z-Richtung (B0-Richtung) lang gegenüber dem Fenster der Struktur/des Zusatzelements ist, dann muss die Suszeptibilität des Dielektrikums nicht kompensiert sein und die Struktur/das Zusatzelement kann auf anderes, z. B. elektrische Verluste, optimiert werden. Dadurch kann die Performanz des Zusatzelementes erhöht werden.
Typischerweise gilt für einen Abstand DD ("Dicke Dielektrikum") der Abdeckelemente der ersten Sandwichebene und der zweiten Sandwichebene (in Grundrichtung) für den Fall, dass ein Probenkanal oder Probenraum zwischen der ersten Sandwichebene und der zweiten Sandwichebene verläuft:

$$0{,}5*Ds \leq DD \leq 1{,}5*Ds,$$

mit Ds: Durchmesser des Probenkanals oder Probenraums.

Falls der Probenkanal oder Probenraum an anderer Stelle verläuft, insbesondere oberhalb oder unterhalb des ersten Sandwichs (z. B. zwischen dem ersten Sandwich und einem zweiten Sandwich, siehe unten), so gilt typischerweise:

$$0{,}1 \text{ mm} \leq DD \leq (Dp\text{-}Ds)/2,$$

mit Dp: maximaler Außendurchmesser des Zusatzelements; man beachte, dass Dp im wesentlichen Dmax entspricht, mit Dmax: maximaler Durchmesser eines zylindrischen Körpers, der in die Probenaufnahme eines zugehörigen NMR-Probenkopfs einführbar ist. Entsprechendes gilt für ein etwaiges zweites Sandwich (siehe unten).

Vorteilhaft ist auch eine Weiterbildung, die vorsieht,

dass das Zusatzelement weiterhin wenigstens ein zweites Sandwich von Abdeckelementen umfasst, wobei das zweite Sandwich eine dritte Sandwichebene und eine vierte Sandwichebene umfasst,
wobei in der dritten Sandwichebene, die senkrecht zur Grundrichtung liegt, sich ein oder mehrere Abdeckelemente flächig erstrecken, und in der vierten Sandwichebene, die senkrecht zur Grundrichtung liegt, sich ein oder mehrere Abdeckelemente flächig erstrecken,
wobei die dritte Sandwichebene und die vierte Sandwichebene bezüglich der Grundrichtung übereinander liegen, und die Abdeckelemente der dritten Sandwichebene und der vierten Sandwichebene zumindest teilweise überlappen,
und dass das erste Sandwich von Abdeckelementen und das zweite Sandwich von Abdeckelementen bezüglich der Grundrichtung übereinander liegen, und die Abdeckelemente des ersten Sandwiches und des zweiten Sandwiches zumindest teilweise überlappen,
insbesondere wobei das Zusatzelement einen Probenkanal oder Probenraum ausbildet, der zwischen dem ersten Sandwich und dem zweiten Sandwich verläuft. Mittels des zweiten Sandwich kann die Kapazität im Schwingkreis des Zusatzelements erhöht werden. Jedes Sandwich, und falls gewünscht auch zwischen den beiden Sandwiches, können platzsparend Flächenkondensatoren eingerichtet werden. Typischerweise gilt für einen Abstand Dz ("Dicke Zwischenraum") zwischen der zweiten Sandwichebene und der dritten Sandwichebene (gelegen zwischen dem ersten Sandwich und dem zweiten Sandwich, wo der Probenkanal oder Probenraum verläuft):

$$0{,}5*Ds \leq Dz \leq 1{,}5*Ds,$$

mit Ds: Durchmesser des Probenkanals oder Probenraums.

Bevorzugt ist auch eine Weiterbildung, bei der das Zusatzelement ein zylindrisches Glasröhrchen umfasst, in welches die Abdeckelemente des oder der Sandwiches eingefügt sind. Mit zylindrischen Glasröhrchen kann eine Anpassung des Zusatzelements an die Probenaufnahme eines herkömmlichen NMR-Probenkopfs erfolgen, und das Zusatzelement kann mit dem Glasröhrchen unmittelbar eingesetzt werden und auch von üblichen Transporteinrichtungen leicht gehandhabt werden.

*Ausführungsformen mit hantelartiger Geometrie*

Eine vorteilhafte Ausführungsform sieht vor,

dass das Zusatzelement zwei einander gegenüberliegende Endabschnitte aufweist, die jeweils mit einem Metallzylinder ausgebildet sind, und einen Verbindungsabschnitt aufweist, der mit einer Metallplatte ausgebildet ist, die senkrecht zur Grundrichtung verläuft,
wobei der Verbindungsabschnitt die Endabschnitte verbindet,
wobei im Verbindungsabschnitt das Durchgangsfenster ausgebildet ist, und das Durchgangsfenster die Metallplatte des Verbindungsabschnitts quer zur Grundrichtung elektrisch unterteilt,
dass ein Probenkanal oder ein Probenraum entlang der Zylinderachsen der Metallzylinder durch die Endabschnitte und durch den Verbindungsabschnitt im Bereich des Durchgangsfensters verläuft,
und dass wenigstens einer der Endabschnitte zumindest einen oberen Schlitz aufweist, der sich vom Probenkanal oder Probenraum zu einer Zylinderaußenseite des zugehörigen Metallzylinders erstreckt und den Metallzylinder dieses Endabschnitt im Umfangsrichtung elektrisch unterteilt, und wenigstens einer der Endabschnitte zumindest einen unteren Schlitz aufweist, der sich vom Probenkanal oder Probenraum zu einer Zylinderaußenseite des zugehörigen Metallzylinders erstreckt und den Metallzylinder dieses Endabschnitts im Umfangsrichtung elektrisch unterteilt, wobei bezüglich der Grundrichtung der obere Schlitz oberhalb und der untere Schlitz unterhalb der Metallplatte verlaufen,

insbesondere wobei der obere Schlitz und der untere Schlitz mit einem Dielektrikum gefüllt sind. Über die zylindrischen Endabschnitte kann eine Grundform des Zusatzelements ausgebildet werden, die für ein direktes Einsetzen in die Probenaufnahme eines üblichen NMR-Probenkopfs geeignet ist. Zudem können über den oberen Schlitz und den unteren Schlitz kapazitiv wirkende Strukturen mit vergleichsweise großer Kondensatorfläche bzw. vergleichsweise großer Kapazität auf einfache Weise eingerichtet werden.

Bei einer bevorzugten Weiterbildung dieser Ausführungsform ist vorgesehen,

dass auf dem Metallzylinder eines jeweiligen Endabschnitts, der einen oberen Schlitz und/oder unteren Schlitz aufweist, ein Metallrohr angeordnet ist, wobei ein radialer Spalt zwischen dem Metallzylinder und dem Metallrohr durch ein Dielektrikum gefüllt ist,

und dass das Metallrohr den Schlitz an der Zylinderaußenseite des Metallzylinders übergreift. Zusätzlich zu dem Flächenkondensator am oberen und/oder Schlitz kann über zwei weitere Flächenkondensatoren, die über den radialen Spalt vor dem Schlitz zum Metallrohr und nach dem Schlitz von Metallrohr wieder zu hinter dem Spalt führen, ein paralleler Wechselstrompfad eingerichtet werden.

Durch das Metallrohr kann auf einfache und effektive Weise im Schwingkreis die Kapazität erhöht werden.

Vorteilhaft ist auch eine Weiterbildung, bei der wenigstens einer der Endabschnitte sowohl einen oberen Schlitz als auch einen unteren Schlitz aufweist. Dies ist einfach zu fertigen und ermöglicht eine besonders hohe Kapazität bereits an einem Metallzylinder.

Bei einer anderen, vorteilhaften Weiterbildung weist das Zusatzelement einen zusätzlichen Mittelschlitz auf, der in der Mitte des Zusatzelements senkrecht zur Grundrichtung verläuft, und die beiden Metallzylinder und auch die Metallplatte in eine obere Hälfte und eine untere Hälfte elektrisch unterteilt, wobei der Mittelschlitz den Probenraum oder Probenkanal schneidet, und wobei der Mittelschlitz mit einem Dielektrikum gefüllt ist. Über den Mittelschlitz kann eine ohmsche Unterteilung in eine obere und eine untere Hälfte des Zwischenstücks erfolgen. Dadurch kann der Wechselstrom in einer gewünschten Weise dirigiert werden. Ebenso können über den Mittelschlitz ein oder mehrere Flächenkondensatoren eingerichtet werden, die als kapazitiv wirkende Strukturen dienen können. Zudem kann falls gewünscht über den Mittelschlitz eine Verwendung des Zusatzelements in zwei um 90° verdrehte Orientierungen eingerichtet werden.

Bevorzugt ist auch eine Ausführungsform, die vorsieht,

dass das Zusatzelement zwei einander gegenüberliegende Endabschnitte aufweist, die jeweils mit einem Metallzylinder ausgebildet sind, und einen Verbindungsabschnitt aufweist, der mit vier Metallplattenteilen ausgebildet ist, die kreuzförmig um einen Probenkanal oder Probenraum angeordnet sind, und die unter 45° zur Grundrichtung ausgerichtet sind,

wobei der Verbindungsabschnitt mit den Metallplattenteilen die Endabschnitte verbindet,

wobei im Verbindungsabschnitt das Durchgangsfenster ausgebildet ist,

dass der Probenkanal oder der Probenraum entlang der Zylinderachsen der Metallzylinder durch die Endabschnitte und den Verbindungsabschnitt im Bereich des Durchgangsfensters verläuft,

und dass ein erster Endabschnitt der Endabschnitte einen ersten Schlitz aufweist, der parallel zur Grundrichtung verläuft und den Metallzylinder dieses Endabschnitts in eine rechte Hälfte und eine linke Hälfte elektrisch unterteilt, und ein zweiter Endabschnitt der Endabschnitte einen zweiten Schlitz aufweist, der mittig durch das Zusatzelement senkrecht zur Grundrichtung verläuft und den Metallzylinder dieses Endabschnitts in eine obere Hälfte und eine untere Hälfte elektrisch unterteilt,

insbesondere wobei der erste Schlitz und der zweite Schlitz mit einem Dielektrikum gefüllt sind,

und insbesondere wobei der erste Schlitz und der zweite Schlitz eine unterschiedliche Schlitzbreite haben und/oder mit einem unterschiedlichen Dielektrikum gefüllt sind. Diese Ausführungsform ist gut dafür geeignet, das Zusatzelement wahlweise in zwei Orientierungen zu verwenden, die um 90° zueinander gedreht sind, um zwei unterschiedliche Atomkerne ohne zwischenzeitliches Rotieren des Einsatzes vermessen zu können. Über die Schlitzbreiten und/oder die Wahl des Dielektrikums im jeweiligen Schlitz kann eine individuelle Resonanzfrequenz in der jeweiligen Orientierung eingerichtet werden.

Vorteilhaft ist eine Ausführungsform, die vorsieht,

dass das Zusatzelement aus einem zylindrischen Metallkörper gebildet ist, wobei der Metallkörper einen mittleren Abschnitt und beidseits des mittleren Abschnitts zwei Seitenabschnitte aufweist,

wobei der Metallkörper zur Ausbildung des Durchgangsfensters in dem mittleren Abschnitt eine Ausnehmung aufweist, die entlang der Grundrichtung durch den Metallkörper verläuft und den mittleren Abschnitt quer zur Grundrichtung elektrisch unterteilt,

dass das Zusatzelement einen Probenkanal oder Probenraum aufweist, der sich entlang einer Zylinderachse des Metallkörpers erstreckt, wobei der Probenkanal oder Probenraum das Durchgangsfenster schneidet,

und dass der Metallkörper geschlitzte Bereiche aufweist, die sich vom Probenkanal oder Probenraum aus zu einer Metallkörperaußenseite hin erstrecken und den Metallkörper im mittleren Abschnitt und/oder in einem der Seitenabschnitte elektrisch unterteilen,

insbesondere wobei in den geschlitzten Bereichen und/oder in der Ausnehmung ein Dielektrikum angeordnet ist. Diese Ausführungsform ist sehr einfach zu fertigen. Beispielsweise können in einem ersten der Seitenabschnitte geschlitzte Bereiche parallel zur Grundrichtung oberhalb und/oder unterhalb des Probenkanals/Probenraums vorgesehen sein. Weiterhin können beispielsweise im zweiten der Seitenabschnitte geschlitzte Bereiche senkrecht zur Grundrichtung links und/oder rechts des Probenkanals/Probenraums vorgesehen sein.

Eine Untervariante dieser Weiterbildung sieht vor, dass der Metallkörper geschlitzte Bereiche aufweist, mit

- einem ersten geschlitzten Bereich in einem ersten Seitenabschnitt der beiden Seitenabschnitte, wobei der erste geschlitzte Bereich parallel zur Grundrichtung mittig durch den ersten Seitenabschnitt verläuft,
- einem zweiten geschlitzten Bereich in einem zweiten Seitenabschnitt der beiden Seitenabschnitte, wobei der zweite geschlitzte Bereich senkrecht zur Grundrichtung mittig durch den zweiten Seitenabschnitt verläuft,
- und einen dritten geschlitzten Bereich im mittleren Abschnitt, wobei der dritte geschlitzte Bereich senkrecht zur Grundrichtung mittig durch den mittleren Abschnitt verläuft. Diese Variante ist einfach zu fertigen, und auch gut für eine Einrichtung von zwei Resonanzen (in um 90° verdrehten Orientierungen) geeignet. Falls das Zusatzelement für zwei Resonanzen vorgesehen ist, kann die Ausnehmung des Durchgangsfensters für die erste Resonanz gleichzeitig einen dritten geschlitzten Bereich für die zweite Resonanz darstellen.

*Weitere Ausführungsformen*

Bevorzugt ist weiterhin eine Ausführungsform, bei der das Zusatzelement eine im Wesentlichen zylindrische Außengestalt aufweist,

insbesondere wobei die Außengestalt einem Probenröhrchen entspricht. Dann kann das Zusatzelement mit herkömmlichen Probentransportsystemen beladen und entladen werden. Das Zusatzelement kann leicht direkt in einem herkömmlichen NMR-Probenkopf eingesetzt werden.

Vorteilhaft ist auch eine Ausführungsform, bei der das Zusatzelement ein Abstimmelement umfasst, mit welchem die Resonanzfrequenz RF des elektrischen Schwingkreises veränderbar ist,

insbesondere wobei mit dem Abstimmelement eine im elektrischen Schwingkreis enthaltene Gesamtkapazität veränderbar ist. Dadurch ist es möglich, das Zusatzelement an einen vorhandenen Probenkopf und/oder eine konkrete Messaufgabe auf einfache Weise anzupassen. Um die Gesamtkapazität zu verändern, umfasst das Abstimmelement wenigstens einen abstimmbaren Kondensator, unbeschadet etwaiger weiterer, nicht abstimmbarer Kondensatoren/Kapazitäten im elektrischen Schwingkreis.

Bevorzugt ist eine Weiterbildung dieser Ausführungsform, bei der das Zusatzelement als Abstimmelement einen Trimmerkondensator umfasst,

insbesondere wobei der Trimmerkondensator bezüglich einer Querrichtung, die senkrecht zur Grundrichtung verläuft, in einer Entfernung von wenigstens ENT vom Durchgangsfenster am übrigen Zusatzelement angeordnet ist, mit ENT $\geq 5$ mm.

Die Querrichtung entspricht im Allgemeinen der Richtung einer langen Seite/Längsrichtung des Durchgangsfensters. Mit dem Trimmerkondensator kann die Abstimmung des Zusatzelements einfach und kostengünstig erfolgen. Durch eine Anordnung wenigstens 5 mm entfernt vom Durchgangsfenster (bezogen auf die Querrichtung, entlang einer langen Seite des Durchgangsfensters) können Störungen des statischen Magnetfelds minimiert werden, die die Linienbreite der gemessenen Substanzen negativ beeinflussen würden.

Bevorzugt ist auch eine Weiterbildung der obigen Ausführungsform, wobei zwischen den Abdeckelementen einer ersten Sandwichebene und einer zweiten Sandwichebene eine Schicht eines Dielektrikums vorgesehen ist (siehe oben), und vorgesehen ist, dass das Abstimmelement dazu ausgebildet ist, durch mechanischen Druck auf die Abdeckelemente der ersten Sandwichebene und/oder der zweiten Sandwichebene eine Dicke DD der Schicht des Dielektrikums zu verändern, insbesondere wobei das Abstimmelement eine Schraube umfasst. Durch den mechanischen Druck kann der Abstand zwischen den Abdeckelementen der ersten und zweiten Sandwichebene auf einfache Weise verändert werden, und die Resonanzfrequenz RF sehr exakt eingestellt werden. Mit einer Schraube ist dies auch kostengünstig und leicht handhabbar. Die Schraube ist bevorzugt wenigstens 5 mm (in Querrichtung) vom Durchgangsfenster entfernt angeordnet.

Besonders bevorzugt ist eine Ausführungsform, bei der das Zusatzelement wenigstens ein Abschirmelement umfasst, welches eine Penetration von zeitlich veränderlichem Magnetfluss in wenigstens einem Teil eines Probenkanals oder Probenraums des Zusatzelements, der sich an das Durchflussfenster anschließt, blockiert, insbesondere wobei das Zusatzelement wenigstens zwei Abschirmelemente umfasst, welche die Penetration von zeitlich veränderlichem Magnetfluss in zwei Teile des Probenkanals oder Probenraums des Zusatzelements, die sich an gegenüberliegenden Seiten an das Durchflussfenster anschließen, blockiert. Dadurch kann das Signal-zu-Rauschverhältnis bei wenig Probenvolumen der Messprobe verbessert werden.

Bevorzugt ist eine Ausführungsform, bei der das Zusatzelement so ausgebildet ist, dass es für einen zeitlich veränderlichen Magnetfluss entlang einer Zweitrichtung, die orthogonal zur Grundrichtung verläuft, im Wesentlichen transparent ist, so dass durch das Zusatzelement der zeitlich veränderliche Magnetfluss entlang der Zweitrichtung in einem Probenkanal oder Probenraum des Zusatzelements im Bereich des Durchgangsfensters relativ um maximal 20% reduziert wird,

insbesondere wobei das Zusatzelement einen Durchlassspalt ausbildet, der senkrecht zur Grundrichtung verläuft und den Probenkanal oder Probenraum schneidet. Dadurch kann eine Messprobe mit dem Zusatzelement in effizienter Weise zeitgleich in zwei Orientierungen insbesondere bezüglich zweier unterschiedlicher Atomkerne vermessen werden. Falls gewünscht, kann der Durchlassspalt teilweise mit einem Dielektrikum befüllt sein (der Schnittbereich mit dem Probenkanal oder Probenraum wird nicht mit dem Dielektrikum befüllt). Weiterhin kann eine Probenaufnahmehilfe im Durchlassspalt vorgesehen werden, die eine reproduzierbare Einführung einer Messprobe erlaubt. Dies kann z.B. durch eine Bohrung oder ein Sackloch im Dielektrikum ausgeführt werden.

Besonders bevorzugt ist eine Ausführungsform, die vorsieht,

dass das Zusatzelement bezüglich einer weiteren Draufsicht entlang einer weiteren Grundrichtung eine weitere Abdeckzone und ein weiteres Durchgangsfenster ausbildet, wobei die weitere Abdeckzone das weitere Durchgangsfenster mit oder ohne Unterbrechungen umschließt,
wobei die weitere Grundrichtung senkrecht zur Grundrichtung verläuft,
wobei das Zusatzelement ein oder mehrere weitere Abdeckelemente aufweist, die zumindest im Bereich eines Teils ihrer jeweiligen Randkurve oder äußeren Oberfläche elektrisch leitfähig sind, wobei die Gesamtheit der weiteren Abdeckelemente ein oder mehrere weitere geschlossene Leiterschleifen ausbildet, die in besagter weiterer Draufsicht jeweils eine weitere Leiterschleifenfläche umschließen, wobei die gesamte Überdeckung der einen oder mehreren weiteren Leiterschleifenflächen die weitere Abdeckzone bildet, die einen weiteren Flächeninhalt $AW_{abdeck}$ aufweist, wobei das Zusatzelement im Bereich des weiteren Durchgangsfensters elektrisch nicht leitfähig ist, und wobei das weitere Durchgangsfenster einen weiteren Flächeninhalt $AW_{fenster}$ aufweist mit $AW_{abdeck} \geq 2*AW_{fenster}$, wobei das Zusatzelement wenigstens eine weitere kapazitiv wirkende Struktur umfasst, so dass das Zusatzelement einen weiteren elektrischen Schwingkreis umfassend das eine oder die mehreren weiteren Abdeckelemente ausbildet, mit einer Eigenresonanz einer weiteren Resonanzfrequenz RFW, mit 5 MHz ≤ RFW ≤ 3000 MHz.

Dadurch kann das Zusatzelement für die Untersuchung von zwei Atomkernen eingesetzt werden. Die Grundrichtung, die weitere Grundrichtung und eine Querrichtung stehen typischerweise senkrecht aufeinander, wobei die Querrichtung entlang einer jeweiligen langen Seite des Durchgangsfensters und des weiteren Durchgangsfensters verläuft. Typischerweise sind RF und RFW verschieden, entsprechend unterschiedlichen zu untersuchenden Kernen. Das Zusatzelement kann bezüglich der weiteren Grundrichtung bzw. der weiteren Abdeckzone, des weiteren Durchgangsfensters und der weiteren Abdeckelemente analog zur Grundrichtung aufgebaut sein (siehe oben) und analog zur Grundrichtung in einer Messanordnung verwendet werden, unter Zusammenwirken mit einer weiteren HF-Spule und einem weiteren Mess-Schwingkreis des NMR-Probenkopfs (siehe unten).

*Erfindungsgemäße Messanordnungen*

In den Rahmen der vorliegenden Erfindung fällt auch eine Messanordnung, umfassend einen NMR-Probenkopf und ein erfindungsgemäßes, oben angegebenes Zusatzelement,

wobei das Zusatzelement in einer Probenaufnahme des NMR-Probenkopfs angeordnet ist,
wobei der Probenkopf eine HF-Spule umfasst, mit der in der Probenaufnahme entlang einer Einstrahlrichtung ein B1-Feld erzeugbar ist,

und wobei das Zusatzelement in der Probenaufnahme so zur HF-Spule orientiert ist, dass die Grundrichtung des Zusatzelements und die Einstrahlrichtung parallel sind. Mit der Messanordnung können auch mit kleinen Probenvolumen NMR-Messungen mit hohem Signal-zu-Rauschverhältnis vorgenommen werden. Mit dem Zusatzelement wird das B1-Feld in das Durchgangsfenster komprimiert, wodurch das SNR verbessert wird. Zugleich kann eine Frequenzverschiebung aufgrund der Verdrängung von Magnetfluss durch die Nutzung der unteren Mode einer Resonanzaufspaltung beim Mess-Schwingkreis des NMR-Probenkopfs durch Kopplung des Schwingkreises des Zusatzelements zumindest teilweise, und bevorzugt im Wesentlichen exakt, kompensiert werden. Die NMR-Messung kann dadurch leicht im abstimmbaren Bereich des NMR-Probenkopfs vorgenommen werden.

Bevorzugt ist eine Ausführungsform der erfindungsgemäßen Messanordnung, bei der der Probenkopf eine Führungshilfe umfasst, mit der beim Einführen des Zusatzelements in die Probenaufnahme des NMR-Probenkopfs das Zusatzelement gegenüber dem NMR-Probenkopf selbsttätig so ausgerichtet wird, dass die Grundrichtung des Zusatzelements und die Einstrahlrichtung zueinander definiert ausgerichtet sind, insbesondere parallel sind. Dies vereinfacht den Probenwechsel und stellt genaue Messergebnisse sicher. Typischerweise umfasst die Führungshilfe Schienen und/oder Keilflächen und/oder Anschläge.

Eine bevorzugte Ausführungsform sieht vor, dass das Zusatzelement einen Probenkanal oder Probenraum für eine Messprobe ausbildet, wobei der Probenkanal oder Probenraum einen Durchmesser $D_s$ aufweist, und in die Probenaufnahme des NMR-Probenkopfs ein kreiszylindrischer Körper mit einem maximalen Durchmesser $D_{max}$ einführbar ist, wobei $D_s$ und $D_{max}$ jeweils gemessen sind senkrecht zu einer Querrichtung, wobei die Querrichtung senkrecht zur Grundrichtung verläuft,

und dass

$$D_s \leq 0{,}6 * D_{max},$$

bevorzugt

$$D_s \leq 0{,}4 * D_{max}.$$

Mit diesen Abmessungen können kleine Probenvolumen effizient vermessen werden.

Vorteilhaft ist auch eine Ausführungsform, die vorsieht, dass der NMR-Probenkopf in der Probenaufnahme ein aktives Volumen ausbildet, welches eine Querschnittsfläche $A_{aktiv}$ aufweist, gemessen in der Ebene senkrecht zur Grundrichtung, wobei

$$A_{abdeck} \geq 0{,}2 * A_{aktiv},$$

bevorzugt

$$A_{abdeck} \geq 0{,}3 * A_{aktiv},$$

besonders bevorzugt $A_{abdeck} \geq 0{,}4 * A_{aktiv}$. Dadurch kann eine deutliche Steigerung des Signal-zu-Rauschverhältnisses erreicht werden.

Besonders bevorzugt ist eine Ausführungsform, die vorsieht,

dass der NMR-Probenkopf eine Abstimmeinrichtung aufweist, mit der eine Basis-Resonanzfrequenz BRF einer Eigenresonanz eines elektrischen Mess-Schwingkreises der HF-Spule ohne das Zusatzelement in der Probenaufnahme in einem Bereich von UF bis OF abgestimmt werden kann, mit UF: unterste abstimmbare Frequenz und OF: oberste abstimmbare Frequenz und UF<BRF<OF,

dass die Präsenz des oder der Abdeckelemente des Zusatzelements in der Probenaufnahme des NMR-Probenkopfs durch Verdrängung von Magnetfluss die Resonanzfrequenz des Mess-Schwingkreises um eine Frequenzverschiebung FV gegenüber der Basis-Resonanzfrequenz BRF erhöht,

und weiterhin bei in die Probenaufnahme eingefügtem Zusatzelement der Mess-Schwingkreis mit dem elektrischen Schwingkreis, den das Zusatzelement ausbildet, koppelt, wodurch eine Aufspaltung der Eigenresonanz des elektrischen Mess-Schwingkreises in eine untere Mode mit einer Modenresonanzfrequenz MRF1 und eine obere Mode mit einer Modenresonanzfrequenz MRF2 erfolgt, wobei MRF1 gegenüber der ungekoppelten Resonanzfrequenz des elektrischen Mess-Schwingkreises um eine Frequenzverschiebung RF1 erniedrigt und MRF2 gegenüber der ungekoppelten Resonanzfrequenz um eine Frequenzverschiebung RF2 erhöht ist,
mit

$$MRF1 = BRF + FV - RF1 \text{ und } MRF2 = BRF + FV + RF2,$$

und dass der NMR-Probenkopf und das Zusatzelement so ausgebildet sind, insbesondere eine Kopplung zwischen dem Mess-Schwingkreis und dem elektrischen Schwingkreis und weiter die Resonanzfrequenz RF des elektrischen Schwingkreises des Zusatzelements so eingerichtet sind,
dass

$$OF - BRF > RF1 - FV$$

und

$$BRF - UF > FV - RF1.$$

Bei dieser Ausführungsform bleibt der NMR-Probenkopf nach dem Einsetzen des Zusatzelements in seinem durch die Abstimmeinrichtung abstimmbaren Bereich für NMR-Messungen gut nutzbar.

Die Frequenzverschiebung von RF1 (und auch von RF2) hängt von den Resonanzeigenschaften des elektrischen Schwingkreises des Zusatzelements und der Kopplung mit der HF-Spule und den Resonanzeigenschaften des elektrischen Schwingkreises des NMR-Probenkopfs ab. Durch Veränderung insbesondere der Gesamtkapazität im elektrischen Schwingkreis des Zusatzelements kann daher die Frequenzverschiebung RF1 verändert werden, und so ein Design entsprechend der obigen Bedingungen gefunden werden. Mit den obigen Bedingungen bleibt die Modenresonanzfrequenz MRF1 im abstimmbaren Bereich der Abstimmeinrichtung, und kann mit der Abstimmeinrichtung zurück zum ursprünglichen BRF geschoben werden.

Bevorzugt gilt weiterhin OF-BRF > RF1-FV + (OF-UF)/5 und/oder
BRF-UF > FV-RF1 + (OF-UF)/5. Dann verbleibt noch eine gewisse Reserve zum Ausgleich von extremen Probeneigenschaften, auch unter Berücksichtigung von Frequenzänderung durch Matching (insbesondere stark verlustbehafteten Messproben, gemäß erster Ungleichung mit OF) oder auch zum Ausgleich einer Veränderung des statischen B0-Feldes, z.B. durch eine Drift des NMR-Magneten (gemäß zweiter Ungleichung mit UF).

UF ist die tiefste Frequenz, die (mit der Abstimmeinrichtung im Mess-Schwingkreis) mit jeder Güte abgestimmt werden kann, und OF die höchste Frequenz, die (mit der Abstimmeinrichtung im Mess-Schwingkreis) mit jeder Güte abgestimmt werden kann (jeweils ohne Zusatzelement).

In den Rahmen der vorliegenden Erfindung fällt zudem die Verwendung einer erfindungsgemäßen, oben beschriebenen Messanordnung in einer NMR-Messung,

wobei der NMR-Probenkopf in einem B0-Feld eines Hintergrundmagneten angeordnet ist, wobei das B0-Feld im Bereich der Probenaufnahme des NMR-Probenkopfs entlang einer Querrichtung verläuft, wobei die Querrichtung senkrecht zur Grundrichtung verläuft,
wobei in einen Probenkanal oder einen Probenraum des Zusatzelements zumindest im Bereich des Durchgangsfensters eine Messprobe angeordnet ist, wobei für ein Volumen VOL der Messprobe gilt:

$$VOL \leq 100 \ \mu l,$$

bevorzugt

$$VOL \leq 40 \ \mu l,$$

besonders bevorzugt

$$VOL \leq 10 \ \mu l,$$

ganz besonders bevorzugt

$$VOL \leq 5 \ \mu l,$$

und wobei eine Modenresonanzfrequenz MRF1 einer unteren Mode des Mess-Schwingkreises mit der Abstimmeinrichtung auf eine Kern-Resonanzfrequenz eines Messkerns, der in der Messprobe enthalten ist, abgestimmt ist. Im Rahmen der Verwendung ist die Vermessung von Messproben mit kleinem Probenvolumen mit gutem SNR unter Nutzung eines herkömmlichen Probenkopfs einfach und kostengünstig möglich.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Fig. 1   zeigt schematisch eine erste Ausführungsform eines erfindungsgemäßen Zusatzelements, umfassend ein erstes Sandwich von Abdeckelementen, mit Teilbild (a) darstellend eine Schrägansicht, Teilbild (b) einen Querschnitt in einem vorderen Teil, (c) einen Querschnitt in einem mittleren Teil, Teilbild (d) einen Querschnitt in einem hinteren Teil, Teilbild (e) eine Aufsicht auf das Abdeckelement der ersten Sandwichebene, und Teilbild (f) eine Aufsicht auf das Abdeckelement der zweiten Sandwichebene;

Fig. 2   zeigt schematisch geschlossene Leiterschleifen in der Ausführungsform von Fig. 1, mit Teilbild (a) im Abdeckelement der ersten Sandwichebene, und Teilbild (b) im Abdeckelement der zweiten Sandwichebene,

Fig. 3   zeigt schematisch die Fokussierung des B1-Felds bei der Ausführungsform von Fig. 1 im Querschnitt innerhalb einer HF-Spule eines NMR-Probenkopfs, mit Teilbild (a) ohne das Zusatzelement, und Teilbild (b) mit Zusatzelement;

Fig. 4   zeigt schematisch einen bei Eigenresonanz im Zusatzelement der Ausführungsform von Fig. 1 sich ergebenden Kreisstrom, mit Teilbild (a) darstellend einen Teil des Kreisstroms im Abdeckelement der ersten Sandwichebene, mit Teilbild (b) einen Teil des Kreisstroms im Abdeckelement der zweiten Sandwichebene, Teilbild (c) den Kreisstrom im Zusatzelement im Längsschnitt, Teilbild (d) den gesamten Kreisstrom in Aufsicht/Projektion;

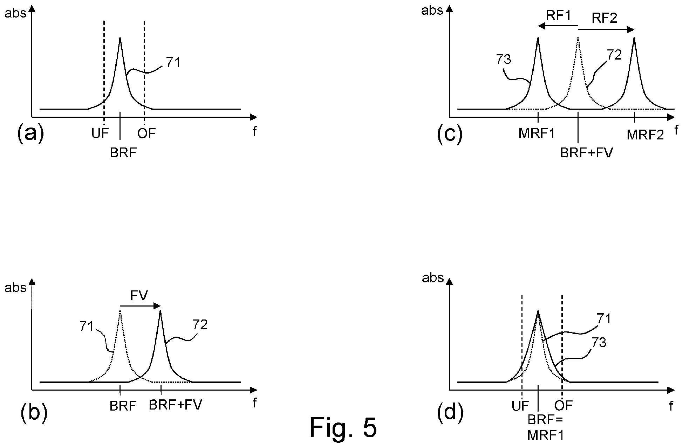

Fig. 5   zeigt schematisch die Auswirkungen eines Zusatzelements im Rahmen der Erfindung auf das Resonanzverhalten eines HF-Resonators eines NMR-Probenkopfs, jeweils in Diagrammen zeigend nach rechts die Frequenz und nach oben die Absorption des HF-Resonators ("Resonanzkurve"), jeweils in willkürlichen Einheiten, mit Teilbild (a) Resonanzkurve des HF-Resonators ohne Zusatzelement, Teilbild (b) Resonanzkurve des HF-Resonators unter Berücksichtigung der Frequenzverschiebung durch Feldverdrängung des Zusatzelements, Teilbild (c) Resonanzkurve des HF-Resonators unter weiterer Berücksichtigung der Resonanzaufspaltung durch Kopplung mit dem Schwingkreis des Zusatzelements, und Teilbild (d) resultierende Resonanzkurve der unteren Mode im Vergleich zur Resonanzkurve ohne Zusatzelement, wobei hier MRF1=BRF;

Fig. 6   zeigt analog zu Fig. 5 Teilbild (d) die resultierende Resonanzkurve der unteren Mode im Vergleich zur Resonanzkurve ohne Zusatzelement, wobei MRF1>BRF, im Rahmen der Erfindung;

Fig. 7   zeigt analog zu Fig. 5 Teilbild (d) die resultierende Resonanzkurve der unteren Mode im Vergleich zur Resonanzkurve ohne Zusatzelement, wobei MRF1<BRF, im Rahmen der Erfindung;

Fig. 8   zeigt schematisch eine zweite Ausführungsform eines erfindungsgemäßen Zusatzelements, umfassend ein erstes Sandwich von Abdeckelementen, mit Teilbild (a) darstellend eine Aufsicht auf die Abdeckelemente der ersten Sandwichebene, Teilbild (b) eine Aufsicht auf die Abdeckelemente der zweiten Sandwichebene, und Teilbild (c) darstellend einen gesamten Kreisstrom bei Eigenresonanz in Aufsicht/Projektion;

Fig. 9   zeigt schematisch eine dritte Ausführungsform eines erfindungsgemäßen Zusatzelements, umfassend ein erstes Sandwich von Abdeckelementen und ein zweites Sandwich von Abdeckelementen, mit Teilbild (a) darstellend eine Schrägansicht, Teilbild (b) eine Aufsicht auf das Abdeckelement der ersten Sandwichebene, Teilbild (c) eine Aufsicht auf das Abdeckelement der zweiten Sandwichebene, Teilbild (d) eine Aufsicht auf das Abdeckelement der dritten Sandwichebene, Teilbild (e) eine Aufsicht auf das Abdeckelement der vierten Sandwichebene;

Fig. 10 zeigt schematisch eine vierte Ausführungsform eines erfindungsgemäßen Zusatzelements, umfassend ein erstes Sandwich von Abdeckelementen und ein zweites Sandwich von Abdeckelementen ähnlich wie in Fig. 9 dargestellt, in Schrägansicht, mit abgerundeten Seiten;

Fig. 11 zeigt schematisch eine fünfte Ausführungsform eines erfindungsgemäßen Zusatzelements, umfassend ein Glasröhrchen enthaltend die Abdeckelemente, im Querschnitt;

Fig. 12 zeigt schematisch eine sechste Ausführungsform eines erfindungsgemäßen Zusatzelements, umfassend ein Abstimmelement, mit welchem eine Dicke der Schicht eines Dielektrikums veränderbar ist;

Fig. 13 zeigt schematisch eine siebente Ausführungsform eines erfindungsgemäßen Zusatzelements, umfassend ein Abstimmelement, welches einen Trimmerkondensator umfasst;

Fig. 14 zeigt schematisch eine achte Ausführungsform eines erfindungsgemäßen Zusatzelements, mit Metallzylindern an Endabschnitten und einer Metallplatte als Verbindungsabschnitt, wobei der vordere Endabschnitt einen oberen Schlitz und unteren Schlitz aufweist;

Fig. 15 zeigt schematisch eine neunte Ausführungsform eines erfindungsgemäßen Zusatzelements, ähnlich wie in Fig. 14 dargestellt, jedoch mit einem Metallrohr am vorderen Endabschnitt, das die Schlitze übergreift;

Fig. 16 zeigt schematisch eine zehnte Ausführungsform eines erfindungsgemäßen Zusatzelements, mit Metallzylindern an Endabschnitten und einer Metallplatte als Verbindungsabschnitt, wobei der vordere Endabschnitt einen oberen Schlitz, der hintere Endabschnitt einen unteren Schlitz, und das Zusatzelement insgesamt einen Mittelschlitz aufweist;

Fig. 17 zeigt schematisch eine elfte Ausführungsform eines erfindungsgemäßen Zusatzelements, mit Metallzylindern an Endabschnitten und einer Metallplatte als Verbindungsabschnitt, wobei der vordere Endabschnitt einen oberen Schlitz und einen unteren Schlitz aufweist, der hintere Endabschnitt einen oberen Schlitz und einen unteren Schlitz aufweist, und beide Endabschnitte jeweils ein Metallrohr aufweisen, das die Schlitze übergreift;

Fig. 18 zeigt schematisch eine zwölfte Ausführungsform eines erfindungsgemäßen Zusatzelements, mit Metallzylindern an Endabschnitten und einer Metallplatte als Verbindungsabschnitt, wobei der vordere Endabschnitt einen oberen Schlitz und einen unteren Schlitz aufweist, der hintere Endabschnitt einen oberen Schlitz und einen unteren Schlitz aufweist, und das Zusatzelement insgesamt einen Mittelschlitz aufweist;

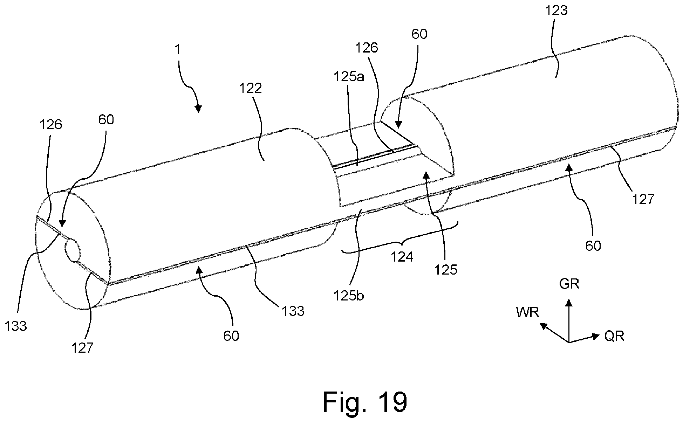

Fig. 19 zeigt schematisch eine dreizehnte Ausführungsform eines erfindungsgemäßen Zusatzelements, mit Metallzylindern an Endabschnitten und einer Metallplatte als Verbindungsabschnitt, wobei in beiden Metallzylindern rechtsseitig ein unterer Schlitz vorgesehen ist, welcher sich von einer Unterkante des Probenkanals zur Metallkörperaußenseite erstreckt und senkrecht zur Grundrichtung verläuft, und wobei in beiden Metallzylindern linksseitig ein oberer Schlitz vorgesehen ist, welcher sich von einer Oberkante des Probenkanals zur Metallkörperaußenseite erstreckt und senkrecht zur Grundrichtung verläuft;

Fig. 20 zeigt schematisch eine vierzehnte Ausführungsform eines erfindungsgemäßen Zusatzelements, mit Metallzylindern an Endabschnitten und vier kreuzförmig angeordneten Metallplattenteilen im Verbindungsabschnitt;

Fig. 21 zeigt schematisch eine fünfzehnte Ausführungsform eines erfindungsgemäßen Zusatzelements, basierend auf einem zylindrischen Metallkörper;

Fig. 22 zeigt ein Sachaltschema einer beispielhaften Ausführungsform einer erfindungsgemäßen Messanordnung, mit einer Abstimmeinrichtung zur Verstellung der Resonanzfrequenz des Mess-Schwingkreises;

Fig. 23 zeigt schematisch ein NMR-Spektrometer zur Verwendung mit der Erfindung, wobei im NMR-Spektrometer eine erfindungsgemäße Messanordnung verbaut ist;

Fig. 24    zeigt schematisch in einem Diagramm durch Simulation erhaltene Modenresonanzfrequenzen MRF1 für einen HF-Resonator mit BRF=600 MHz mit eingesetzten Zusatzelementen mit drei unterschiedlichen Längen des Durchgangsfensters, bei unterschiedlich angepasster Eigenresonanz;

Fig. 25    zeigt schematisch in einem Diagramm durch Simulation erhaltene B1-Feldstärken als Funktion der z-Position (entlang der Querrichtung QR) für den HF-Resonator von Fig. 24 ohne Zusatzelement und mit eingesetztem Zusatzelement mit LSD=5mm.

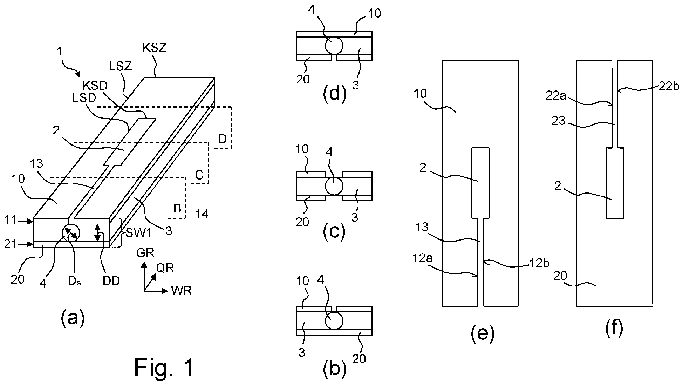

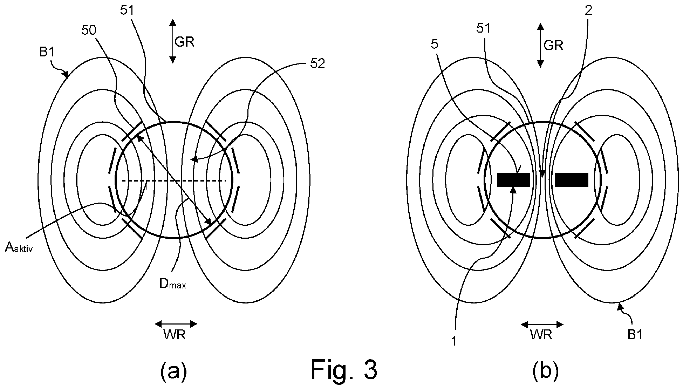

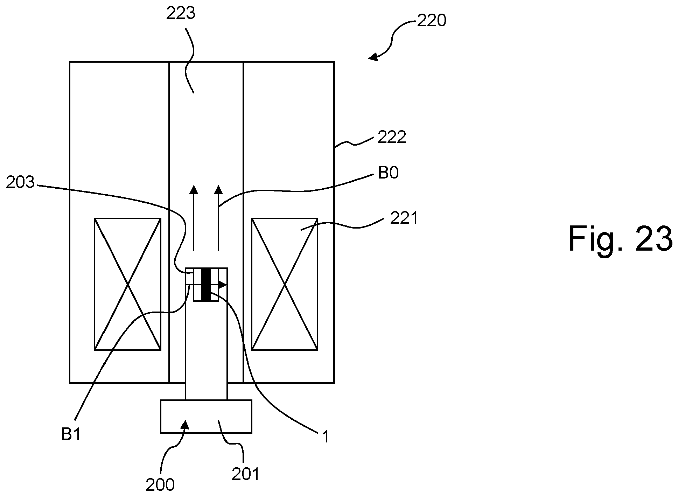

Die **Fig. 1** illustriert schematisch eine erste Ausführungsform eines erfindungsgemäßen Zusatzelements 1. Das Teilbild (a) zeigt eine Schrägansicht, und die Teilbilder (b), (c) und (d) zeigen Querschnitte an den in Teilbild (a) mit B, C und D markierten Ebenen. Das Zusatzelement 1 kann zusammen mit einer Messprobe in der Probenaufnahme eines NMR-Probenkopfs angeordnet werden (letzteres nicht näher dargestellt, vgl. aber zB Fig. 3 und Fig. 23 hierzu).

Das Zusatzelement 1 ist in der ersten Ausführungsform Sandwichartig aufgebaut und umfasst hier ein erstes (oberes) Abdeckelement 10 in einer ersten Sandwichebene 11, ein zweites (unteres) Abdeckelement 20 in einer zweiten Sandwichebene 21, und eine dazwischenliegende Schicht 3 eines Dielektrikums. Diese Anordnung kann als ein (erstes) Sandwich SW1 von Abdeckelementen 10, 20 aufgefasst werden. Die Sandwichebenen 11, 21 liegen jeweils senkrecht zu einer Grundrichtung GR und bezüglich dieser Grundrichtung GR hintereinander. Das Teilbild (e) zeigt eine Aufsicht auf das Abdeckelement 10, und Teilbild (f) zeigt eine Aufsicht auf das Abdeckelement 20 (jeweils von oben, Draufsicht entlang der Grundrichtung GR).

Das Zusatzelement 1 ist hier insgesamt im Wesentlichen quaderförmig, und weist in der Ebene senkrecht zur Grundrichtung GR eine lange Seite LSZ und eine kurze Seite KSZ auf. Das Zusatzelement 1 enthält ein Durchgangsfenster 2, das hier in Draufsicht (Draufsicht entlang der Grundrichtung GR) rechteckförmig ist, und ebenfalls eine lange Seite LSD und eine kurze Seite KSD aufweist. Senkrecht zur Grundrichtung GR verläuft eine Querrichtung QR, die hier parallel zu den langen Seiten LSZ, LSD verläuft. Die kurzen Seiten KSZ und KSD verlaufen entlang einer weiteren Richtung WR. Die Richtungen GR, QR und WR sind orthogonal zueinander.

Hier in der Schicht 3 des Dielektrikums verläuft ein Probenraum 4 im Form einer zylindrischen Bohrung mittig im Zusatzelement 1 entlang der Querrichtung QR, wobei der Probenraum 4 durch das Durchgangsfenster 2 verläuft. Die Schicht 3 hat eine Dicke DD. Der Probenraum 4 hat einen Durchmesser $D_s$. In der gezeigten Ausführungsform ist $DD=D_s$. Typischerweise liegt $D_s$ bei ca. 2 mm oder weniger.

In dem Probenraum 4 kann ein dünnes Probenröhrchen mit einer Messprobe angeordnet werden. Probenmaterial, das im Bereich des Durchgangsfensters 2 liegt, kann einer NMR-Messung unterzogen werden. Falls der Probenraum 4 im Zusatzelement 1 flüssigkeitsdicht ist, kann er auch unmittelbar als ein Probenkanal für eine flüssige Messprobe genutzt werden (jeweils nicht näher dargestellt). Bei der NMR-Messung verläuft ein homogenes, statisches Hintergrundmagnetfeld B0 entlang der Querrichtung QR, und ein zeitlich veränderliches Magnetfeld B1 verläuft entlang der Grundrichtung GR. Das B1-Feld konzentriert sich im Bereich des Durchgangsfensters 2 (nicht näher dargestellt, vgl. aber Fig. 3 hierzu).

Beide Abdeckelemente 10, 20 sind hier in der Ebene senkrecht zur Grundrichtung GR näherungsweise C-förmig aufgebaut, und umgreifen jeweils fast vollständig das Durchgangsfenster 2. Die Abdeckelemente 10, 20 bestehen in der gezeigten Ausführungsform vollständig aus Metall, hier aus Kupfer. Jeweils an gegenüberliegenden Enden 12a, 12b und 22a, 22b der Abdeckelemente 10, 20 verbleibt ein schmaler Unterbrechungsspalt 13 und 23. Die Unterbrechungsspalten 13, 23 verlaufen hier jeweils entlang der Grundrichtung GR und mittig an der kurzen Seite KSD des Durchgangsfensters 2, jedoch an gegenüberliegenden Seiten des Durchgangsfensters 2.

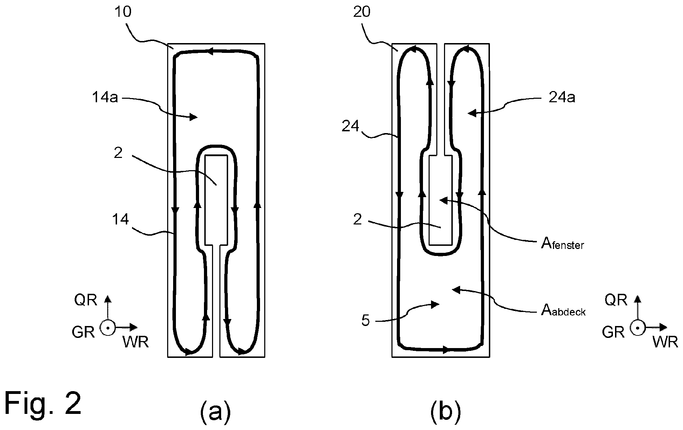

Die **Fig. 2** illustriert nochmals das Abdeckelement 10 im Teilbild (a), und das Abdeckelement 20 im Teilbild (b), jeweils in Aufsicht (Draufsicht entgegen der Grundrichtung GR von Fig. 1; die Grundrichtung GR ist in Fig. 2 also senkrecht zur Zeichenebene). Wenn ein äußeres, veränderliches Magnetfeld (B1-Feld) entlang der Grundrichtung GR angelegt wird, wird dieses Magnetfeld durch die elektrisch leitenden Abdeckelemente 10, 20 blockiert und kann die Abdeckelemente 10, 20 nicht durchdringen. Durch das B1-Feld wird im Bereich der Randkurve eines jeweiligen Abdeckelements 10, 20 ein (vollständig ohmscher) Kreisstrom entlang einer geschlossenen Leiterschleife 14, 24 induziert. Innerhalb der zugehörigen Leiterschleifenfläche 14a, 24a wird das Magnetfeld verdrängt. Das Durchgangsfenster 2 liegt jedoch außerhalb der beiden Leiterschleifenflächen 14a, 24a. Der Stromfluss am äußeren Rand der Abdeckelemente 10, 20 ist jeweils umgekehrt zum Stromfluss am inneren Rand der Abdeckelemente 10, 20, der das Durchgangsfenster 2 umgreift. Entsprechend kann sich im Durchgangsfenster 2 der magnetische Fluss konzentrieren.

Die gesamte Überdeckung der beiden Leiterschleifenflächen 14a, 24a (in Draufsicht entlang der Grundrichtung) wird als Abdeckzone 5 bezeichnet, und hat einen Flächeninhalt $A_{abdeck}$. Im Rahmen der Erfindung ist $A_{abdeck}$ deutlich größer als die Fensterfläche $A_{fenster}$, mit $A_{abdeck} \geq 2*A_{fenster}$, und hier mit ca. $A_{abdeck}=12*A_{fenster}$.

Die **Fig. 3** illustriert die Konzentration des zeitlich veränderlichen Magnetflusses (bzw. B1-Felds) in der HF-Spule 50 eines NMR-Probenkopfs, mit dem Teilbild (a) ohne Zusatzelement, und Teilbild (b) mit Zusatzelement gemäß der Erfindung, jeweils im Querschnitt senkrecht zur Querrichtung.

Wie in Teilbild (a) ersichtlich, erzeugt die HF-Spule 50 ein zeitlich veränderliches Magnetfeld B1 im Bereich einer im Querschnitt kreiszylindrischen Probenaufnahme 51. In der Probenaufnahme 51 kann ein kreiszylindrischer Körper (zB ein herkömmliches Probenröhrchen) mit einem maximalen Durchmesser $D_{max}$ aufgenommen werden. Typischerweise liegt $D_{max}$ bei 5 mm. Die HF-Spule 50 hat ein aktives Volumen 52 mit einer Querschnittsfläche $A_{aktiv}$ (gemessen in der Ebene senkrecht zur Grundrichtung GR), die sich im Wesentlichen über die Breite der Probenaufnahme 51 erstreckt. Die Verteilung des B1-Felds innerhalb der HF-Spule 50 bzw. des aktiven Volumens 52 ohne Zusatzelement ist im Wesentlichen homogen.

Durch Einfügen des Zusatzelements 1 in die Probenaufnahme 51, wie in Teilbild (b) dargestellt, wird das B1-Feld aus dem Bereich der Abdeckzone 5 verdrängt, und weitgehend in das Durchgangsfenster 2 fokussiert (in der Praxis wird auch ein gewisser Teil des B1-Feldes aus dem Bereich der Abdeckzone 5 verdrängt und außenseitlich am Zusatzelement 1 vorbei gelenkt, nicht näher dargestellt). Erfindungsgemäß ist $A_{abdeck} \geq 0{,}2 * A_{aktiv}$, und hier gilt ca. $A_{abdeck} = 0{,}7 * A_{aktiv}$. Das Zusatzelement 1 wirkt insoweit als Lenz-Linse.

Wird die Messprobe (nicht näher dargestellt) im Bereich des Durchgangsfensters 2 angeordnet, kann eine zugehörige NMR-Messung mit einem entsprechend verstärkten B1-Feld und daher verbessertem Signal-zu-Rausch-Verhältnis durchgeführt werden.

Man beachte, dass in der schematischen Darstellung von Fig. 3 zur Vereinfachung die genaue Lage von Feldlinien des B1-Felds bezüglich der Teilabschnitte der illustrierten HF-Spule 50 nicht näher herausgearbeitet wurde.

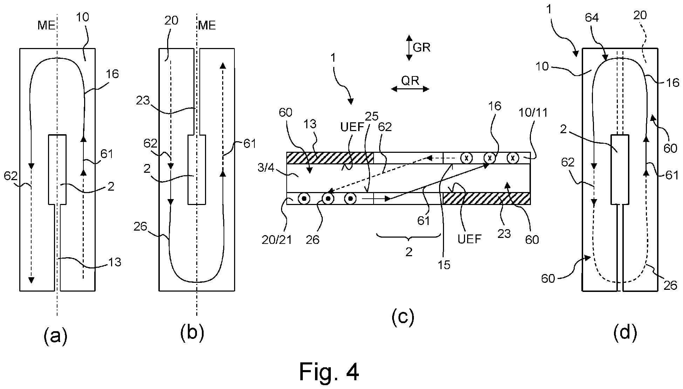

Das erfindungsgemäße Zusatzelement 1 wirkt jedoch nicht nur als Lenz-Linse zur Feldkonzentration, sondern bildet auch einen Schwingkreis aus, der an die HF-Spule des NMR-Probenkopfs koppelt. Die **Fig. 4** illustriert die Ausbildung des Schwingkreises für das Zusatzelement 1 von Fig. 1. Das Teilbild (a) zeigt eine Aufsicht (Draufsicht entgegen der Grundrichtung von Fig. 1) auf das Abdeckelement 10, Teilbild (2) eine Aufsicht auf das Abdeckelement 20, das Teilbild (c) einen Längsschnitt entlang der Querrichtung QR (und entlang der Grundrichtung GR), und Teilbild (d) eine Aufsicht/Projektion auf das gesamte Zusatzelement 1, wobei das Zusatzelement 10 oberhalb des darunterliegenden, gestrichelt angedeuteten Zusatzelement 20 liegt.

Für die Ausbildung des Schwingkreises im Zusatzelement ist es im Rahmen der Erfindung bevorzugt, wenn sich ein geschlossener (Wechsel-)Kreisstrom um das Durchgangsfenster 2 herum ausbildet. Im Abdeckelement 10 der ersten Sandwichebene 11 ist kein vollständig ohmscher Leiterpfad um das gesamte Durchgangsfenster 2 möglich, da der Unterbrechungsspalt 13 im vorderen Teil den ohmschen Stromfluss blockiert. Umgekehrt ist im Abdeckelement 20 der zweiten Sandwichebene 21 kein vollständig ohmscher Leiterpfad um das gesamte Durchgangsfenster 2 möglich, da der Unterbrechungsspalt 23 im hinteren Teil den ohmschen Stromfluss blockiert.

Die im (ersten) Sandwich SW1 einander gegenüberliegenden Abdeckelemente 10, 20 bilden jedoch gegenüberliegende und überlappende Kopplungsflächen 15, 25 aus, durch die hindurch ein Wechselstrom entsprechend einem Flächenkondensator übertreten kann. Ein erster Übertritt findet auf der rechten Seite der Mittelebene ME statt (Kreisstromteil 61) statt, und ein weiterer Übertritt findet auf der rechten Seite der Mittelebene ME (Kreisstromteil 62), jeweils über verteilt über die volle Länge des Zusatzelements in Querrichtung QR. Dafür steht jeweils eine Überlappungsfläche UEF zur Verfügung, die hier jeweils der halben (linken bzw. rechten) Fläche eines einzelnen Abdeckelements 10, 20 entspricht. Ein jeweiliger solchermaßen ausgebildete Flächenkondensator stellt jeweils eine kapazitiv wirkende Struktur 60 dar.

Dadurch kann sich ein Kreisstrom 64 eines Wechselstroms ausbilden, der im Abdeckelement 10 im hinteren Teil einen ohmschen Strompfad nutzen kann (Kreisstromteil 16), der im Abdeckelement 20 im vorderen Teil einen ohmschen Strompfad nutzen kann (Kreisstromteil 26), und der verteilt über die beiden Überlappungsflächen UEF durch die kapazitiv wirkenden Strukturen 60 zwischen den Abdeckelementen 10, 20 übertreten kann (Kreisstromteil 61 rechts, Kreisstromteil 62 links). Der vollständige Kreisstrom 64 um das Durchgangsfenster 2 ist in der Gesamtdarstellung von Teilbild (d) gut zu sehen, wo Kreisstromteile/Strukturen unterhalb der Zeichenebene gestrichelt dargestellt sind. Man beachte, dass der Kreisstrom 64 im Wesentlichen überall die gleiche Stromstärke hat, und zudem keine Stromknoten (Verzweigungen oder Zusammenflüsse von elektrischem Strom) aufweist. Der Kreisstrom 64 wechselt hier bei einem Umlauf um das Durchgangsfenster 2 zweimal die Sandwichebene 11, 21, entsprechend zwei kapazitiv wirkenden Strukturen 60.

Dadurch wird ein Schwingkreis ausgebildet, der durch ein B1-Feld parallel zur Grundrichtung GR angeregt werden kann, und der mit dem Mess-Schwingkreis des HF-Resonators im NMR-Probenkopf koppeln kann. Der Schwingkreis umfasst die kapazitiv wirkenden Strukturen 60, die insgesamt eine Kapazität C bewirken, und da der Wechselstrom um das Durchgangsfenster 2 herum fließt, auch einen Aufbau, der eine Induktivität L bewirkt (LC-Schwingkreis). Im Rahmen der Erfindung weist der durch das Zusatzelement ausgebildete Schwingkreis eine Resonanzfrequenz RF auf, mit 5 MHz $\leq$ RF $\leq$ 3000 MHz, wodurch eine gute und passende Kopplung mit dem Mess-Schwingkreis des NMR-Probenkopfs erreichbar ist (siehe dazu auch bei Fig. 5).

Es sei darauf hingewiesen, dass auch mit den weiteren dargestellten Ausführungsformen eine Feldkonzentration (vgl. Fig. 3) und die Ausbildung eines Schwingkreises (vgl. Fig. 4) in analoger Weise und erfindungsgemäß erfolgen kann.

Die **Fig. 5** illustriert die Auswirkungen des Zusatzelements bei Kopplung von dessen Schwingkreis an den Mess-Schwingkreis eines NMR-Probenkopfs im Rahmen der Erfindung. In den Teilbildern (a) bis (d) sind jeweils nach rechts die Frequenz (f) und nach oben die Absorption (abs) des HF-Resonators des NMR-Probenkopfs, jeweils in willkürlichen Einheiten, aufgetragen ("Resonanzkurven").

Im **Teilbild (a)** ist zunächst die Resonanzkurve 71 des HF-Resonators des NMR-Probenkopfs ohne Zusatzelement dargestellt. Die Resonanzkurve 71 hat ein Maximum bei der Basis-Resonanzfrequenz BRF (Eigenresonanz des Mess-Schwingkreises). Durch eine Abstimmeinrichtung im NMR-Probenkopf kann der HF-Resonator noch geringfügig zwischen einer unteren Frequenz UF und einer oberen Frequenz OF verstimmt werden (z.B. zur Anpassung an extreme Probeneigenschaften oder Magnetdrift), und BRF liegt zwischen UF und OF.

Wird nun ein Zusatzelement, das als Lenz-Linse wirkt, in die Probenaufnahme des NMR-Probenkopfs eingeführt, vgl. **Teilbild (b),** so kommt es aufgrund von Feldverdrängung zu einer Frequenzverschiebung FV der Resonanzfrequenz des Mess-Schwingkreises, genauer gesagt zu einer Frequenzerhöhung. Die neue Resonanzkurve 72 hat eine neue Resonanzfrequenz, die bei BRF+FV liegt.

Wenn das Zusatzelement gemäß der Erfindung zudem auch einen Schwingkreis ausbildet, der mit der HF-Spule bzw. dem Mess-Schwingkreis koppelt, so kommt es zusätzlich auch zu einer Aufspaltung der Eigenresonanz des Mess-Schwingkreises in zwei Moden, vgl. die Resonanzkurve 73 in **Teilbild (c).** Die untere Mode hat eine um RF1 verminderte Resonanzfrequenz, und entsprechend eine Modenresonanzfrequenz MRF1=BRF+FV-RF1. Die die obere Mode hat eine um RF2 erhöhte Resonanzfrequenz, und entsprechend eine Modenresonanzfrequenz MRF2=BRF+FV+RF2. Man beachte, dass FV, RF1 und RF2 hier stets positiv angenommen werden.

Im illustrierten Beispiel sind die Resonanzfrequenz des Schwingkreises des Zusatzelement und die Kopplung an den HF-Resonator des NMR-Probenkopfs so eingerichtet, dass MRF1 wieder exakt BRF entspricht, wie im **Teilbild (d)** dargestellt, welches nun die Resonanzkurve 73 nur noch im Bereich der unteren Mode darstellt. Die obere Mode wird für die Erfindung nicht genutzt. Mit der unteren Mode kann eine NMR-Messung erfolgen. Vorbereitend kann dabei in gewohnter Weise eine Abstimmung des (gekoppelten) HF-Resonators des NMR-Probenkopfs an die konkrete Messprobe und den gewünschten Atomkern erfolgen. Die bereits erwähnte Abstimmeinrichtung kann innerhalb der Frequenzen UF bis OF die Abstimmung vornehmen. Entsprechend beeinträchtigt im Rahmen der Erfindung die Frequenzverschiebung FV durch Feldverdrängung nicht die Brauchbarkeit des NMR-Probenkopfs bezüglich der Abstimmbarkeit, da FV durch RF1 kompensiert wird. In Teilbild (d) ist die Resonanzkurve 73 der unteren Mode mit einem etwas verbreiterten Peak dargestellt im Vergleich zur ursprünglichen Resonanzkurve 71, um eine durch das Zusatzelement geringfügig verschlechterte Güte anzudeuten.

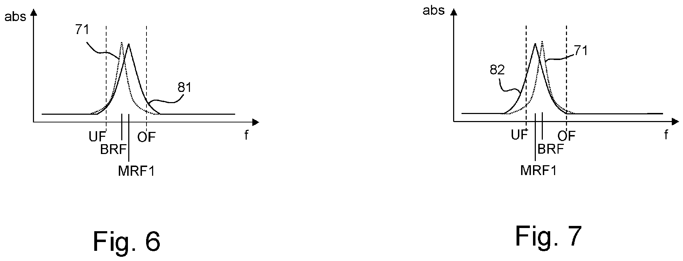

Bevorzugt (und wie in Fig. 5 Teilbild (d) dargestellt) sind die Eigenresonanz des Zusatzelements und dessen Kopplung so eingerichtet, dass MRF1=BRF, oder anders ausgedrückt FV=RF1. In der Praxis genügt es bereits für die Erfindung, dass die Frequenzverschiebung FV durch die Feldverdrängung einerseits und die Frequenzverminderung RF1 der unteren Mode gegenüber der ungekoppelten Resonanzfrequenz sich soweit aufheben, dass die Modenresonanzfrequenz MRF1 im abstimmbaren Bereich des NMR-Probenkopf bleibt, wie in Fig. 6 und Fig. 7 ersichtlich. Hierbei ist zu beachten, dass es die Aufgabe des Zusatzelementes ist, Messproben mit gegenüber dem Probenraumvolumen des NMR-Messkopfes deutlich reduziertem Volumen zu vermessen. Selbst stark verlustbehaftete Messproben oder solche mit hoher Dielektrizitätskonstante führen aufgrund ihres geringen Volumens nur zu geringen Veränderungen der Abstimmung des Messkopfes, so dass der vollständige Abstimmbereich von UF bis OF in der Regel nicht notwendig ist, um eine optimale Abstimmung mit allen relevanten Messproben erreichen zu können.

Die **Fig. 6** illustriert eine Resonanzkurve 81 der resultierenden unteren Mode, bei der MRF1 geringfügig größer ist als BRF, und entsprechend FV>RF1 ist. Solange BRF-UF > FV-RF1 ist, kann dann MRF1 mit der Abstimmeinrichtung immer noch auf das vormalige BRF zurückgeschoben werden, und Messungen, die ohne das Zusatzelement bei der Basis-Resonanzfrequenz möglich waren, sind auch mit dem Zusatzelement mit der vorhandenen Ausrüstung möglich.

Bevorzugt gilt auch BRF-UF > FV-RF1 + (OF-UF)/5, so dass auch noch ein Ausgleich von extremen Probeneigenschaften und/oder Frequenzänderungen zum Ausgleich von Magnetdrift in gewissem Umfang möglich bleiben.

Die **Fig. 7** illustriert eine Resonanzkurve 82 der resultierenden unteren Mode, bei der MRF1 geringfügig kleiner ist als BRF, und entsprechend FV<RF1 ist. Solange OF-BRF > RF1-FV ist, kann dann MRF1 mit der Abstimmeinrichtung immer noch auf das vormalige BRF zurückgeschoben werden, und Messungen, die ohne das Zusatzelement bei der Basis-Resonanzfrequenz möglich waren, sind auch mit dem Zusatzelement mit der vorhandenen Ausrüstung möglich.

Bevorzugt gilt auch OF-BRF > RF1-FV + (OF-UF)/5, so dass auch noch ein Ausgleich von extremen Probeneigenschaften und/oder Frequenzänderungen zum Ausgleich von Magnetdrift in gewissem Umfang möglich bleiben.

Hierzu ein typisches Beispiel gemäß der Erfindung: Der NMR-Probenkopf weist eine Basis-Resonanzfrequenz BRF von 600 MHz auf, und kann mit einer vorhandenen Abstimmeinrichtung zwischen UF = 590 MHz und OF = 610 MHz abgestimmt werden (jeweils ohne Zusatzelement) (Man beachte, dass UF und OF nicht symmetrisch um BRF liegen müssen, in der Regel ist BRF - UF > OF - BRF). Durch Kopplung mit einem erfindungsgemäßen Zusatzelement mit einer Resonanzfrequenz RF von 1200 MHz, mit einem Kopplungsfaktor von 0,75, und weiterhin einer Induktivität des Zusatzelements von 1/3 der Induktivität der HF-Spule des Probenkopfs wird eine Resonanzfrequenzverminderung RF1 für den unteren Mode von 40 MHz bewirkt. Gleichzeitig erzeugt das Zusatzelement durch Feldverdrängung eine Frequenzverschiebung FV (Erhöhung der Resonanzfrequenz) von ca. 45 MHz. Dann liegt MRF1 = BRF + FV - RF1 bei 605 MHz. Dies ist mit der vorhandenen Abstimmeinrichtung des Probenkopfs problemlos abstimmbar, also auf 600 MHz zurückführbar, da BRF-UF = 10 MHz, und weiterhin lediglich RF1-FV = 5 MHz ist, also BRF -UF > RF1 - FV. Es bleiben sogar noch 5 MHz als weitere Abstimmreserve, was hier mehr als (OF - UF)/5 = 4 MHz ist.

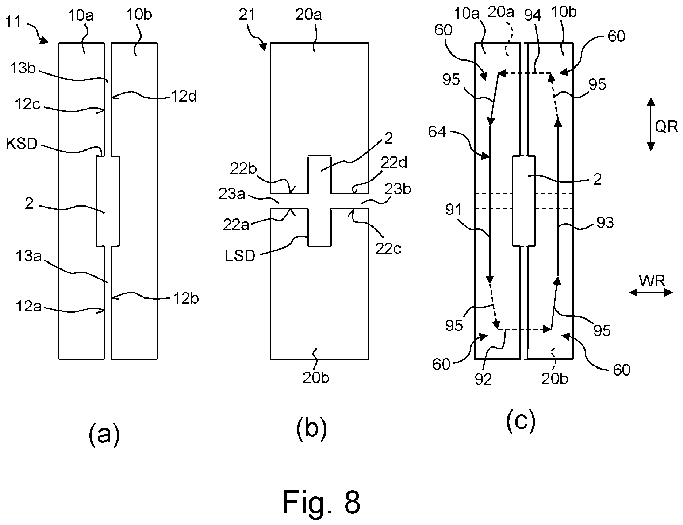

Die **Fig. 8** illustriert eine zweite Ausführungsform eines erfindungsgemäßen Zusatzelements 1, ähnlich dem Zusatzelement von Fig. 1. Es werden nur die wesentlichen Unterschiede erläutert.

Das Zusatzelement 1 der zweiten Ausführungsform verfügt in der ersten Sandwichebene 11 über zwei Abdeckelemente 10a, 10b, und in der zweiten Sandwichebene 21 über zwei Abdeckelemente 20a, 20b. Zwischen den Abdeckelementen 10a, 10b, 20a, 20b der zwei Sandwichebenen 11, 21 ist eine Schicht eines Dielektrikums angeordnet (nicht näher dargestellt, vgl. aber z.B. Fig. 1, Teilbild (a) dort).

Teilbild (a) zeigt die Aufsicht (Draufsicht entlang der Grundrichtung) auf die Abdeckelemente 10a, 10b der ersten Sandwichebene 11, Teilbild (b) eine Aufsicht auf die Abdeckelemente 20a, 20b der zweiten Sandwichebene 21, und Teilbild (c) eine Gesamtschau des Zusatzelements 1 in Aufsicht/Projektion.

Die Abdeckelemente 10a, 10b sind näherungsweise C-Förmig, und jedes umgreift etwa die Hälfte des Durchgangsfensters 2 (10 linke Hälfte, 10b rechte Hälfte). Zwischen den gegenüberliegenden Enden 12a, 12b liegt ein Unterbrechungsspalt 13a, und zwischen den gegenüberliegenden Enden 12c, 12d liegt ein Unterbrechungsspalt 13b. Die Unterbrechungsspalten 13a, 13b liegen mittig an der kurzen Seite KSD des Durchgangsfensters 2 und verlaufen entlang der Querrichtung QR.

Die Abdeckelemente 20a, 20b sind ebenfalls näherungsweise C-Förmig, und jedes umgreift etwa die Hälfte des Durchgangsfensters 2 (20a hintere Hälfte, 20b vordere Hälfte). Zwischen den gegenüberliegenden Enden 22a, 22b liegt ein Unterbrechungsspalt 23a, und zwischen gegenüberliegenden Enden 22c, 22d liegt ein Unterbrechungsspalt 23b. Die Unterbrechungsspalten 23a, 23b liegen mittig an der langen Seite LSD des Durchgangsfensters 2 und verlaufen entlang der weiteren Richtung WR.

Entsprechend sind die Unterbrechungsspalten 13a, 13b der ersten Sandwichebene 11 gegenüber den Unterbrechungsspalten 23a, 23b der zweiten Sandwichebene 21 in einer Umlaufrichtung um das Durchgangsfenster 2 herum gegeneinander versetzt, hier um jeweils 90°.

Zur Einrichtung eines Schwingkreises ermöglicht dieser Aufbau einen gesamten (Wechsel-)Kreisstrom 64 um das Durchgangsfenster 2, mit ohmschem Kreisstromteil 91 in Abdeckelement 10a, ohmschem Kreisstromteil 92 in Abdeckelement 20b, ohmschem Kreisstromteil 93 in Abdeckelement 10b, und ohmschem Kreisstromteil 94 in Abdeckelement 20a, sowie vier Kreisstromteilen 95, die jeweils durch einen Übertritt von Wechselstrom durch die kapazitiv wirkende Strukturen 60 der eingerichteten Flächenkondensatoren zwischen den Sandwichebenen eingerichtet werden.

Der gesamte Kreisstrom 64 wechselt hier also bei einem Umlauf viermal die Sandwichebene 11, 21. Die Quadranten links vorne, rechts vorne, rechts hinten und links hinten bilden jeweils nach Art eines Flächenkondensators eine kapazitiv wirkende Struktur 60 aus, mit einer jeweiligen Fläche UEB entsprechend ca. ½ eines zugehörigen einzelnen Abdeckelements 10a, 10b, 20a, 20b.

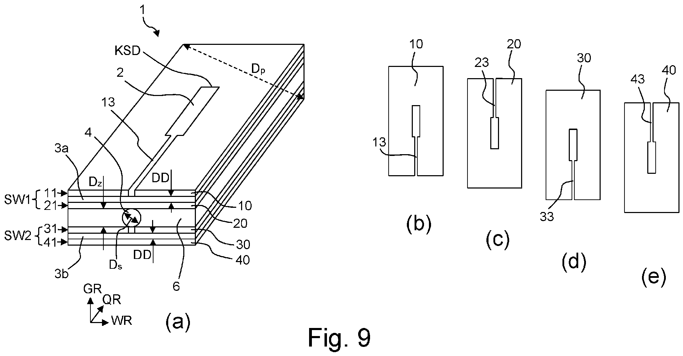

Die **Fig. 9** zeigt eine dritte Ausführungsform eines erfindungsgemäßen Zusatzelements 1, ähnlich wie in Fig. 1 dargestellt. Es werden nur die wesentlichen Unterschiede erläutert. Teilbild (a) zeigt eine Schrägansicht, Teilbild (b) zeigt eine Aufsicht (Draufsicht entlang der Grundrichtung, jeweils von oben) auf das Abdeckelement 10, Teilbild (c) eine Aufsicht auf das Abdeckelement 21, Teilbild (d) eine Aufsicht auf das Abdeckelement 30, und Teilbild (e) eine Aufsicht auf das Abdeckelement 40.

Das Zusatzelement 1 umfasst hier ein erstes Sandwich SW1 von Abdeckelementen 10, 20 in den Sandwichebenen 11, 21, und ein zweites Sandwich SW2 von Abdeckelementen 30, 40 in den Sandwichebenen 31, 41. Die erste Sandwichebene 11 enthält das Abdeckelement 10, und die zweite Sandwichebene 21 enthält das Abdeckelement 21. Weiterhin enthält die Sandwichebene 31 das Abdeckelement 30, und die vierte Sandwichebene 41 enthält das Abdeckelement 40. Die Abdeckelemente 10, 20, 30, 40 sind jeweils C-Förmig ausgebildet, und umgreifen das Durchgangsfenster 2 jeweils fast vollständig, bis auf einen jeweiligen Unterbrechungsspalt 13, 23, 34, 44, der jeweils an einer kurzen Seite KSD des Durchgangsfensters 2 gelegen ist. Innerhalb eines jeweiligen Sandwiches SW1, SW2 sind die Unterbrechungsspalten 13, 23 und 33, 43 einander gegenüberliegend. Zudem sind die Unterbrechungsspalten der mittigen Abdeckelemente 21, 31, die einander zugewandt sind, einander entgegengesetzt.

Zwischen den Abdeckelementen 10, 20 im ersten Sandwich SW1 liegt eine Schicht 3a eines Dielektrikums mit Schichtdicke DD. Zudem liegt zwischen den Abdeckelementen 30, 40 im zweiten Sandwich SW2 eine Schicht 3b eines Dielektrikums (hier ebenfalls mit Schichtdicke DD). Schließlich liegt zwischen den Abdeckelementen 20, 30 eine Schicht 6 eines Dielektrikums mit einer Dicke $D_z$.

Die Schicht 6 enthält hier auch den Probenkanal 4 mit Durchmesser $D_s$, der sich in Querrichtung QR erstreckt, wobei hier $D_s=D_z$. Das Zusatzelement 1 hat hier einen maximalen Außendurchmesser $D_p$. In der gezeigten Ausführungsform betragen DD ca. 0,15 mm, $D_s$ ca. 0,4 mm, $D_z$ ca. 0,4 mm und $D_p$ ca. 4 mm.

Mit dem Zusatzelement 1 der dritten Ausführungsform kann eine besonders hohe gesamte Kapazität C des Schwingkreises des Zusatzelements 1 erreicht werden, und damit auch eine vergleichsweise niedrige Resonanzfrequenz RF.

Weiterhin erlaubt eine entsprechende Ausführungsform mit $D_s < D_z$ einen Probenkanal zu integrieren, der keine Interferenz mit den Leiterelementen aufweist und somit besonders einfach herstellbar ist.

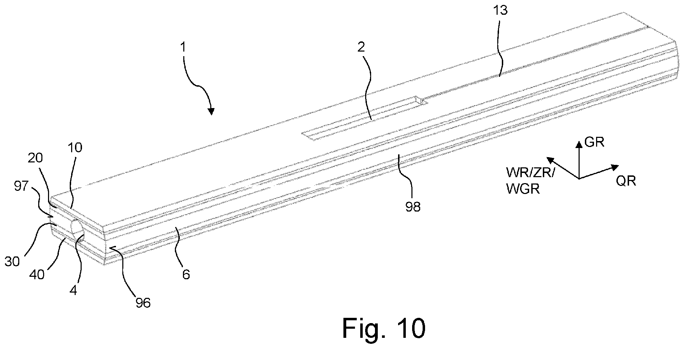

Die **Fig. 10** zeigt schematisch eine vierte Ausführungsform eines Zusatzelements 1 für die Erfindung, in einer Schrägansicht.

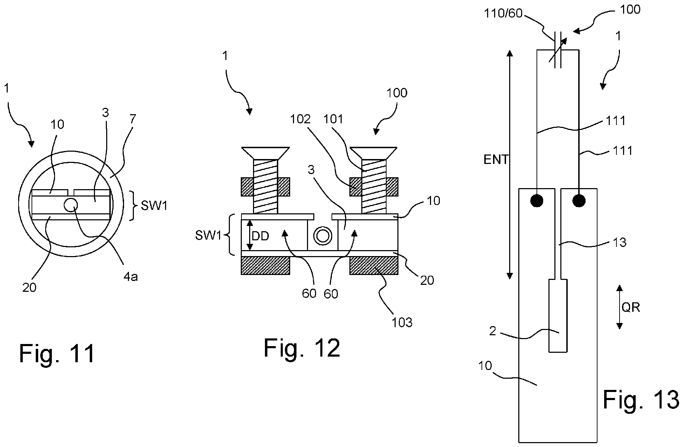

Die Ausführungsform von Fig. 10 entspricht weitgehend der Ausführungsform von Fig. 9; jedoch liegen hier die Unterbrechungsspalten der Abdeckelemente 10 und 40 im in Fig. 10 hinteren/oberen Teil des Zusatzelements 1 (in Richtung QR liegend, vgl. Bzz. 13 für Abdeckelement 10, der andere Unterbrechungsspalt von Abdeckelement 40 ist verdeckt), und die Unterbrechungsspalten der Abdeckelemente 20, 30 liegen im in Fig. 10 vorderen/unteren Teil des Zusatzelements 1 (entgegen Richtung Q liegend, jeweils verdeckt). Dadurch wird eine zusätzliche Kapazität zwischen den Abdeckelementen 20, 30 vermieden, da deren Potentiale im Wesentlichen gleich sind. Zudem reicht hier der Probenraum 4 bis in die Abdeckelemente 20, 30 über einen Teil ihrer Höhe hinein. Weiterhin sind die Seitenkanten 96, 97 des Zusatzelements 1 abgerundet, um ein Einfügen in ein Glasröhrchen oder direkt in die kreiszylinderförmige Öffnung eines NMR-Messkopfes zu erleichtern (vgl. dazu auch Fig. 11).

Das Zusatzelement 1 wird in der herkömmlichen Orientierung mit einem B1-Feld entlang der Grundrichtung GR betrieben, so dass das zugehörige B1-Feld fokussiert durch das Durchgangsfenster 2 tritt und eine dortige Messprobe bestrahlt. Das B0-Feld liegt entlang der Querrichtung QR.

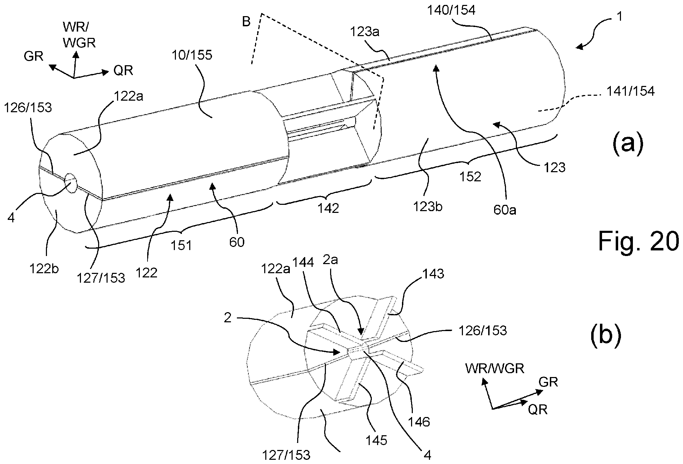

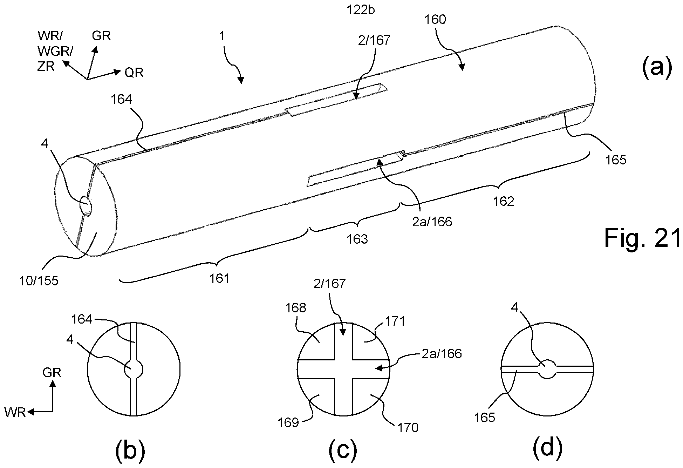

Die vergleichsweise dicke Schicht 6 des Dielektrikums zwischen den Abdeckelementen 20, 30 (und auch die vergleichsweise geringe Bauhöhe des Zusatzelements 1 in der Grundrichtung GR insgesamt) erreicht, dass ein entlang einer Zweitrichtung ZR eingestrahlter, weiterer zeitlich veränderlicher Magnetfluss ("weiteres B1-Feld") auf die Messprobe nur wenig abgeschwächt würde, insbesondere um weniger als 20%. Diese Zweitrichtung ZR liegt senkrecht zur Grundrichtung GR und senkrecht zur Querrichtung QR; die Zweitrichtung ZR entspricht also der weiteren Richtung WR. Der Raum zwischen den Abdeckelementen 20, 30 kann als ein Durchlassspalt 98 für das weitere B1-Feld aufgefasst werden, der mit einem Dielektrikum gefüllt ist. Dadurch ist diese Ausführungsform auch für die Messung von zwei verschiedenen Atomkernen in um 90° zueinander gedrehten Orientierungen geeignet; die Zweitrichtung ZR entspricht dann einer weiteren Grundrichtung WGR. Bezüglich der weiteren Grundrichtung WGR wird allerdings hier keine merkliche B1-Feld-Konzentration erreicht (vgl. aber Fig. 20, 21 hierzu).

**Fig. 11** zeigt in einem schematischen Querschnitt eine fünfte Ausführungsform eines Zusatzelements 1 gemäß der Erfindung. Das Zusatzelement 1 umfasst hier ein (erstes) Sandwich SW1 der Abdeckelemente 10, 20 mit einer zwischengeordneten Schicht 3 eines Dielektrikums, ähnlich wie in Fig. 1 gezeigt. Das Zusatzelement 1 umfasst weiterhin ein (kreis-)zylindrisches Glasröhrchen 7. Das Sandwich SW1 ist in dem Glasröhrchen 7 angeordnet, insbesondere eingeklemmt oder eingeklebt (nicht näher dargestellt). Das Zusatzelement 1 kann dann analog zu einem herkömmlichem Probenröhrchen gehandhabt werden, beispielsweise mit vorhandenen Transportsystemen ergriffen und bewegt werden, und in die Probenaufnahme eines üblichen NMR-Probenkopfs eingefügt werden.

In dem gezeigten Ausführungsbeispiel ist ein Probenkanal 4a mittig in der Schicht 3 ausgebildet; dieser Probenkanal ist vollständig von Dielektrikum der Schicht 3 umgeben, und entsprechend (über die Länge des Sandwiches SW1) rundum geschlossen bzw. dicht ausgebildet, insbesondere auch im Bereich des Durchgangsfensters. In dem Probenkanal 4a kann daher unmittelbar flüssige Messprobe eingefüllt werden.

**Fig. 12** zeigt in schematischem Querschnitt eine sechste Ausführungsform eines Zusatzelements 1 für die Erfindung.

Das Zusatzelement 1 umfasst hier ein (erstes) Sandwich SW1 der Abdeckelemente 10, 20 mit einer zwischengeordneten Schicht 3 eine Dielektrikums, ähnlich wie in Fig. 1 gezeigt. Weiterhin umfasst das Zusatzelement 1 ein Abstimmelement 100, mit welchem die Dicke DD der Schicht 3 des Dielektrikums verändert werden kann, und damit die Resonanzfrequenz des durch das Zusatzelement 1 aufgebauten Schwingkreises. Das Abstimmelement 100 weist hierfür mehrere Schrauben 101 mit Außengewinde auf, die in (auf nicht näher dargestellte Weise fixierten) Lagern 10 mit Innengewinde ein- und ausgeschraubt werden können. Ein Fußende einer jeweiligen Schraube 101 liegt auf der Oberseite des Abdeckelements 10 an. Die Unterseite des Abdeckelements 20 liegt an (auf nicht näher dargestellte Weise fixierten) Gegenlagern 103 auf.

Wenn die Schrauben 101 weiter in die Lager 102 eingeschraubt werden, wird das Sandwich SW1 elastisch zusammengepresst, und dabei die Dicke DD der Schicht 3 wird verringert. Dadurch erhöht sich die Kapazität der kapazitiv wirkenden Strukturen 60 (Flächenkondensatoren zwischen den Abdeckelementen 10, 20), was die Resonanzfrequenz des Schwingkreises senkt. Umgekehrt kann die Kapazität verringert werden, indem die Schrauben 101 aus den Lagern 102 weiter herausgeschraubt werden, wenn sich dabei das Sandwich SW1 elastisch entspannt.

Man beachte, dass die Schrauben 101 in einem ausreichenden Abstand (typischerweise 5 mm oder mehr) in Querrichtung vom Durchgangsfenster liegen sollten, um Feldverzerrungen klein zu halten.

Die **Fig. 13** zeigt schematisch eine siebente Ausführungsform eines Zusatzelements 1 für die Erfindung, welches hier ein C-förmiges Abdeckelement 10 mit einem Unterbrechungsspalt 13 umfasst (vgl. Fig. 1 hierzu). Das Zusatzelement kann zudem nicht näher dargestellte Abdeckelemente in einem ersten Sandwich oder auch einem zweiten Sandwich enthalten (nicht näher dargestellt).

Das Zusatzelement 1 ist mit einem Abstimmelement 100 versehen, welches hier als Trimmerkondensator 110 ausgebildet ist. Der Trimmerkondensator 110 ist mittels Zuleitungen 111, die hier an einem hinteren Ende des Abdeckelementes 10 beidseits des Unterbrechungsspalts 13 angelötet sind, angeschlossen. Über den Trimmerkondensator 110 kann somit ein (Wechsel-)Kreisstrom, der geschlossen um das Durchgangsfenster 2 herum fließen soll, den Unterbrechungsspalt 13 überwinden. Der Trimmerkondensator 110 ist in Querrichtung QR in einer Entfernung ENT vom Durchgangsfenster 2 angeordnet, wobei ENT $\geq$ 5 mm. Dadurch können Feldinhomogenitäten im Bereich des Durchgangsfensters 2 minimiert werden.

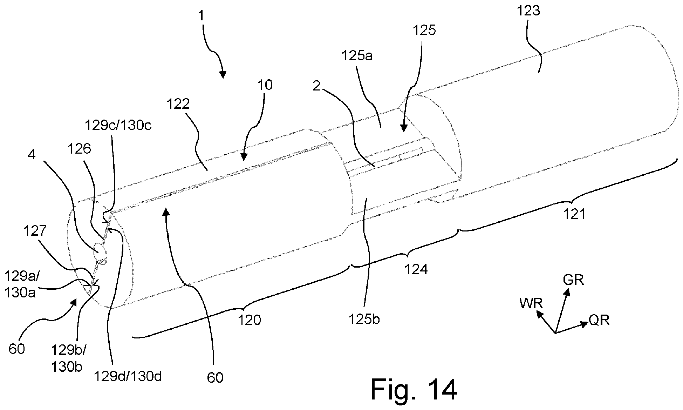

Die **Fig. 14** illustriert in schematischer Schrägansicht eine achte Ausführungsform eines Zusatzelements 1 für die Erfindung.

Dieses Zusatzelement 1 ist im Wesentlichen hantelförmig ausgebildet, und umfasst einen vorderen Endabschnitt 120 und einen hinteren Endabschnitt 121, die jeweils als Metallzylinder 122, 123 aufgebaut sind. Ein Verbindungsabschnitt 124 ist mit einer Metallplatte 125 ausgebildet, die senkrecht zur Grundrichtung GR verläuft. Die Metallplatte 125 verbindet die beiden Metallzylinder 122, 123. In der Metallplatte 125 ist das Durchgangsfenster 2 ausgebildet, wodurch die Metallplatte 125 in zwei Plattenteile 125a, 125b aufgeteilt und entsprechend elektrisch unterteilt wird. Die Plattenteile 125a, 125b liegen links und rechts des Durchgangsfensters 2. Das Zusatzelement 1 wird von einem Probenraum 4 durchzogen, der als Bohrung in Querrichtung QR mittig durch die Metallzylinder 122, 123 und die Metallplatte 125 verläuft und das Durchgangsfenster 2 schneidet. In der Anwendung wird ein statisches B0-Feld entlang der Querrichtung QR (auch als z-Richtung bezeichnet) und ein zeitlich veränderliches B1-Feld entlang der Grundrichtung GR angewandt.

Im Metallzylinder 122 des vorderen Endabschnitts 120 sind ein oberer Schlitz 126 und ein untere Schlitz 127 ausgebildet. Beide Schlitze 126, 127 verlaufen in einer Ebene, die durch die Grundrichtung GR und die Querrichtung QR aufgespannt wird, jeweils vom Probenraum 4 zu einer Außenseite des Metallzylinders 122 in radialer Richtung, wobei der Schlitz 126 nach oben und der Schlitz 127 nach unten verläuft. In den Schlitzen 126, 127 ist eine hier Schicht eines Dielektrikums angeordnet.

Das Zusatzelement 1 umfasst hier lediglich ein einziges, einstückiges Abdeckelement 10. Das Abdeckelement 10 deckt eine Abdeckzone ab, die der Projektion des Abdeckelements 10 in die Ebene senkrecht zur Grundrichtung GR entspricht (ohne den Bereich von Durchgangsfenster 2 und Schlitzen 126, 127) (Abdeckzone nicht näher markiert).

Die beiden Schlitze 126, 127 bilden jeweils eine kapazitive Struktur 60 nach Art eines Flächenkondensators aus, indem an den gegenüberliegenden Enden 129a, 129b und 129c, 129d jeweils Kopplungsflächen 130a, 130b und 130c, 130d des Zusatzelements 1 einander gegenüberliegen. Die zugehörige jeweilige Überlappungsfläche UEF entspricht jeweils ungefähr der halben Schnittfläche des Metallzylinders 122.

In Draufsicht entlang der Grundrichtung GR, also in der durch die Querrichtung und die weitere Richtung WR aufgespannten Ebene, kann ein (Wechsel-)Kreisstrom um das Durchgangsfenster 2 fließen, nämlich als ohmscher Strom vom hinteren Metallzylinder 123 über das Plattenteil 125a zum linken Teil des vorderen Metallzylinders 122, sodann mit einem kapazitiven Transfer über die Schlitze 126, 127 vom linken Teil in den rechten Teil des Metallzylinders 122, und weiter als ohmscher Strom vom rechten Teil des vorderen Metallzylinders 122 über das Plattenteil 125b wieder zum hinteren Metallzylinder 123. Entsprechend kann sich ein Schwingkreis ausbilden.

Wie üblich bei einer Lenz-Linse ist ein ohmscher Stromfluss nicht vollständig um das Durchgangsfenster 2 möglich, da die Schlitze 126, 127 (und der Probenraum 4) den ohmschen Strompfad unterbrechen. Eine ohmsche geschlossene Leiterschleife ist ähnlich wie in Fig. 2 Teilbild (a) möglich, wobei der Strom an den Schlitzen 126, 127 entlang fließt.

Bei der in Fig. 14 gezeigten Ausführungsform des Zusatzelements 1 ist es bevorzugt, ein Material für die Metallzylinder 122, 123 und die Metallplatte 125 zu verwenden, welches keine nennenswerten Shimstörungen erzeugt (beispielsweise Aluminium). Das Zusatzelement 1 kann als ein Einsatz gefertigt werden, der dieselbe Form wie ein normales Glassample (Standard-Probenröhrchen) hat, der einfach herzustellen ist (insbesondere mit wenigen Fertigungsschritten, vor allem wenn das Dielektrikum in den Spalten 129 "Luft" ist) und der zudem die Verdrängung/Konzentration von Magnetfeld maximiert, da kein zusätzliches Glaselement existiert, durch das B1 fließen kann, ohne verdrängt/konzentriert zu werden. Sollte die Kapazität des "Luftspaltes" nicht ausreichend sein, dann kann beispielsweise mittels diskreter Elemente (z.B. ein zusätzlicher Trimmerkondensator) wie Fig. 13 oder mittels "Annäheren" (elastischem Stauchen) wie in Fig. 12 dargestellt die Kapazität erhöht werden; ebenso ist es möglich, in den Luftspalt ein Dielektrikum mit hoher Permittivität (typischerweise mit $\varepsilon_r > 2$) einzufüllen.

Im Folgenden werden weitere Ausführungsformen von hantelartigen oder metallzylinderartigen Grundformen basieren Zusatzelementen erläutert. Es werden vor allem die wichtigsten Unterschiede zu der Bauform von Fig. 14 erläutert.

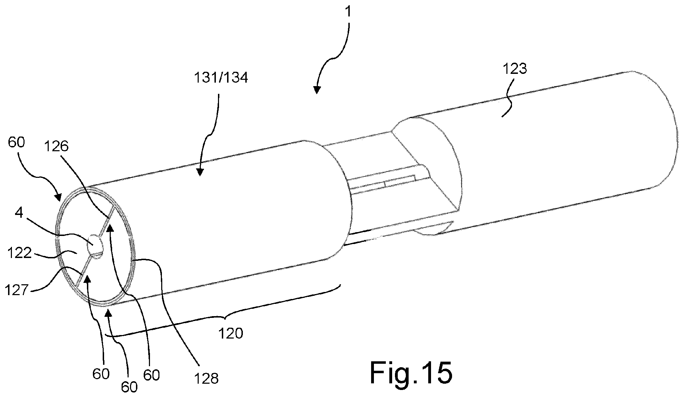

Das Zusatzelement 1 gemäß der neunten Ausführungsform von **Fig. 15** entspricht weitestgehend der Ausführungsform von Fig. 14, wobei aber zusätzlich ein Metallrohr 131 um den vorderen Metallzylinder 122 angeordnet ist, und zwischen dem Metallrohr 131 und dem vorderen Metallzylinder 122 liegt ein radialer Spalt 128, der mit einer Schicht eines Dielektrikums gefüllt ist.

Das Metallrohr 131 übergreift entsprechend die Schlitze 126, 127 an der Zylinderaußenseite des Metallzylinders 122. Dadurch werden weitere kapazitive Strukturen 60 eingerichtet, über die der Wechselstrom vom linken Teil in den Rechten Teil des Metallzylinders 122 kapazitiv transferiert werden kann. Entsprechend wird eine höhere gesamte Kapazität erreicht, und es ist eine kleinere Resonanzfrequenz des Schwingkreises des Zusatzelements 1 erreichbar.

Eine weitere Funktion des Metallrohrs 131 ist, dass es im vorderen Endbereich 120 zusätzlich als Abschirmelement 134 wirkt, so dass dort eine Abschirmung des Probenraums 4 gegenüber dem B1-Feld erreicht wird, welches ansonsten in gewissen Umfang durch die Schlitze 126, 127 dringen könnte.

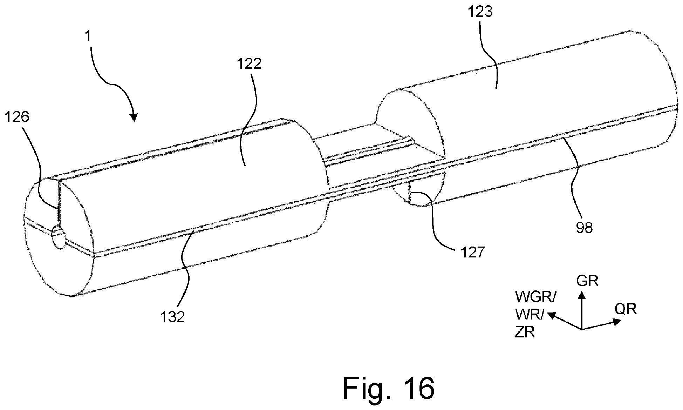

In der zehnten Ausführungsform von **Fig. 16** weist der vordere Metallzylinder 122 den oberen Schlitz 126 auf, und der hintere Metallzylinder 123 weist den unteren Schlitz 127 auf. Zudem ist ein Mittelschlitz 132 vorgesehen, der mittig durch das Zusatzelement 1 entlang einer durch die Querrichtung QR und die weitere Richtung WR aufgespannten Ebene verläuft. Der Mittelschlitz 132 unterteilt die Metallzylinder 122, 123 und auch die Metallplatte 125, und ist mit einer Schicht eines Dielektrikums befüllt.

Bei dieser Ausführungsform können sich oberhalb und unterhalb des Mittelschlitzes 132 jeweils (Wechsel-)Kreisströme wie in der Ausführungsform von Fig. 14 einstellen. Zusätzlich sind auch kapazitive Stromtransfers ähnlich wie in der Ausführungsform von Fig. 1 möglich, vgl. dortige Fig. 4.

Der vergleichsweise breite Mittelschlitz 132 kann zudem als ein Durchlassspalt 98 fungieren, der zusammen mit dem freien Bereich oberhalb und unterhalb der Metallplatte 125 eine gute Transparenz für einen weiteren zeitlich veränderlichen Magnetfluss entlang einer Zweitrichtung ZR, die senkrecht zur Grundrichtung GR (und senkrecht zur Querrichtung QR) verläuft, bewirkt. Dadurch ist diese Ausführungsform nicht nur für eine NMR-Messung in der normalen Orientierung (mit B1-Feld entlang der Grundrichtung GR), sondern auch für eine weitere NMR-Messung mit einer um 90°gedrehten Orientierung gut geeignet (mit einem weiteren B1-Feld entlang der Zweitrichtung ZR, die dann auch als weitere Grundrichtung WGR bezeichnet wird).

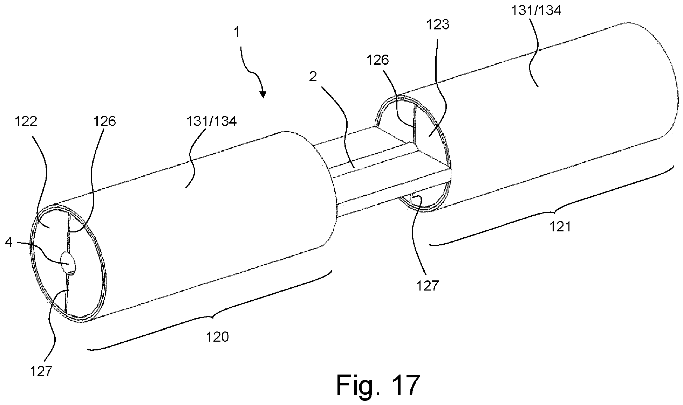

Die elfte Ausführungsform eines Zusatzelements 1, die in **Fig. 17** dargestellt ist, verfügt in beiden Metallzylindern 122, 123 jeweils über einen oberen Schlitz 126 und einen unteren Schlitz 127 sowie ein umgebendes Metallrohr 131. (Wechsel-)Kreisströme um das Durchgangsfenster 2 müssen hier sowohl im vorderen Metallzylinder 122, als auch im hinteren Metallzylinder 123 kapazitiv über die Schlitze 126, 127 transferiert werden. Durch die Verschaltung von zwei Kondensatoren in Serie steigt die Eigenresonanzfrequenz im Vergleich zu den vorhergehenden Ausführungsformen an. Zusammen mit den Metallrohren 131 kann die Kapazität noch weiter gesteigert werden, so dass trotz Serieverschaltung vergleichbare Eigenresonanzfrequenzen auch ohne Veränderung der Dielektrizitätskonstante oder der Dicke der Dielektrika erreicht werden können. Zudem wirken die Metallrohre 131 wiederum zusätzlich als Abschirmelemente 134 im vorderen Endabschnitt 120 und im hinteren Endabschnitt 121.

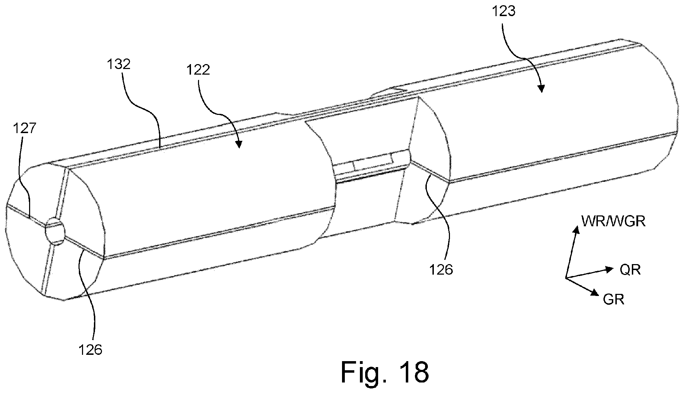

Zwei unabhängig einstellbare orthogonale Moden werden mit der zwölften Ausführungsform eines Zusatzelements 1 von **Fig. 18** erreicht. Hier sind in beiden Metallzylindern 122, 123 jeweils ein oberer Schlitz 126 und ein unterer Schlitz 127 vorgesehen, und zudem ist ein Mittelschlitz 132 vorgesehen. Die über die Schlitze 126, 127 ausgebildete Kapazität beeinflusst vor allem die Resonanzfrequenz der Mode, deren B1-Feld in der Grundrichtung GR orientiert ist, wohingegen die über den Mittelschlitz 132 ausgebildeten Kapazitäten vor allem die Resonanzeigenschaften der Mode beeinflussen, deren B1-Feld entlang der weiteren Grundrichtung WGR orientiert ist.

Die **Fig. 19** zeigt eine dreizehnte Ausführungsform eines Zusatzelements 1 für die Erfindung, wobei beide Metallzylinder 122, 123 jeweils einen oberen Schlitz 126 und einen unteren Schlitz 127 aufweisen, die jedoch jeweils in einer eigenen, durch die Querrichtung QR und die weitere Richtung WR aufgespannten Ebene angeordnet sind. Der jeweils obere Schlitz geht von der oberen Kante des Probenraums 4 ab, und der untere Schlitz 127 geht von der unteren Kante des Probenraums 4 ab (oben und unten wird anhand der Grundrichtung bestimmt). Die Schlitzte 126, 127 sind jeweils mit einer Schicht 133 eines Dielektrikums gefüllt, und die Schicht 133 wird hier auch jeweils im Verbindungsbereich 124 fortgesetzt, mit einem Schichtabschnitt an der Unterseite des Plattenteils 125b und einem Schichtabschnitt an der Oberseite des Plattenteils 125a. Durch die Schlitze 126, 127 werden hier kapazitiv wirkende Strukturen 60 ausgebildet.

Ein "unterer" Wechselkreisstrom kann hier beispielsweise als ohmscher Strom vom unteren Teil des Metallzylinders 122 über das linke Plattenteil 125a zum unteren Teil des Metallzylinders 123 fließen. Um jedoch rechts am Durchgangsfenster 2 vorbei fließen zu können, muss der Strom kapazitiv nach oben transferiert werden, beispielsweise im hinteren Metallzylinder 123 durch den unteren Schlitz 127 hindurch. Dann kann er ohmsch durch das rechte Plattenteil 125b fließen. Um den Kreis zu schließen, muss der Strom dann wieder kapazitiv nach unten transferiert werden, beispielsweise in vorderen Metallzylinder 122 durch den unteren Schlitz 127 hindurch. Entsprechendes gilt für einen "oberen" Wechselstromkreis.

Die **Fig. 20** illustriert eine vierzehnte Ausführungsform eines Zusatzelements 1 in einem oberen Teilbild (a), das eine Gesamtansicht zeigt, und in einem unteren Teilbild (b), das die vordere Hälfte des Zusatzelements 1 mit einer Schnittfläche entsprechend der Ebene B in Teilbild (a) zeigt.

Ein erster Endabschnitt 151 des Zusatzelements 1 wird durch einen vorderen Metallzylinder 122 gebildet, und ein zweiter Endabschnitt 152 wird durch einen hinteren Metallzylinder 123 gebildet.

Der vordere Metallzylinder 122 verfügt (ähnlich wie aus Fig. 14 bekannt) über einen oberen Schlitz 126 und einen unteren Schlitz 127, die parallel zur Grundrichtung GR (und entlang der Querrichtung QR) verlaufen. Die obere Schlitz 126 und der untere Schlitz 127 werden hier zusammen auch als erster Schlitz 153 bezeichnet, der den Metallzylinder 122 in eine rechte Hälfte 122a und eine linke Hälfte 122b teilt.

Der hintere Metallzylinder 123 verfügt über einen rechtsseitigen Schlitz 140 und einen linksseitigen Schlitz 141 (verdeckt in Fig. 20), die jeweils senkrecht zur Grundrichtung GR liegen. Der rechtsseitige Schlitz 140 und der linksseitige Schlitz 141 zusammen werden auch als zweiter Schlitz 154 bezeichnet, der den hinteren Metallzylinder 123 in eine obere Hälfte 123a und eine untere Hälfte 123b teilt. Die Schlitze 126, 127, 140, 141 erstrecken sich jeweils vom Probenraum 4 radial nach außen zu den jeweiligen Zylinderaußenflächen der Metallzylinder 122, 123, und gehen jeweils mittig vom Probenraum 4 ab.

Ein Verbindungsabschnitt 142 verbindet die Metallzylinder 122, 123 und ist mit vier Metallplattenteilen 143, 144, 145, 146 ausgebildet, die kreuzförmig um den Probenkanal 4 (bzw. dessen Projektion im Bereich des Verbindungsabschnitts 142) angeordnet sind. Die Metallplatten 143, 144, 145, 146 schließen jeweils einen Winkel von 45° zur Grundrichtung GR ein, und auch jeweils einen Winkel von 45° zur weiteren Richtung WR ein. In Projektion entlang der Grundrichtung GR verbleibt eine Lücke zwischen den radial inneren Enden der Metallplattenteile 143, 144, 145, 146, was einem Durchgangsfenster 2 entspricht.

In dieser Ausführungsform kann (in der bisher vorgestellten *normalen Orientierung)* bezogen auf ein erstes B1-Feld parallel zur Grundrichtung GR ein Wechselkreisstrom ähnlich wie in der Ausführungsform von Fig. 14 um das Durchgangsfenster 2 fließen:

Ein ohmscher Strom kann von der rechten Hälfte 122a des Metallzylinders 122 durch die Metallplattenteile 143, 144 in die obere und untere Hälfte 123a, 123b des Metallzylinders 123 und weiter durch die Metallplattenteile 145, 146 in die linke Hälfte 122b des Metallzylinders 122 fließen. Zwischen den Hälften 122a, 122b des Metallzylinders 122 ist jedoch ein kapazitiver Stromtransfer über den ersten Schlitz 153 als kapazitiv wirkende Struktur 60 erforderlich. Die Unterteilung des hinteren Metallzylinders 123 in eine obere Hälfte 123a und eine untere Hälfte 123b durch die Schlitze 140, 141 spielt keine Rolle. Entsprechend wird ein Schwingkreis eingerichtet.

Das Zusatzelement 1 kann jedoch auch in einer *weiteren Orientierung* betrieben werden, nämlich mit einem zweiten B1-Feld parallel zur weiteren Richtung WR; die bisherige weitere Richtung WR wird in diesem Fall auch als weitere Grundrichtung WGR bezeichnet. In Projektion entlang der weiteren Grundrichtung WGR verbleibt ebenfalls eine Lücke zwischen den radial inneren Enden der Metallplattenteile 143, 144, 145, 146, was einem weiteren Durchgangsfenster 2a entspricht. Um das weitere Durchgangsfenster 2a stellt sich ein weiterer Wechselkreisstrom ein:

Ein ohmscher Strom kann von der oberen Hälfte 123a des Metallzylinders 123 durch die Metallplattenteile 146, 143 in die rechte und linke Hälfte 122a, 122b des Metallzylinders 122 und weiter durch die Metallplattenteile 144, 145 in die untere Hälfte 123b des Metallzylinders 123 fließen. Zwischen den Hälften 123a, 123b des Metallzylinders 123 ist jedoch ein kapazitiver Stromtransfer über den zweiten Schlitz 154 als weitere kapazitiv wirkende Struktur 60a erforderlich. Die Unterteilung des vorderen Metallzylinders 122 in eine rechte Hälfte 122a und eine linke Hälfte 122b durch die Schlitze 126, 127 spielt keine Rolle. Entsprechend wird ein weiterer Schwingkreis eingerichtet.

Wenn in der erste Schlitz 153 und der zweite Schlitz 154 eine unterschiedliche Spaltbreite und/oder ein unterschiedliches Dielektrikum aufweisen, kann somit auf einfache Weise ein Zusatzelement 1 bereit gestellt werden, das je nach Orientierung eine andere Resonanzfrequenz des jeweils genutzten Schwingkreises aufweist.

Man beachte, dass in der Ausführungsform von Fig. 20 das Zusatzelement 1 mit einem einzigen, komplexes Metallbauteil ausgebildet wird, welches in der bisher vorgestellten Orientierung (B1 parallel GR) als Abdeckelement 10, und in der weiteren Orientierung (B1 parallel WGR) als weiteres Abdeckelement 155 fungiert. Als Abdeckelement 10 wird eine Abdeckzone abgedeckt, die der Projektion des Zusatzelements 1 in die Ebene senkrecht zur Grundrichtung GR entspricht (ohne den Bereich von Durchgangsfenster 2 und erstem Schlitz 153). Als weiteres Abdeckelement 155 wird eine weitere Abdeckzone abgedeckt, die der Projektion des Zusatzelements 1 in die Ebene senkrecht zur weiteren Grundrichtung WGR entspricht (ohne den Bereich von weiterem Durchgangsfenster 2a und zweitem Schlitz 154) (Abdeckzone und weitere Abdeckzone nicht gesondert markiert).

Die **Fig. 21** zeigt eine fünfzehnte Ausführungsform eines Zusatzelements 1 für die Erfindung.

Das Zusatzelement 1 ist hier im Wesentlichen durch einen zylindrischen Metallkörper 160 ausgebildet, der einen ersten, vorderen Seitenabschnitt 161, einen zweiten, hinteren Seitenabschnitt 162 und einen dazwischen liegenden mittleren Abschnitt 163 aufweist. Teilbild (a) zeigt eine Gesamtansicht, Teilbild (b) einen Querschnitt (senkrecht zur Querrichtung QR) im vorderen Seitenabschnitt 161, Teilbild (b) einen Querschnitt im mittleren Abschnitt 163, und Teilbild (d) einen Querschnitt im hinteren Seitenabschnitt 162.

Das Zusatzelement 1 weist im ersten Seitenabschnitt 161 einen ersten geschlitzten Bereich 164 auf, welcher sich parallel zur Grundrichtung GR (und entlang der Querrichtung QR) mittig im Metallzylinder 160 erstreckt. Weiterhin weist das Zusatzelement 1 im zweiten Seitenabschnitt 162 einen zweiten geschlitzten Bereich 165 auf, welcher sich senkrecht zur Grundrichtung GR (und entlang der Querrichtung QR) mittig im Metallzylinder 160 erstreckt. Zudem weist der mittlere Abschnitt 163 eine Ausnehmung 167 auf, die sich entlang der Grundrichtung GR erstreckt und den Probenraum 4 schneidet, und dadurch das Durchgangsfenster 2 ausbildet. Der mittlere Abschnitt 163 weist weiterhin einen dritten geschlitzten Bereich 166 auf, der sich entlang der weiteren Richtung WR erstreckt und den Probenkanal 4 schneidet. In den geschlitzten Bereichen 164, 165 kann jeweils ein Dielektrikum angeordnet werden.

Die Ausführungsform des Zusatzelements 1 von Fig. 21 entspricht funktional der Ausführungsform von Fig. 20. Insbesondere kann das Zusatzelement 1 in der normalen Orientierung mit einem B1-Feld entlang der Grundrichtung GR betrieben werden, unter Nutzung des Durchgangsfensters 2. Ebenso kann das Zusatzelement 1 in einer um 90° gedrehten, weiteren Orientierung mit einem B1-Feld entlang der weiteren Richtung WR (=weitere Grundrichtung WGR) betrieben werden. Die Ausbildung von Wechselkreisströmen in beiden Orientierungen entspricht den Angaben von Fig. 20, wobei die Sektoren 168, 169, 170, 171 im mittleren Abschnitt 163 an die Stelle der Metallplattenteile (Bzz. 143, 144, 145, 146 in Fig. 20) treten.

Auch in der Ausführungsform von Fig. 21 wird das Zusatzelement 1 mit einem einzigen, komplexes Metallbauteil ausgebildet, welches in der normalen Orientierung (B1 parallel GR) als Abdeckelement 10, und in der weiteren Orientierung (B1 parallel WGR) als weiteres Abdeckelement 155 fungiert.

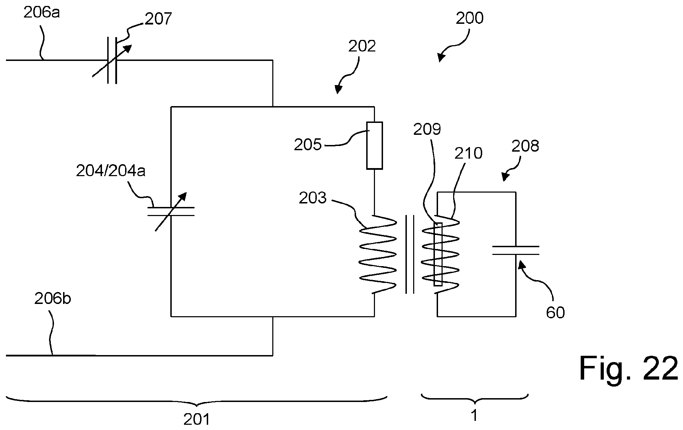

Die **Fig. 22** illustriert schematisch einen Teil der elektrischen Verschaltung einer beispielhaften Ausführungsform einer Messanordnung 200 gemäß der Erfindung.

Die Messanordnung 200 umfasst auf Seiten eines Probenkopfs 201 einen Mess-Schwingkreis 202, der eine HF-Spule 203, einen verstellbaren Kondensator 204 und einen ohmschen Widerstand 205 in einer seriellen Verschaltung umfasst. Über den verstellbaren Kondensator 204 kann eine Frequenzabstimmung ("tuning") des Mess-Schwingkreises 202 erfolgen; der verstellbare Kondensator 204 stellt daher eine Abstimmeinrichtung 204a dar. Mit der Abstimmeinrichtung 204a kann eine Resonanzfrequenz des Mess-Schwingkreises 202 zwischen einer untersten abstimmbaren Frequenz UF und einer obersten abstimmbaren Frequenz OF (jeweils ohne Zusatzelement) abgestimmt werden.

Der Mess-Schwingkreis 202 verfügt hier über Anschlüsse 206a, 206b für die Einspeisung und das Auslesen von HF-Impulsen, wobei der Anschluss 206a über einen weiteren verstellbarer Kondensator 207 zum Mess-Schwingkreis 202 führt. Mit dem weiteren verstellbaren Kondensator 207 kann eine Impedanzanpassung ("matching") erfolgen. Der Anschluss 206b kann auf Masse liegen.

Der Mess-Schwingkreis 202 ist erfindungsgemäß mit dem Schwingkreis 208 des Zusatzelements 1 gekoppelt; hierfür ist das Zusatzelement 1 in eine Probenaufnahme des NMR-Probenkopfs 201 eingeführt (zur Wirkung der Kopplung siehe auch Fig. 5 oben). Dem Schwingkreis 208 des Zusatzelements 1 kann eine Kapazität zugeordnet werden, die im Wesentlichen durch die zumindest eine kapazitiv wirkende Struktur 60 des Zusatzelements 1 bestimmt wird. Im Zusatzelement 1 ist die zu vermessende Probe 209 angeordnet und wird durch das Durchgangsfenster dem zeitlich veränderlichen B1-Feld der HF-Spule 203 ausgesetzt, wobei eine Fokussierung des Magnetflusses bewirkt wird. Den Strukturen des Zusatzelements 1, die einen um das Durchgangsfenster herum fließenden Wechselstrom einrichten, kann eine Induktivität zugewiesen werden, entsprechend einer Zusatzelement-Spule 210 im illustrierten Schaltbild. Der Kopplung der Schwingkreise 202, 208 kann im Schaltbild eine Kopplung der HF-Spule 203 und der Zusatzelement-Spule 210 zugeordnet werden. Der Schwingkreis 208 hat erfindungsgemäß eine Eigenresonanz mit einer Resonanzfrequenz RF zwischen 5 MHz und 3000 MHz.

Die **Fig. 23** zeigt schematisch ein NMR-Spektrometer 220, in welchem eine erfindungsgemäße Messanordnung 200 verwendet wird. Die Messanordnung 200 wird durch einen NMR-Probenkopf 201 und ein in dessen Probenaufnahme angeordnetes Zusatzelement 1 gebildet.

Das NMR-Spektrometer 220 verfügt über einen Hintergrundmagneten 221, der ein statisches und am Ort der Messprobe homogenes Magnetfeld B0 erzeugt. Der Hintergrundmagnet 221 ist hier eine supraleitende Spule in einem Kryostaten 222, der eine Raumtemperaturbohrung 223 aufweist. In diese ragt der NMR-Probenkopf 201 ein. An dessen vorderem Ende ist die HF-Spule 203 angeordnet. In der HF-Spule 203 ist wiederum das Zusatzelement 1 einschließlich der zu vermessenden Messprobe angeordnet. Die HF-Spule 203 erzeugt ein zeitlich veränderliches Magnetfeld B1, das senkrecht zum Hintergrundfeld B0 ausgerichtet ist.

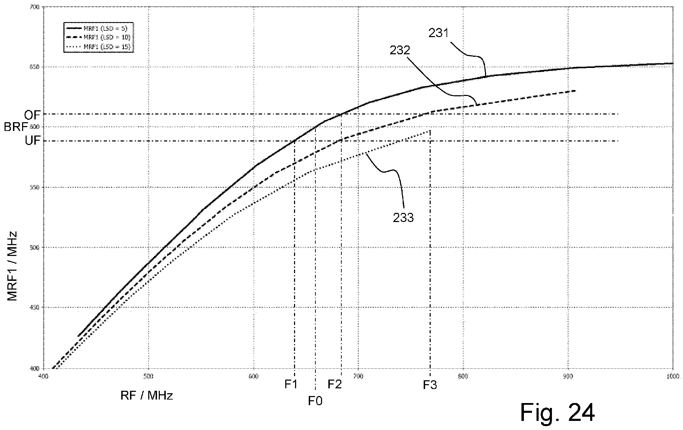

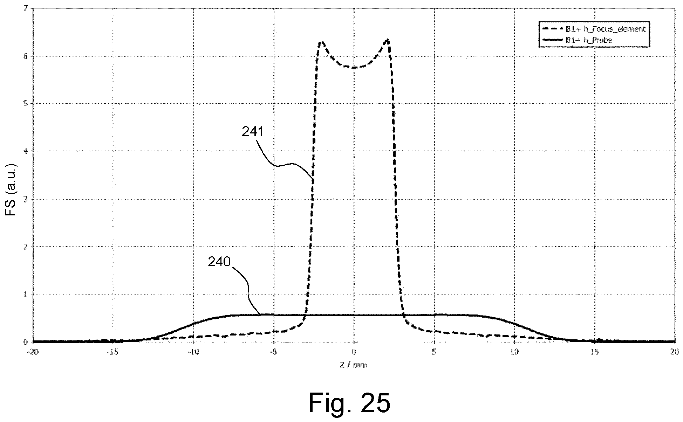

Die Fig. 24 und die Fig. 25 illustrieren den Effekt der Erfindung anhand eines Zusatzelement-Designs, das im Wesentlichen wie in Fig. 17 gezeigt aufgebaut ist (elfte Ausführungsform), anhand von Simulationsberechnungen. Es wurden Zusatzelemente mit unterschiedlichen Längen der langen Seite des Durchgangsfensters (LSD) herangezogen, mit LSD = 5 mm, LSD = 10 mm und LSD = 15 mm. Zudem wurde die Resonanzfrequenz RF der jeweiligen Zusatzelemente dadurch variiert, dass in den Schlitzen und dem radialen Spalt jeweils Dielektrika mit unterschiedlicher relativer Permittivität $\varepsilon_r$ angenommen wurden. Man beachte, dass dabei die kleinste anzunehmende relative Permittivität als Grenzfall $\varepsilon_r = 1$ ist, wodurch die erreichbare Resonanzfrequenz RF der Zusatzelemente nach oben hin im jeweiligen Design begrenzt wird; eine höhere Permittivität wäre dann nur durch eine Änderung des Designs möglich, z.B. durch größere Spaltbreiten oder Verkürzung der Länge der Zusatzelemente. Eine untere Grenze der erreichbaren Resonanzfrequenzen RF ergibt sich durch das verfügbare Dielektrikum mit der höchsten relativen Permittivität.

Die **Fig. 24** zeigt nach rechts aufgetragen jeweils die Resonanzfrequenz RF in MHz, und nach oben aufgetragen die Frequenz für das sich ergebende untere Maximum in der Resonanzkurve des Mess-Schwingkreises in einem herkömmlichen NMR-Probenkopf, also die Modenresonanzfrequenz MRF1 der unteren Mode, unter gleichzeitiger Berücksichtigung der Frequenzverschiebung durch Feldverdrängung, in MHz. Die sich ergebende Modenresonanzfrequenz MRF1 hängt von der Kopplung von HF-Resonator oder HF-Spule im NMR-Probenkopf einerseits und dem Zusatzelement andererseits ab, und vor allem von der Resonanzfrequenz RF des Zusatzelements. Die Messpunkte für eine jeweilige Größe des Zusatzelements sind miteinander zu Kurven 231 (für LSD = 5 mm), 232 (für LSD = 10 mm), 233 (für LSD = 15 mm) verbunden. Die Basis-Resonanzfrequenz BRF des Mess-Schwingkreises des NMR-Probenkopfs ohne Zusatzelement ist hier 600 MHz, und der NMR-Probenkopf erlaubt hier eine Abstimmung zwischen den Frequenzen UF = 590 MHz und OF = 610 MHz.

Für das Zusatzelement mit LSD = 5 mm, vgl. Kurve 231, sind Resonanzfrequenzen RF bis über 1000 MHz zugänglich. Mit einer Resonanzfrequenz RF von F0 von hier ca. 660 MHz kann eine Modenresonanzfrequenz MRF1 von 600 MHz erreicht werden, was der Basis-Resonanzfrequenz BRF entspricht. Resonanzfrequenzen RF zwischen einer ersten Grenzfrequenz F1 bei ca. 630 MHz und einer zweiten Grenzfrequenz F2 bei ca. 685 MHz führen zu Werten von MRF1, die im Bereich zwischen UF und OF sind, und dementsprechend mit dem vorhandenen NMR-Probenkopf noch abstimmbar wären.

Für das Zusatzelement mit LSD = 10 mm, vgl. Kurve 232, sind Resonanzfrequenzen RF bis ca. 910 MHz zugänglich. Eine Resonanzfrequenz RF von ca. 720 MHz führt hier zu einer Modenresonanzfrequenz MRF1 von 600 MHz, entsprechend BRF. Der abstimmbare Bereich für MRF1 zwischen UF und OF ist für dieses Design vollständig zugänglich (jeweils nicht näher eingezeichnet in Fig. 24).

Für das Zusatzelement mit LSD = 15mm, vgl. Kurve 233, sind Resonanzfrequenzen RF bis ca. 770 MHz zugänglich. Bei dieser höchsten zugänglichen Resonanzfrequenz F3 = 770 MHz wird eine Modenresonanzfrequenz MRF1 von lediglich ca. 596 MHz erreicht; die Modenresonanzfrequenz MRF1 kann also mit dem zugehörigen Zusatzelement nicht ganz auf die Basis-Resonanzfrequenz BRF zurückgeschoben werden. Da aber die erreichbare Modenresonanzfrequenz MRF1 noch zwischen UF und OF liegt, ist auch mit diesem Zusatzelement der vorhandene NMR-Probenkopf noch abstimmbar, und NMR-Messungen sind möglich.

Wäre das Zusatzelement als eine herkömmliche Lenzlinse ausgebildet (und würde also keinen Schwingkreis mit Eigenresonanz ausbilden wie ein erfindungsgemäßen Zusatzelement), entspräche dies einer (für die Zwecke der Simulation) gegen "unendlich" gehenden Resonanzfrequenz RF des Zusatzelements. In diesem Fall würde lediglich die Resonanzfrequenz des Mess-Schwingkreises mit Zusatzelement aufgrund der Frequenzverschiebung durch Feldverdrängung auf über 650 MHz ansteigen. Das wäre außerhalb des durch UF und OV angegebenen abstimmbaren Bereichs, und der NMR-Probenkopf könnte nicht mehr für eine NMR-Messung verwendet werden.

Die **Fig. 25** zeigt weiterhin ein Diagramm, in welchem in der Probenaufnahme des NMR-Probenkopfs die Feldstärke FS des B1-Feldes (nach oben aufgetragen, in willkürlichen Einheiten a.u.) als Funktion der z-Position (entlang der Querrichtung, nach rechts aufgetragen in mm) auf der Mittelachse der Probenaufnahme (entspricht auch der Mittelachse des Probenraums der Zusatzelemente) um das magnetische Zentrum herum bestimmt wurde.

Die Kurve 240 zeigt die Feldstärke ohne Zusatzelement; das B1-Feld hat in diesem Fall zwischen ca. -8 mm und +8 mm eine einheitliche, geringe Feldstärke von ca. 0,6 a.u..

Die Kurve 241 zeigt die Feldstärke des B1-Felds mit Zusatzelement, wobei für die Fig. 25 das Design des Zusatzelement mit LSD = 5 mm gewählt wurde. Mit Zusatzelement beträgt die Feldstärke des B1-Felds im Bereich von -2,5 mm bis +2,5 mm ca. 6 a.u., und ist damit ca. 10 mal höher als ohne das Zusatzelement. Man beachte, dass eine Konzentration des B1-Feldes sowohl in der Querrichtung als auch in der weiteren Richtung erfolgt, so dass die Feldvergrößerung größer ist als es der Bereichsverkleinerung in der Querrichtung allein entsprechen würde.

Das Beispiel von Fig. 24 und 25 zeigt, dass mit einem erfindungsgemäßen Zusatzelement geeigneter Resonanzfrequenz RF seiner Eigenresonanz (und geeigneter Kopplung zum NMR-Probenkopf) die Feldstärke des B1-Feldes im Bereich der Messprobe deutlich gesteigert werden kann (siehe Fig. 25), und gleichzeitig die Resonanzfrequenz des Mess-Schwingkreises für die NMR-Messung im Wesentlichen beibehalten werden kann (Fig. 24).

Zusammenfassend betrifft die Erfindung ein Zusatzelement (1) zum Fokussieren eines zeitlich veränderlichen Magnetflusses (B1), für den Einbau in eine Probenaufnahme (51) eines NMR-Probenkopfs (201),

wobei das Zusatzelement (1) wenigstens bezüglich einer Draufsicht entlang einer Grundrichtung (GR) eine Abdeckzone (5) und ein Durchgangsfenster (2) ausbildet, wobei die Abdeckzone (5) das Durchgangsfenster (2) umschließt,

wobei das Zusatzelement (1) ein oder mehrere Abdeckelemente (10; 10a, 10b; 20; 20a, 20b; 30, 40) aufweist, die zumindest im Bereich eines Teils ihrer jeweiligen Randkurve oder äußeren Oberfläche elektrisch leitfähig sind, wobei die Gesamtheit der Abdeckelemente eine oder mehrere geschlossene Leiterschleifen (14, 24) ausbildet, wobei die gesamte Überdeckung der zugehörigen einen oder mehreren Leiterschleifenflächen (14a, 24a) die Abdeckzone (5) bildet, die einen Flächeninhalt $A_{abdeck}$ aufweist,

und wobei das Durchgangsfenster (2) einen Flächeninhalt $A_{fenster}$ aufweist mit $A_{ab\text{-}deck} \geq 2 \ast A_{fenster}$,

und wobei das Zusatzelement (1) wenigstens eine kapazitiv wirkende Struktur (60) umfasst, so dass das Zusatzelement (1) einen elektrischen Schwingkreis (208) umfassend das eine oder die mehreren Abdeckelemente ausbildet, mit einer Eigenresonanz einer Resonanzfrequenz RF, mit 5 MHz ≤ RF ≤ 3000 MHz. Mit dem Zusatzelement kann das Signal-zu-Rauschverhältnis mit Messproben geringen Volumens bei Vermessung in einem vorhandenen NMR-Probenkopf verbessert werden.

Bezugszeichenliste

| 1 | Zusatzelement |
|---|---|
| 2 | Durchgangsfenster |
| 2a | weiteres Durchgangsfenster |
| 3 | Schicht von Dielektrikum (einziges Sandwich) |
| 3a | Schicht von Dielektrikum (erstes von zwei Sandwiches) |
| 3b | Schicht von Dielektrikum (zweites von zwei Sandwiches) |
| 4 | Probenraum |
| 4a | Probenkanal |
| 5 | Abdeckzone |
| 6 | Schicht von Dielektrikum (zwischen erstem und zweitem Sandwich) |
| 7 | Glasröhrchen |
| 10 | Abdeckelement |
| 10a, 10b | Abdeckelemente |
| 11 | erste Sandwichebene |
| 12a-12d | Enden von Abdeckelementen |
| 13 | Unterbrechungsspalt |
| 13a, 13b | Unterbrechungsspalt |
| 14 | geschlossene Leiterschleife |
| 14a | Leiterschleifenfläche |
| 15 | Kopplungsfläche |
| 16 | (ohmscher) Kreisstromteil |
| 20 | Abdeckelement |
| 20a, 20b | Abdeckelemente |
| 21 | zweite Sandwichebene |
| 22a-22d | Enden von Abdeckelementen |
| 23 | Unterbrechungsspalt |
| 23a, 23b | Unterbrechungsspalt |
| 24 | geschlossene Leiterschleife |
| 24a | Leiterschleifenfläche |
| 25 | Kopplungsfläche |
| 26 | (ohmscher) Kreisstromteil |
| 30 | Abdeckelement |
| 31 | dritte Sandwichebene |
| 33 | Unterbrechungsspalt |
| 40 | Abdeckelement |
| 41 | vierte Sandwichebene |
| 43 | Unterbrechungsspalt |
| 50 | HF-Spule |
| 51 | Probenaufnahme des NMR-Probenkopfs |
| 52 | aktives Volumen |
| 60 | kapazitiv wirkende Strukturen |
| 60a | weitere kapazitiv wirkende Struktur |
| 61, 62 | Kreisstromteile (mit kapazitivem Transfer) |
| 64 | gesamter Kreisstrom (Wechsel-Kreisstrom) |
| 71 | Resonanzkurve (HF-Resonator allein) |
| 72 | Resonanzkurve (HF-Resonator mit Zusatzelement, wirkend nur als Lenz-Linse) |
| 73 | Resonanzkurve (HF-Resonator mit Zusatzelement, wirkend als Lenz-Linse und als gekoppelter Schwingkreis) |
| 81 | Resonanzkurve (HF-Resonator mit Zusatzelement, wirkend als Lenz-Linse und als gekoppelter Schwingkreis) |

| | |
|---|---|
| 82 | Resonanzkurve (HF-Resonator mit Zusatzelement, wirkend als Lenz-Linse und als gekoppelter Schwingkreis) |
| 91-94 | (ohmsche) Kreisstromteile |
| 95 | Kreisstromteile (mit kapazitivem Transfer) |
| 96, 97 | Seitenkanten |
| 98 | Durchlassspalt |
| 100 | Abstimmelement |
| 101 | Schraube |
| 102 | Lager |
| 103 | Gegenlager |
| 110 | Trimmerkondensator |
| 111 | Zuleitungen |
| 120 | vorderer Endabschnitt |
| 121 | hinterer Endabschnitt |
| 122 | vorderer Metallzylinder |
| 122a | linke Hälfte (vorderer Metallzylinder) |
| 122b | rechte Hälfte (vorderer Metallzylinder) |
| 123 | hinterer Metallzylinder |
| 123a | obere Hälfte (hinterer Metallzylinder) |
| 123b | untere Hälfte (hinterer Metallzylinder) |
| 124 | Verbindungsabschnitt |
| 125 | Metallplatte |
| 125a | linkes Plattenteil |
| 125b | rechtes Plattenteil |
| 126 | oberer Schlitz |
| 127 | unterer Schlitz |
| 128 | radialer Spalt |
| 129a-129d | gegenüberliegende Enden |
| 130a-130d | Kopplungsflächen |
| 131 | Metallrohr |
| 132 | Mittelschlitz |
| 133 | Schicht von Dielektrikum (Mittelschlitz) |
| 134 | Abschirmelement |
| 140 | rechtsseitiger Schlitz |
| 141 | linksseitiger Schlitz |
| 142 | Verbindungsabschnitt |
| 143-146 | Metallplattenteile |
| 151 | erster Endabschnitt |
| 152 | zweiter Endabschnitt |
| 153 | erster Schlitz |
| 154 | zweiter Schlitz |
| 155 | weiteres Abdeckelement |
| 160 | zylindrischer Metallkörper |
| 161 | erster Seitenabschnitt |
| 162 | zweiter Seitenabschnitt |
| 163 | mittlerer Abschnitt |
| 164 | erster geschlitzter Bereich |
| 165 | zweiter geschlitzter Bereich |
| 166 | dritter geschlitzter Bereich |
| 167 | Ausnehmung (für Durchgangsfenster) |
| 168-171 | Sektoren |
| 200 | Messanordnung |
| 201 | NMR-Probenkopf |
| 202 | Mess-Schwingkreis |
| 203 | HF-Spule |
| 204 | einstellbarer Kondensator (tuning) |
| 204a | Abstimmeinrichtung (tuning) |
| 205 | ohmscher Widerstand |

| 206a, 206b | Anschlüsse |
|---|---|
| 207 | verstellbarer Kondensator (matching) |
| 208 | Schwingkreis des Zusatzelements |
| 209 | Messprobe |
| 210 | Schwingkreis-Spule |
| 220 | NMR-Spektrometer |
| 221 | supraleitender Magnet/Hintergrundmagnet |
| 222 | Kryostat |
| 223 | Raumtemperaturbohrung |
| 231 | MRF1-Kurve Zusatzelement mit LSD = 5 mm |
| 232 | MRF1-Kurve Zusatzelement mit LSD = 10 mm |
| 233 | MRF1-Kurve Zusatzelement mit LSD = 25 mm |
| 240 | B1-Feld-Kurve für Probenaufnahme ohne Zusatzelement |
| 241 | B1-Feld-Kurve für Probenaufnahme mit Zusatzelement mit LSD = 5 mm |
| $A_{abdeck}$ | Flächeninhalt der Abdeckzone |
| $A_{aktiv}$ | Querschnittsfläche des aktiven Volumens |
| abs | Absorption (Resonanzkurven) |
| $A_{fenster}$ | Flächeninhalt des Durchgangsfensters |
| BRF | Basis-Resonanzfrequenz (HF-Resonator ohne Zusatzelement) |
| B0 | Bo-Feld/Hintergrundmagnetfeld |
| B1 | B1-Feld/zeitlich veränderlicher Magnetfluss |
| DD | Dicke der Schicht des Dielektrikums (im ersten Sandwich oder im zweiten Sandwich) |
| $D_{max}$ | maximaler Durchmesser eines in der Probenaufnahme aufnehmbaren zylindrischen Körpers |
| $D_p$ | maximaler Außendurchmesser des Zusatzelements (ggf. ohne Probenröhrchen) |
| $D_s$ | Durchmesser Probenraum/Probenkanal |
| $D_z$ | Dicke der Schicht des Dielektrikums (zwischen erstem Sandwich und zweitem Sandwich) |
| ENT | Entfernung Trimmerkondensator zu Durchgangsfenster |
| F0-F3 | Frequenzen (Frequenzwerte für die Resonanzfrequenz RF) |
| FV | Frequenzverschiebung durch Feldverdrängung |
| FS | Feldstärke des B1-Felds |
| GR | Grundrichtung |
| KSD | kurze Seite Durchgangsfenster |
| KSZ | kurze Seite Zusatzelement |
| LSD | lange Seite Durchgangsfenster |
| LSZ | lange Seite Zusatzelement |
| ME | Mittelebene |
| MRF1 | Modenresonanzfrequenz der unteren Mode |
| MRF2 | Modenresonanzfrequenz der oberen Mode |
| OF | oberste abstimmbare Frequenz |
| QR | Querrichtung |
| RF | Resonanzfrequenz (Schwingkreis) |
| RF1 | Verminderung der Resonanzfrequenz in unterer Mode |
| RF2 | Erhöhung der Resonanzfrequenz in oberer Mode |
| SW1 | erstes Sandwich |
| SW2 | zweites Sandwich |
| UEF | Überlappungsfläche |
| UF | unterste abstimmbare Frequenz |
| WGR | weitere Grundrichtung |
| WR | weitere Richtung |
| Z | Position entlang z-Achse (entspricht Querrichtung) |
| ZR | Zweitrichtung |
| $\varepsilon_r$ | relative Permittivität |

**Patentansprüche**

1. Zusatzelement (1) zum Fokussieren eines zeitlich veränderlichen Magnetflusses (B1), für den Einbau in eine Probenaufnahme (51) eines NMR-Probenkopfs (201),

wobei das Zusatzelement (1) wenigstens bezüglich einer Draufsicht entlang einer Grundrichtung (GR) eine Abdeckzone (5) und ein Durchgangsfenster (2) ausbildet, wobei die Abdeckzone (5) das Durchgangsfenster (2) mit oder ohne Unterbrechungen umschließt,

wobei das Zusatzelement (1) ein oder mehrere Abdeckelemente (10; 10a, 10b; 20; 20a, 20b; 30, 40) aufweist, die zumindest im Bereich eines Teils ihrer jeweiligen Randkurve oder äußeren Oberfläche elektrisch leitfähig sind, wobei die Gesamtheit der Abdeckelemente (10; 10a, 10b; 20; 20a, 20b; 30, 40) eine oder mehrere geschlossene Leiterschleifen (14, 24) ausbildet, die in besagter Draufsicht jeweils eine Leiterschleifenfläche (14a; 24a) umschließen, wobei die gesamte Überdeckung der einen oder mehreren Leiterschleifenflächen (14a, 24a) die Abdeckzone (5) bildet, die einen Flächeninhalt $A_{abdeck}$ aufweist,

wobei das Zusatzelement (1) im Bereich des Durchgangsfensters (2) elektrisch nicht leitfähig ist,

und wobei das Durchgangsfenster (2) einen Flächeninhalt $A_{fenster}$ aufweist mit $A_{abdeck} \geq 2*A_{fenster}$,

**dadurch gekennzeichnet,**

**dass** das Zusatzelement (1) wenigstens eine kapazitiv wirkende Struktur (60) umfasst, so dass das Zusatzelement (1) einen elektrischen Schwingkreis (208) umfassend das eine oder die mehreren Abdeckelemente (10; 10a, 10b; 20; 20a, 20b; 30, 40) ausbildet, mit einer Eigenresonanz einer Resonanzfrequenz RF,

mit 5 MHz $\leq$ RF $\leq$ 3000 MHz.

2.  Zusatzelement (1) nach Anspruch 1, **dadurch gekennzeichnet, dass** das Zusatzelement (1) so ausgebildet ist, dass bei dieser Eigenresonanz der Strom (64) auf dem Zusatzelement (1) keine Stromknoten aufweist.

3.  Zusatzelement (1) nach Anspruch 1 oder 2, **dadurch gekennzeichnet, dass** das Zusatzelement (1) so ausgebildet ist, dass bei dieser Eigenresonanz auf dem Zusatzelement (1) ein Kreisstrom (64) fließt, der das Durchgangsfenster (2) vollständig umschließt.

4.  Zusatzelement (1) nach einem der vorhergehenden Ansprüche **dadurch gekennzeichnet,**

    **dass** die wenigstens eine kapazitiv wirkende Struktur (60) zwei einander gegenüberliegende Kopplungsflächen (15, 25; 130a-130d) umfasst, die an zwei Abdeckelementen (10; 10a, 10b; 20; 20a, 20b; 30, 40) oder an zwei gegenüberliegenden Enden (129a-129d) eines Abdeckelements (10; 10a, 10b; 20; 20a, 20b; 30, 40) ausgebildet sind,

    und **dass** die einander gegenüberliegenden Kopplungsflächen (15, 25; 130a-130d) zumindest teilweise überlappen und eine Überlappungsfläche UEF aufweisen, wobei UEF $\geq$ 0,5 mm$^2$, bevorzugt $\geq$ 1,0 mm$^2$.

5.  Zusatzelement (1) nach einem der Ansprüche 1 bis 4, **dadurch gekennzeichnet,**

    **dass** das Zusatzelement (1) wenigstens ein erstes Sandwich (SW1) von Abdeckelementen (10; 10a, 10b; 20; 20a, 20b) umfasst, wobei das erste Sandwich (SW1) eine erste Sandwichebene (11) und eine zweite Sandwichebene (21) umfasst,

    wobei in der ersten Sandwichebene (11), die senkrecht zur Grundrichtung (GR) liegt, sich ein oder mehrere Abdeckelemente (10; 10a, 10b) flächig erstrecken, und in der zweiten Sandwichebene (21), die senkrecht zur Grundrichtung (GR) liegt, sich ein oder mehrere Abdeckelemente (20; 20a, 20b) flächig erstrecken,

    wobei die erste Sandwichebene (11) und die zweite Sandwichebene (21) bezüglich der Grundrichtung (GR) übereinander liegen, und die Abdeckelemente (10; 10a, 10b; 20; 20a, 20b) der ersten Sandwichebene (11) und der zweiten Sandwichebene (21) zumindest teilweise überlappen.

6.  Zusatzelement (1) nach Anspruch 5, **dadurch gekennzeichnet,**

    **dass** in der ersten Sandwichebene (11) das eine oder die mehreren Abdeckelemente (10; 10a, 10b) umlaufend um das Durchgangsfenster (2) angeordnet sind, und in Umlaufrichtung einander gegenüberliegende Enden (12a-12d) des einen oder der mehreren Abdeckelemente (109; 10a, 10b) jeweils durch einen Unterbrechungsspalt (13; 13a, 13b) getrennt sind,

    **dass** in der zweiten Sandwichebene (21) das eine oder die mehreren Abdeckelemente (20; 20a, 20b) umlaufend um das Durchgangsfenster (2) angeordnet sind, und in Umlaufrichtung einander gegenüberliegende Enden (22; 22a, 22b) des einen oder der mehreren Abdeckelemente (20; 20a, 20b) jeweils durch einen Unterbrechungsspalt (23; 23a, 23b) getrennt sind,

    und **dass** die Unterbrechungsspalten (13; 13a, 13b; 23; 23a, 23b) der ersten Sandwichebene (11) und der zweiten Sandwichebene (21) in Umlaufrichtung gegeneinander versetzt sind.

7. Zusatzelement (1) nach einem der Ansprüche 5 oder 6, **dadurch gekennzeichnet,**

**dass** das Zusatzelement (1) weiterhin wenigstens ein zweites Sandwich (SW2) von Abdeckelementen (30, 40) umfasst, wobei das zweite Sandwich (SW2) eine dritte Sandwichebene (31) und eine vierte Sandwichebene (41) umfasst,
wobei in der dritten Sandwichebene (31), die senkrecht zur Grundrichtung (GR) liegt, sich ein oder mehrere Abdeckelemente (30) flächig erstrecken, und in der vierten Sandwichebene (41), die senkrecht zur Grundrichtung (GR) liegt, sich ein oder mehrere Abdeckelemente (40) flächig erstrecken, wobei die dritte Sandwichebene (31) und die vierte Sandwichebene (41) bezüglich der Grundrichtung (GR) übereinander liegen, und die Abdeckelemente (30, 40) der dritten Sandwichebene (31) und der vierten Sandwichebene (41) zumindest teilweise überlappen,
und **dass** das erste Sandwich (SW1) von Abdeckelementen (10; 10a, 10b; 20; 20a, 20b) und das zweite Sandwich (SW2) von Abdeckelementen (30, 40) bezüglich der Grundrichtung (GR) übereinander liegen, und die Abdeckelemente (10; 10a, 10b; 20; 20a, 20b; 30, 40) des ersten Sandwiches (SW1) und des zweiten Sandwiches (SW2) zumindest teilweise überlappen,
insbesondere wobei das Zusatzelement (1) einen Probenkanal (4a) oder Probenraum (4) ausbildet, der zwischen dem ersten Sandwich (SW1) und dem zweiten Sandwich (SW2) verläuft.

8. Zusatzelement (1) nach einem der Ansprüche 5 bis 7, **dadurch gekennzeichnet, dass** das Zusatzelement (1) ein zylindrisches Glasröhrchen (7) umfasst, in welches die Abdeckelemente (10; 10a, 10b; 20; 20a, 20b; 30, 40) des oder der Sandwiches (SW1, SW2) eingefügt sind.

9. Zusatzelement (1) nach einem der Ansprüche 1 bis 4, **dadurch gekennzeichnet,**

**dass** das Zusatzelement (1) zwei einander gegenüberliegende Endabschnitte (120, 121) aufweist, die jeweils mit einem Metallzylinder (122, 123) ausgebildet sind, und einen Verbindungsabschnitt (124) aufweist, der mit einer Metallplatte (125) ausgebildet ist, die senkrecht zur Grundrichtung (GR) verläuft,
wobei der Verbindungsabschnitt (124) die Endabschnitte (120, 121) verbindet,
wobei im Verbindungsabschnitt (124) das Durchgangsfenster (2) ausgebildet ist, und das Durchgangsfenster (2) die Metallplatte (125) des Verbindungsabschnitts (124) quer zur Grundrichtung (GR) elektrisch unterteilt, dass ein Probenkanal (4a) oder ein Probenraum (4) entlang der Zylinderachsen der Metallzylinder (122, 123) durch die Endabschnitte (120, 121) und durch den Verbindungsabschnitt (124) im Bereich des Durchgangsfensters (2) verläuft,
und **dass** wenigstens einer der Endabschnitte (120, 121) zumindest einen oberen Schlitz (126) aufweist, der sich vom Probenkanal (4a) oder Probenraum (4) zu einer Zylinderaußenseite des zugehörigen Metallzylinders (122, 123) erstreckt und den Metallzylinder (122, 123) dieses Endabschnitts (120, 121) im Umfangsrichtung elektrisch unterteilt, und wenigstens einer der Endabschnitte (120, 121) zumindest einen unteren Schlitz (127) aufweist, der sich vom Probenkanal (4a) oder Probenraum (4) zu einer Zylinderaußenseite des zugehörigen Metallzylinders (122, 123) erstreckt und den Metallzylinder (122, 123) dieses Endabschnitts (120, 121) im Umfangsrichtung elektrisch unterteilt, wobei bezüglich der Grundrichtung (GR) der obere Schlitz (126) oberhalb und der untere Schlitz (127) unterhalb der Metallplatte (125) verlaufen,
insbesondere wobei der obere Schlitz (126) und der untere Schlitz (127) mit einem Dielektrikum gefüllt sind.

10. Zusatzelement (1) nach Anspruch 9, **dadurch gekennzeichnet,**

**dass** auf dem Metallzylinder (122, 123) eines jeweiligen Endabschnitts (120, 121), der einen oberen Schlitz (126) und/oder unteren Schlitz (127) aufweist, ein Metallrohr (131) angeordnet ist, wobei ein radialer Spalt (128) zwischen dem Metallzylinder (122, 123) und dem Metallrohr (131) durch ein Dielektrikum gefüllt ist,
und **dass** das Metallrohr (131) den Schlitz (126, 127) an der Zylinderaußenseite des Metallzylinders (122, 123) übergreift.

11. Zusatzelement (1) nach einem der Ansprüche 9 oder 10, **dadurch gekennzeichnet, dass** das Zusatzelement (1) einen zusätzlichen Mittelschlitz (132) aufweist, der in der Mitte des Zusatzelements (1) senkrecht zur Grundrichtung (GR) verläuft, und die beiden Metallzylinder (122, 123) und auch die Metallplatte (125) in eine obere Hälfte und eine untere Hälfte elektrisch unterteilt, wobei der Mittelschlitz (132) den Probenraum (4) oder Probenkanal (4a) schneidet, und wobei der Mittelschlitz (132) mit einem Dielektrikum gefüllt ist.

12. Zusatzelement (1) nach einem der Ansprüche 1 bis 4, **dadurch gekennzeichnet,**

**dass** das Zusatzelement (1) zwei einander gegenüberliegende Endabschnitte (151, 152) aufweist, die jeweils mit einem Metallzylinder (122, 123) ausgebildet sind, und einen Verbindungsabschnitt (124) aufweist, der mit vier Metallplattenteilen (143-146) ausgebildet ist, die kreuzförmig um einen Probenkanal (4a) oder Probenraum (4) angeordnet sind, und die unter 45° zur Grundrichtung (GR) ausgerichtet sind,

wobei der Verbindungsabschnitt (124) mit den Metallplattenteilen (143-146) die Endabschnitte (151, 152) verbindet,

wobei im Verbindungsabschnitt (124) das Durchgangsfenster (2) ausgebildet ist,

**dass** der Probenkanal (4a) oder der Probenraum (4) entlang der Zylinderachsen der Metallzylinder (122, 123) durch die Endabschnitte (151, 152) und den Verbindungsabschnitt (124) im Bereich des Durchgangsfensters (2) verläuft,

und **dass** ein erster Endabschnitt (151) der Endabschnitte (151, 152) einen ersten Schlitz (153) aufweist, der parallel zur Grundrichtung (GR) verläuft und den Metallzylinder (122) dieses Endabschnitts (151) in eine rechte Hälfte (122b) und eine linke Hälfte (122a) elektrisch unterteilt, und ein zweiter Endabschnitt (152) der Endabschnitte (151, 152) einen zweiten Schlitz (154) aufweist, der mittig durch das Zusatzelement (1) senkrecht zur Grundrichtung (GR) verläuft und den Metallzylinder (123) dieses Endabschnitts in eine obere Hälfte (123a) und eine untere Hälfte (123b) elektrisch unterteilt,

insbesondere wobei der erste Schlitz (153) und der zweite Schlitz (154) mit einem Dielektrikum gefüllt sind, und insbesondere wobei der erste Schlitz (153) und der zweite Schlitz (154) eine unterschiedliche Schlitzbreite haben und/oder mit einem unterschiedlichen Dielektrikum gefüllt sind.

13. Zusatzelement (1) nach einem der Ansprüche 1 bis 4, **dadurch gekennzeichnet,**

**dass** das Zusatzelement (1) aus einem zylindrischen Metallkörper (160) gebildet ist, wobei der Metallkörper (160) einen mittleren Abschnitt (163) und beidseits des mittleren Abschnitts (163) zwei Seitenabschnitte (161, 162) aufweist,

wobei der Metallkörper (160) zur Ausbildung des Durchgangsfensters (2) in dem mittleren Abschnitt (163) eine Ausnehmung (167) aufweist, die entlang der Grundrichtung (GR) durch den Metallkörper (160) verläuft und den mittleren Abschnitt (163) quer zur Grundrichtung (GR) elektrisch unterteilt,

**dass** das Zusatzelement (1) einen Probenkanal (4a) oder Probenraum (4) aufweist, der sich entlang einer Zylinderachse des Metallkörpers (160) erstreckt, wobei der Probenkanal (4a) oder Probenraum (4) das Durchgangsfenster (2) schneidet,

und **dass** der Metallkörper (160) geschlitzte Bereiche (164-166) aufweist, die sich vom Probenkanal (4a) oder Probenraum (4) aus zu einer Metallkörperaußenseite hin erstrecken und den Metallkörper (160) im mittleren Abschnitt (163) und/oder in einem der Seitenabschnitte (161, 162) elektrisch unterteilen,

insbesondere wobei in den geschlitzten Bereichen (164-166) und/oder in der Ausnehmung (167) ein Dielektrikum angeordnet ist.

14. Zusatzelement (1) nach Anspruch 13, **dadurch gekennzeichnet, dass** der Metallkörper (160) geschlitzte Bereiche (164-166) aufweist, mit

- einem ersten geschlitzten Bereich (164) in einem ersten Seitenabschnitt (161) der beiden Seitenabschnitte (161, 162), wobei der erste geschlitzte Bereich (164) parallel zur Grundrichtung (GR) mittig durch den ersten Seitenabschnitt (161) verläuft,

- einem zweiten geschlitzten Bereich (165) in einem zweiten Seitenabschnitt (162) der beiden Seitenabschnitte (161, 162), wobei der zweite geschlitzte Bereich (165) senkrecht zur Grundrichtung (GR) mittig durch den zweiten Seitenabschnitt (162) verläuft,

- und einen dritten geschlitzten Bereich (166) im mittleren Abschnitt (163), wobei der dritte geschlitzte Bereich (166) senkrecht zur Grundrichtung (GR) mittig durch den mittleren Abschnitt (163) verläuft.

15. Zusatzelement (1) nach einem der vorhergehenden Ansprüche, **dadurch gekennzeichnet, dass** das Zusatzelement (1) eine im Wesentlichen zylindrische Außengestalt aufweist,

insbesondere wobei die Außengestalt einem Probenröhrchen (7) entspricht.

16. Zusatzelement (1) nach einem der vorhergehenden Ansprüche, **dadurch gekennzeichnet, dass** das Zusatzelement (1) ein Abstimmelement (100) umfasst, mit welchem die Resonanzfrequenz RF des elektrischen Schwingkreises (208) veränderbar ist,

insbesondere wobei mit dem Abstimmelement (100) eine im elektrischen Schwingkreis (208) enthaltene Gesamtkapazität veränderbar ist.

**17.** Zusatzelement (1) nach einem der vorhergehenden Ansprüche, **dadurch gekennzeichnet, dass** das Zusatzelement (1) wenigstens ein Abschirmelement (134) umfasst, welches eine Penetration von zeitlich veränderlichem Magnetfluss (B1) in wenigstens einem Teil eines Probenkanals (4a) oder Probenraums (4) des Zusatzelements (1), der sich an das Durchflussfenster (2) anschließt, blockiert,

insbesondere wobei das Zusatzelement (1) wenigstens zwei Abschirmelemente (134) umfasst, welche die Penetration von zeitlich veränderlichem Magnetfluss in zwei Teile des Probenkanals (4a) oder Probenraums (4) des Zusatzelements (1), die sich an gegenüberliegenden Seiten an das Durchflussfenster (2) anschließen, blockiert.

**18.** Zusatzelement (1) nach einem der vorhergehenden Ansprüche, **dadurch gekennzeichnet,**

**dass** das Zusatzelement (1) so ausgebildet ist, dass es für einen zeitlich veränderlichen Magnetfluss (B1) entlang einer Zweitrichtung (ZR), die orthogonal zur Grundrichtung (GR) verläuft, im Wesentlichen transparent ist, so dass durch das Zusatzelement (1) der zeitlich veränderliche Magnetfluss (B1) entlang der Zweitrichtung (ZR) in einem Probenkanal (4a) oder Probenraum (4) des Zusatzelements (1) im Bereich des Durchgangsfensters (2) relativ um maximal 20% reduziert wird,

insbesondere wobei das Zusatzelement (1) einen Durchlassspalt (98) ausbildet, der senkrecht zur Grundrichtung (GR) verläuft und den Probenkanal (4a) oder Probenraum (5) schneidet.

**19.** Zusatzelement (1) nach einem der vorhergehenden Ansprüche, **dadurch gekennzeichnet,**

**dass** das Zusatzelement (1) bezüglich einer weiteren Draufsicht entlang einer weiteren Grundrichtung (WGR) eine weitere Abdeckzone und ein weiteres Durchgangsfenster (2a) ausbildet, wobei die weitere Abdeckzone das weitere Durchgangsfenster (2a) mit oder ohne Unterbrechungen umschließt,

wobei die weitere Grundrichtung (WGR) senkrecht zur Grundrichtung (GR) verläuft,

wobei das Zusatzelement (1) ein oder mehrere weitere Abdeckelemente (155) aufweist, die zumindest im Bereich eines Teils ihrer jeweiligen Randkurve oder äußeren Oberfläche elektrisch leitfähig sind, wobei die Gesamtheit der weiteren Abdeckelemente (155) ein oder mehrere weitere geschlossene Leiterschleifen ausbildet, die in besagter weiterer Draufsicht jeweils eine weitere Leiterschleifenfläche umschließen, wobei die gesamte Überdeckung der einen oder mehreren weiteren Leiterschleifenflächen die weitere Abdeckzone bildet, die einen weiteren Flächeninhalt $AW_{abdeck}$ aufweist,

wobei das Zusatzelement (1) im Bereich des weiteren Durchgangsfensters (2a) elektrisch nicht leitfähig ist, und wobei das weitere Durchgangsfenster (2a) einen weiteren Flächen**halt** $AW_{fenster}$ aufweist mit $AW_{abdeck} \geq 2 \cdot AW_{fenster}$,

wobei das Zusatzelement (1) wenigstens eine weitere kapazitiv wirkende Struktur (60a) umfasst, so dass das Zusatzelement (1) einen weiteren elektrischen Schwingkreis umfassend das eine oder die mehreren weiteren Abdeckelemente (155) ausbildet, mit einer Eigenresonanz einer weiteren Resonanzfrequenz RFW,

mit

$$5 \text{ MHz} \leq RFW \leq 3000 \text{ MHz.}$$

**20.** Messanordnung (200), umfassend einen NMR-Probenkopf (201) und ein Zusatzelement (1) nach einem der vorhergehenden Ansprüche,

wobei das Zusatzelement (1) in einer Probenaufnahme (51) des NMR-Probenkopfs (201) angeordnet ist, wobei der Probenkopf (201) eine HF-Spule (50; 203) umfasst, mit der in der Probenaufnahme (51) entlang einer Einstrahlrichtung ein B1-Feld erzeugbar ist,

und wobei das Zusatzelement (1) in der Probenaufnahme (51) so zur HF-Spule (50; 203) orientiert ist, dass die Grundrichtung (GR) des Zusatzelements (1) und die Einstrahlrichtung parallel sind.

**21.** Messanordnung (200) nach Anspruch 20, **dadurch gekennzeichnet, dass** der Probenkopf (201) eine Führungshilfe umfasst, mit der beim Einführen des Zusatzelements (1) in die Probenaufnahme (51) des NMR-Probenkopfs (201) das Zusatzelement (1) gegenüber dem NMR-Probenkopf (201) selbsttätig so ausgerichtet wird, dass die Grundrichtung (GR) des Zusatzelements (1) und die Einstrahlrichtung zueinander definiert ausgerichtet sind, insbesondere parallel sind.

**22.** Messanordnung (200) nach einem der Ansprüche 20 oder 21, **dadurch gekennzeichnet,**

**dass** das Zusatzelement (1) einen Probenkanal (4a) oder Probenraum (4) für eine Messprobe (209) ausbildet, wobei der Probenkanal (4a) oder Probenraum (4) einen Durchmesser $D_s$ aufweist, und in die Probenaufnahme des NMR-Probenkopfs (201) ein kreiszylindrischer Körper mit einem maximalen Durchmesser $D_{max}$ einführbar ist, wobei $D_s$ und $D_{max}$ jeweils gemessen sind senkrecht zu einer Querrichtung (QR), wobei die Querrichtung (QR) senkrecht zur Grundrichtung (GR) verläuft,
und **dass**

$$D_s \leq 0{,}6 * D_{max},$$

bevorzugt

$$D_s \leq 0{,}4 * D_{max}.$$

23. Messanordnung (200) nach einem der Ansprüche 20 bis 22, **dadurch gekennzeichnet,**

**dass** der NMR-Probenkopf (201) in der Probenaufnahme (51) ein aktives Volumen (52) ausbildet, welches eine Querschnittsfläche $A_{aktiv}$ aufweist, gemessen in der Ebene senkrecht zur Grundrichtung (GR),
wobei

$$A_{abdeck} \geq 0{,}2 * A_{aktiv},$$

bevorzugt

$$A_{abdeck} \geq 0{,}3 * A_{aktiv},$$

besonders bevorzugt

$$A_{abdeck} \geq 0{,}4 * A_{aktiv}.$$

24. Messanordnung (200) nach einem der Ansprüche 20 bis 23, **dadurch gekennzeichnet,**

**dass** der NMR-Probenkopf (201) eine Abstimmeinrichtung (204a) aufweist, mit der eine Basis-Resonanzfrequenz BRF einer Eigenresonanz eines elektrischen Mess-Schwingkreises (202) der HF-Spule (50; 203) ohne das Zusatzelement (1) in der Probenaufnahme (51) in einem Bereich von UF bis OF abgestimmt werden kann, mit UF: unterste abstimmbare Frequenz und OF: oberste abstimmbare Frequenz und UF<BRF<OF,
**dass** die Präsenz des oder der Abdeckelemente (10; 10a, 10b; 20; 20a, 20b; 30, 40) des Zusatzelements (1) in der Probenaufnahme (51) des NMR-Probenkopfs (201) durch Verdrängung von Magnetfluss die Resonanzfrequenz des Mess-Schwingkreises (202) um eine Frequenzverschiebung FV gegenüber der Basis-Resonanzfrequenz BRF erhöht,
und weiterhin bei in die Probenaufnahme (51) eingefügtem Zusatzelement (1) der Mess-Schwingkreis (202) mit dem elektrischen Schwingkreis (208), den das Zusatzelement (1) ausbildet, koppelt, wodurch eine Aufspaltung der Eigenresonanz des elektrischen Mess-Schwingkreises (202) in eine untere Mode mit einer Modenresonanzfrequenz MRF1 und eine obere Mode mit einer Modenresonanzfrequenz MRF2 erfolgt, wobei MRF1 gegenüber der ungekoppelten Resonanzfrequenz des elektrischen Mess-Schwingkreises (202) um eine Frequenzverschiebung RF1 erniedrigt und MRF2 gegenüber der ungekoppelten Resonanzfrequenz um eine Frequenzverschiebung RF2 erhöht ist,
mit

$$MRF1 = BRF + FV - RF1 \ und \ MRF2 = BRF + FV + RF2,$$

und **dass** der NMR-Probenkopf (201) und das Zusatzelement (1) so ausgebildet sind,
insbesondere eine Kopplung zwischen dem Mess-Schwingkreis (202) und dem elektrischen Schwingkreis (208) und weiter die Resonanzfrequenz RF des elektrischen Schwingkreises (208) des Zusatzelements (1) so eingerichtet sind,
**dass**

$$OF\text{-}BRF > RF1\text{-}FV$$

und

$$BRF\text{-}UF > FV\text{-}RF1.$$

**25.** Verwendung einer Messanordnung (200) nach Anspruch 24 in einer NMR-Messung,

wobei der NMR-Probenkopf (201) in einem B0-Feld eines Hintergrundmagneten (221) angeordnet ist, wobei das B0-Feld im Bereich der Probenaufnahme (51) des NMR-Probenkopfs (201) entlang einer Querrichtung (QR) verläuft, wobei die Querrichtung (QR) senkrecht zur Grundrichtung (GR) verläuft,
wobei in einen Probenkanal (4a) oder einen Probenraum (5) des Zusatzelements (1) zumindest im Bereich des Durchgangsfensters (2) eine Messprobe (209) angeordnet ist, wobei für ein Volumen VOL der Messprobe (209) gilt:

$$VOL \leq 100\ \mu l,$$

bevorzugt

$$VOL \leq 40\ \mu l,$$

besonders bevorzugt

$$VOL \leq 10\ \mu l,$$

ganz besonders bevorzugt

$$VOL \leq 5\ \mu l,$$

und wobei eine Modenresonanzfrequenz MRF1 einer unteren Mode des Mess-Schwingkreises (202) mit der Abstimmeinrichtung (204a) auf eine Kern-Resonanzfrequenz eines Messkerns, der in der Messprobe (209) enthalten ist, abgestimmt ist.

**Claims**

**1.** An additional element (1) for focusing a time-varying magnetic flux (B1), for installation in a sample receptacle (51) of an NMR sample head (201),

wherein the additional element (1) forms at least with respect to a plan view a cover zone (5) and a passage window (2) along a base direction (GR), wherein the cover zone (5) encloses the passage window (2) with or without interruptions,
wherein the additional element (1) has one or more cover elements (10; 10a, 10b; 20; 20a, 20b; 30, 40) that are electrically conductive at least in the area of part of their respective edge curve or outer surface, wherein the entirety of the cover elements (10; 10a, 10b; 20; 20a, 20b; 30, 40) forms one or more closed conductor loops (14, 24) which, in said plan view, each enclose a conductor loop area (14a; 24a), wherein the entire covering of the one or more conductor loop areas (14a, 24a) forms the cover zone (5), which has an area $A_{abdeck}$,
wherein the additional element (1) is electrically non-conductive in the area of the passage window (2),
and wherein the passage window (2) has an area $A_{fenster}$ with $A_{abdeck} \geq 2^* A_{fenster}$,
**characterized in that**
the additional element (1) comprises at least one capacitively acting structure (60), such that the additional element (1) forms an electrical resonant circuit (208) comprising the one or more cover elements (10; 10a, 10b; 20; 20a, 20b; 30, 40), with a natural resonance of a resonance frequency RF,
with 5 MHz $\leq$ RF $\leq$ 3000 MHz.

**2.** The additional element (1) according to claim 1, **characterized in that** the additional element (1) is designed such that at this natural resonance the current (64) on the additional element (1) has no current nodes.

3. The additional element (1) according to claim 1 or 2, **characterized in that** the additional element (1) is designed such that at this natural resonance a circulating current (64) flows on the additional element (1), which completely encloses the passage window (2).

4. The additional element (1) according to any of the preceding claims, **characterized in that**

   the at least one capacitively acting structure (60) comprises two mutually opposing coupling surfaces (15, 25; 130a-130d) which are formed on two cover elements (10; 10a, 10b; 20; 20a, 20b; 30, 40) or on two opposing ends (129a-129d) of a cover element (10; 10a, 10b; 20; 20a, 20b; 30, 40),
   and the mutually opposing coupling surfaces (15, 25; 130a-130d) at least partially overlap and have an overlap area UEF, wherein UEF $\geq 0.5$ mm$^2$, preferably $\geq 1.0$ mm$^2$.

5. The additional element (1) according to any of claims 1 to 4, **characterized in that**

   the additional element (1) comprises at least a first sandwich (SW1) of cover elements (10; 10a, 10b; 20; 20a, 20b), wherein the first sandwich (SW1) comprises a first sandwich plane (11) and a second sandwich plane (21), wherein one or more cover elements (10; 10a, 10b) extend flatly in the first sandwich plane (11), which lies perpendicular to the base direction (GR), and one or more cover elements (20; 20a, 20b) extend flatly in the second sandwich plane (21), which lies perpendicular to the base direction (GR),
   wherein the first sandwich plane (11) and the second sandwich plane (21) lie one above the other with respect to the base direction (GR), and the covering elements (10; 10a, 10b; 20; 20a, 20b) of the first sandwich plane (11) and the second sandwich plane (21) at least partially overlap.

6. The additional element (1) according to claim 5, **characterized in that**

   in the first sandwich plane (11) the one or more cover elements (10; 10a, 10b) are arranged circumferentially around the passage window (2), and ends (12a-12d) of the one or more cover elements (109; 10a, 10b) opposite one another in the circumferential direction are each separated by an interruption gap (13; 13a, 13b),
   **in that** in the second sandwich plane (21) the one or more cover elements (20; 20a, 20b) are arranged circumferentially around the passage window (2), and ends (22; 22a, 22b) of the one or more cover elements (20; 20a, 20b) opposite one another in the circumferential direction are each separated by an interruption gap (23; 23a, 23b),
   and the interruption gaps (13; 13a, 13b; 23; 23a, 23b) of the first sandwich plane (11) and the second sandwich plane (21) are offset relative to one another in the circumferential direction.

7. The additional element (1) according to any of claims 5 or 6, **characterized in that**

   the additional element (1) further comprises at least a second sandwich (SW2) of cover elements (30, 40), wherein the second sandwich (SW2) comprises a third sandwich plane (31) and a fourth sandwich plane (41), wherein in the third sandwich plane (31), which lies perpendicular to the base direction (GR), one or more cover elements (30) extend flatly, and in the fourth sandwich plane (41), which lies perpendicular to the base direction (GR), one or more cover elements (40) extend flatly,
   wherein the third sandwich plane (31) and the fourth sandwich plane (41) lie one above the other with respect to the base direction (GR), and the cover elements (30, 40) of the third sandwich plane (31) and the fourth sandwich plane (41) at least partially overlap,
   and **in that** the first sandwich (SW1) of cover elements (10; 10a, 10b; 20; 20a, 20b) and the second sandwich (SW2) of cover elements (30, 40) lie one above the other with respect to the base direction (GR), and the cover elements (10; 10a, 10b; 20; 20a, 20b; 30, 40) of the first sandwich (SW1) and of the second sandwich (SW2) at least partially overlap,
   in particular wherein the additional element (1) forms a sample channel (4a) or sample space (4) which extends between the first sandwich (SW1) and the second sandwich (SW2).

8. The additional element (1) according to any of claims 5 to 7, **characterized in that** the additional element (1) comprises a cylindrical glass tube (7) into which the cover elements (10; 10a, 10b; 20; 20a, 20b; 30, 40) of the sandwich or sandwiches (SW1, SW2) are inserted.

9. The additional element (1) according to any of claims 1 to 4, **characterized in that**

the additional element (1) has two opposite end portions (120, 121), each formed with a metal cylinder (122, 123), and a connecting portion (124) formed with a metal plate (125) running perpendicular to the base direction (GR), wherein the connecting portion (124) connects the end portions (120, 121),
wherein the passage window (2) is formed in the connecting portion (124), and the passage window (2) electrically subdivides the metal plate (125) of the connecting portion (124) transversely to the base direction (GR),
a sample channel (4a) or a sample space (4) runs along the cylinder axes of the metal cylinders (122, 123) through the end portions (120, 121) and through the connecting portion (124) in the area of the passage window (2),
and **in that** at least one of the end portions (120, 121) has at least one upper slot (126) which extends from the sample channel (4a) or sample space (4) to a cylinder outer side of the associated metal cylinder (122, 123) and electrically subdivides the metal cylinder (122, 123) of this end portion (120, 121) in the circumferential direction, and at least one of the end portions (120, 121) has at least one lower slot (127) which extends from the sample channel (4a) or sample space (4) to a cylinder outer side of the associated metal cylinder (122, 123) and electrically subdivides the metal cylinder (122, 123) of this end portion (120, 121) in the circumferential direction, wherein the upper slot (126) runs above and the lower slot (127) runs below the metal plate (125) with respect to the base direction (GR),
in particular wherein the upper slot (126) and the lower slot (127) are filled with a dielectric.

10. The additional element (1) according to claim 9, **characterized in that**

a metal tube (131) is arranged on the metal cylinder (122, 123) of a respective end portion (120, 121), which has an upper slot (126) and/or lower slot (127), wherein a radial gap (128) between the metal cylinder (122, 123) and the metal tube (131) is filled by a dielectric,
and the metal tube (131) overlaps the slot (126, 127) on the cylinder outer side of the metal cylinder (122, 123).

11. The additional element (1) according to any of claims 9 or 10, **characterized in that** the additional element (1) has an additional central slot (132) which runs perpendicular to the base direction (GR) in the center of the additional element (1) and electrically subdivides the two metal cylinders (122, 123) and also the metal plate (125) into an upper half and a lower half, wherein the central slot (132) intersects the sample space (4) or sample channel (4a), and wherein the central slot (132) is filled with a dielectric.

12. The additional element (1) according to any of claims 1 to 4, **characterized in that**

the additional element (1) has two mutually opposing end portions (151, 152), each formed with a metal cylinder (122, 123), and a connecting portion (124) formed with four metal plate parts (143-146) which are arranged in a cross shape around a sample channel (4a) or sample space (4) and which are oriented at 45° to the base direction (GR),
wherein the connecting portion (124) connects the end portions (151, 152) with the metal plate parts (143-146), wherein the passage window (2) is formed in the connecting portion (124),
**in that** the sample channel (4a) or the sample space (4) runs along the cylinder axes of the metal cylinders (122, 123) through the end portions (151, 152) and the connecting portion (124) in the area of the passage window (2),
and **in that** a first end portion (151) of the end portions (151, 152) has a first slot (153) which runs parallel to the base direction (GR) and electrically subdivides the metal cylinder (122) of this end portion (151) into a right half (122b) and a left half (122a), and a second end portion (152) of the end portions (151, 152) has a second slot (154) which runs centrally through the additional element (1) perpendicular to the base direction (GR) and electrically subdivides the metal cylinder (123) of this end portion into an upper half (123a) and a lower half (123b),
in particular wherein the first slot (153) and the second slot (154) are filled with a dielectric,
and in particular wherein the first slot (153) and the second slot (154) have a different slot width and/or are filled with a different dielectric.

13. The additional element (1) according to any of claims 1 to 4, **characterized in that**

the additional element (1) is formed from a cylindrical metal body (160), wherein the metal body (160) has a central portion (163) and two side portions (161, 162) on either side of the central portion (163),
wherein the metal body (160) has a recess (167) in the central portion (163) to form the passage window (2), said recess running through the metal body (160) along the base direction (GR) and electrically subdividing the central portion (163) transversely to the base direction (GR),

**in that** the additional element (1) has a sample channel (4a) or sample space (4) which extends along a cylindrical axis of the metal body (160), wherein the sample channel (4a) or sample space (4) intersects the passage window (2),

and **in that** the metal body (160) has slotted areas (164-166) which extend from the sample channel (4a) or sample space (4) towards a metal body outer side and electrically subdivide the metal body (160) in the central portion (163) and/or in one of the side portions (161, 162), in particular wherein a dielectric is arranged in the slotted areas (164-166) and/or in the recess (167).

14. The additional element (1) according to claim 13, **characterized in that** the metal body (160) has slotted areas (164-166), with

- a first slotted area (164) in a first side portion (161) of the two side portions (161, 162), wherein the first slotted area (164) runs parallel to the base direction (GR) centrally through the first side portion (161),
- a second slotted area (165) in a second side portion (162) of the two side portions (161, 162), wherein the second slotted area (165) runs perpendicular to the base direction (GR) centrally through the second side portion (162),
- and a third slotted area (166) in the central portion (163), wherein the third slotted area (166) runs perpendicular to the base direction (GR) centrally through the central portion (163).

15. The additional element (1) according to any of the preceding claims, **characterized in that** the additional element (1) has a substantially cylindrical outer shape, in particular wherein the outer shape corresponds to a sample tube (7).

16. The additional element (1) according to any of the preceding claims, **characterized in that** the additional element (1) comprises a tuning element (100) with which the resonance frequency RF of the electrical resonant circuit (208) can be varied, in particular wherein the tuning element (100) can be used to change a total capacitance contained in the electrical resonant circuit (208).

17. The additional element (1) according to any of the preceding claims, **characterized in that** the additional element (1) comprises at least one shielding element (134) which blocks a penetration of time-varying magnetic flux (B1) in at least a part of a sample channel (4a) or sample space (4) of the additional element (1) which adjoins the passage window (2), in particular wherein the additional element (1) comprises at least two shielding elements (134) which block the penetration of time-varying magnetic flux into two parts of the sample channel (4a) or sample space (4) of the additional element (1) which adjoin the passage window (2) on opposite sides.

18. The additional element (1) according to any of the preceding claims, **characterized in that**

the additional element (1) is designed such that it is substantially transparent for a time-varying magnetic flux (B1) along a second direction (ZR), which runs orthogonal to the base direction (GR), so that the time-varying magnetic flux (B1) along the second direction (ZR) in a sample channel (4a) or sample space (4) of the additional element (1) in the area of the passage window (2) is reduced relatively by a maximum of 20% by the additional element (1), in particular wherein the additional element (1) forms a passage gap (98) which runs perpendicular to the base direction (GR) and intersects the sample channel (4a) or sample space (5).

19. The additional element (1) according to any of the preceding claims, **characterized in that**

the additional element (1) forms a further cover zone and a further passage window (2a) with respect to a further plan view along a further base direction (WGR), wherein the further cover zone encloses the further passage window (2a) with or without interruptions, wherein the further base direction (WGR) runs perpendicular to the base direction (GR), wherein the additional element (1) has one or more further cover elements (155) which are electrically conductive at least in the area of part of their respective edge curve or outer surface, wherein the entirety of the further cover elements (155) forms one or more further closed conductor loops which, in said further plan view, each enclose a further conductor loop area, wherein the entire covering of the one or more further conductor loop areas forms the further cover zone, which has a further area $AW_{abdeck}$, wherein the additional element (1) is electrically non-conductive in the area of the further passage window (2a), and wherein the further passage window (2a) has a further area $AW_{fenster}$ with $AW_{abdeck}=22*AW_{fenster}$,

wherein the additional element (1) comprises at least one further capacitively acting structure (60a), so that the additional element (1) forms a further electrical resonant circuit comprising the one or more further cover elements (155), with a natural resonance of a further resonance frequency RFW, with

$$5 \text{ MHz} \leq \text{RFW} \leq 3000 \text{ MHz}.$$

20. A measuring arrangement (200) comprising an NMR sample head (201) and an additional element (1) according to any of the preceding claims,

wherein the additional element (1) is arranged in a sample receptacle (51) of the NMR sample head (201), wherein the sample head (201) comprises an RF coil (50; 203) with which a B1 field can be generated in the sample receptacle (51) along an irradiation direction, and wherein the additional element (1) in the sample receptacle (51) is oriented relative to the RF coil (50; 203) such that the base direction (GR) of the additional element (1) and the irradiation direction are parallel.

21. The measuring arrangement (200) according to claim 20, **characterized in that** the sample head (201) comprises a guide aid with which, when the additional element (1) is being inserted into the sample receptacle (51) of the NMR sample head (201), the additional element (1) is automatically aligned with respect to the NMR sample head (201) such that the base direction (GR) of the additional element (1) and the irradiation direction are aligned in a defined manner with respect to one another, in particular are parallel.

22. The measuring arrangement (200) according to any of claims 20 or 21, **characterized in that,**

the additional element (1) forms a sample channel (4a) or sample space (4) for a measurement sample (209), wherein the sample channel (4a) or sample space (4) has a diameter $D_s$, and a circular cylindrical body with a maximum diameter $D_{max}$ can be introduced into the sample receptacle of the NMR sample head (201), wherein $D_s$ and $D_{max}$ are each measured perpendicular to a transverse direction (QR), wherein the transverse direction (QR) runs perpendicular to the base direction (GR), and

$$D_s \leq 0.6*D_{max},$$

preferably

$$D_s \leq 0.4*D_{max}.$$

23. The measuring arrangement (200) according to any of claims 20 to 22, **characterized in that**

the NMR sample head (201) forms an active volume (52) in the sample receptacle (51), which active volume (52) has a cross-sectional area $A_{aktiv}$, measured in the plane perpendicular to the base direction (GR), wherein

$$A_{abdeck} \geq 0.2*A_{aktiv},$$

preferably

$$A_{abdeck} \geq 0.3*A_{aktiv},$$

particularly preferably

$$A_{abdeck} \geq 0.4*A_{aktiv}.$$

24. The measuring arrangement (200) according to any of claims 20 to 23, **characterized in that**

the NMR sample head (201) has a tuning device (204a) with which a base resonance frequency BRF of a natural resonance of an electrical measuring resonant circuit (202) of the RF coil (50; 203) without the additional element (1) in the sample receptacle (51) can be tuned in a range from UF to OF, with UF: lowest tunable frequency and OF: highest tunable frequency and UF<BRF<OF,

and **in that** the presence of the cover element(s) (10; 10a, 10b; 20; 20a, 20b; 30, 40) of the additional element (1) in the sample receptacle (51) of the NMR sample head (201) increases the resonance frequency of the measuring resonant circuit (202) by a frequency shift FV relative to the base resonance frequency BRF by displacing magnetic flux,

and furthermore, when the additional element (1) is inserted into the sample receptacle (51), the measuring resonant circuit (202) is coupled to the electrical resonant circuit (208) formed by the additional element (1), as a result of which the natural resonance of the electrical measuring resonant circuit (202) is split into a lower mode with a mode resonance frequency MRF1 and an upper mode with a mode resonance frequency MRF2, wherein MRF1 is decreased by a frequency shift RF1 with respect to the uncoupled resonance frequency of the electrical measuring resonant circuit (202) and MRF2 is increased by a frequency shift RF2 with respect to the uncoupled resonance frequency,

with

$$MRF1=BRF+FV-RF1 \text{ and } MRF2=BRF+FV+RF2,$$

and **in that** the NMR sample head (201) and the additional element (1) are designed such that,

in particular a coupling between the measuring resonant circuit (202) and the electrical resonant circuit (208) and furthermore the resonance frequency RF of the electrical resonant circuit (208) of the additional element (1) are configured such that,

OF-BRF > RF1-FV and
BRF-UF > FV-RF1.

25. A use of a measuring arrangement (200) according to claim 24 in an NMR measurement,

wherein the NMR sample head (201) is arranged in a B0 field of a background magnet (221), wherein the B0 field runs in the area of the sample receptacle (51) of the NMR sample head (201) along a transverse direction (QR), wherein the transverse direction (QR) runs perpendicular to the base direction (GR),

wherein a measurement sample (209) is arranged in a sample channel (4a) or a sample space (5) of the additional element (1) at least in the area of the passage window (2), wherein for a volume VOL of the measurement sample (209) applies:

$$VOL \leq 100 \ \mu l,$$

preferably $VOL \leq 40 \ \mu l$,
particularly preferably $VOL \leq 10 \ \mu l$,
very particularly preferably $VOL \leq 5 \ \mu l$,
and wherein a mode resonance frequency MRF1 of a lower mode of the measurement resonant circuit (202) is tuned with the tuning device (204a) to a core resonance frequency of a measurement core contained in the measurement sample (209).

**Revendications**

1. Élément supplémentaire (1), permettant de focaliser un flux magnétique (B1) variable dans le temps, et destiné à être mis en place dans un logement d'échantillon (51) d'une tête d'échantillonnage RMN (201),

l'élément supplémentaire (1) formant une région de masquage (5) et une fenêtre de passage (2) au moins en vue de dessus le long d'une direction de base (GR), la région de masquage (5) entourant la fenêtre de passage (2) avec ou sans interruptions,

l'élément supplémentaire (1) présentant un ou plusieurs élément(s) de masquage (10 ; 10a, 10b ; 20 ; 20a, 20b ; 30, 40) électriquement conducteur(s) au moins dans la région d'une partie de leur courbe de bord respective ou de leur surface extérieure, la totalité des éléments de masquage (10 ; 10a, 10b ; 20 ; 20a, 20b ; 30, 40) formant une ou plusieurs boucle(s) conductrice(s) (14, 24) fermée(s) qui, dans ladite vue de dessus, entoure(nt) respectivement une surface de boucle conductrice (14a ; 24a), la totalité du masquage de la ou des surface(s) de boucle conductrice (14a, 24a) formant la région de masquage (5) qui présente une superficie $A_{abdeck}$, l'élément supplémentaire (1) n'étant pas électriquement conducteur dans la région de la fenêtre de passage (2), et la fenêtre de passage (2) présentant une superficie Afenster avec $A_{abdeck} \geq 2*$Afenster, **caractérisé en ce que** l'élément supplémentaire (1) comprend au moins une structure capacitive (60), de sorte que l'élément supplémentaire (1) forme un circuit oscillant électrique (208) comprenant le ou les élément(s) de masquage (10 ; 10a, 10b ; 20 ; 20a, 20b ; 30, 40), avec une résonance propre d'une fréquence de résonance RF, avec 5 Mhz $\leq$ RF $\leq$ 3000 MHz.

2. Élément supplémentaire (1) selon la revendication 1, **caractérisé en ce que** l'élément supplémentaire (1) est réalisé de sorte que, pour ladite résonance propre, le courant (64) ne présente sur l'élément supplémentaire (1) aucun nœud de courant.

3. Élément supplémentaire (1) selon la revendication 1 ou 2, **caractérisé en ce que** l'élément supplémentaire (1) est réalisé de sorte qu'un courant de circuit (64) entourant complètement la fenêtre de passage (2) circule sur l'élément supplémentaire (1) pour ladite résonance propre.

4. Élément supplémentaire (1) selon l'une quelconque des revendications précédentes, **caractérisé en ce que**

   la au moins une structure capacitive (60) comprend deux surfaces de couplage (15, 25 ; 130a à 130d) se faisant face et formées au niveau de deux éléments de masquage (10 ; 10a, 10b ; 20 ; 20a, 20b ; 30, 40) ou au niveau de deux extrémités (129a à 129d) se faisant face d'un élément de masquage (10 ; 10a, 10b ; 20 ; 20a, 20b ; 30, 40), et les surfaces de couplage (15, 25 ; 130a à 130d) se faisant face se chevauchent au moins partiellement et présentent une surface de chevauchement UEF, avec UEF $\geq 0,5$ mm$^2$, de manière préférée $\geq 1,0$ mm$^2$.

5. Élément supplémentaire (1) selon l'une quelconque des revendications 1 à 4, **caractérisé en ce que**

   l'élément supplémentaire (1) comprend au moins un premier sandwich (SW1) d'éléments de masquage (10 ; 10a, 10b ; 20 ; 20a, 20b), le premier sandwich (SW1) comprenant un premier niveau de sandwich (11) et un second niveau de sandwich (21),
   un ou plusieurs élément(s) de masquage (10 ; 10a, 10b) s'étend(ent) à plat dans le premier niveau de sandwich (11) perpendiculaire à la direction de base (GR), et un ou plusieurs élément(s) de masquage (20 ; 20a, 20b) s'étend(ent) à plat dans le deuxième niveau de sandwich (21) perpendiculaire à la direction de base (GR), le premier niveau de sandwich (11) et le deuxième niveau de sandwich (21) étant superposés par rapport à la direction de base (GR), et les éléments de masquage (10 ; 10a, 10b ; 20 ; 20a, 20b) du premier niveau de sandwich (11) et du deuxième niveau de sandwich (21) se chevauchant au moins partiellement.

6. Élément supplémentaire (1) selon la revendication 5, **caractérisé en ce que**

   dans le premier niveau de sandwich (11), le ou les élément(s) de masquage (10 ; 10a, 10b) est/sont agencé(s) de manière circonférentielle autour de la fenêtre de passage (2), et, dans le sens circonférentiel, des extrémités (12a à 12d) se faisant face du ou des élément(s) de masquage (109 ; 10a, 10b) sont respectivement séparées par un interstice d'interruption (13 ; 13a, 13b), **en ce que**, dans le deuxième niveau de sandwich (21), le ou les élément(s) de masquage (20 ; 20a, 20b) est/sont agencé(s) de manière circonférentielle autour de la fenêtre de passage (2), et, dans le sens circonférentiel, des extrémités (22 ; 22a, 22b) se faisant face du ou des élément(s) de masquage (20 ; 20a, 20b) sont respectivement séparées par un interstice d'interruption (23 ; 23a, 23b), et les interstices d'interruption (13 ; 13a, 13b ; 23 ; 23a, 23b) du premier niveau de sandwich (11) et du deuxième niveau de sandwich (21) sont décalées l'une par rapport à l'autre dans le sens circonférentiel.

7. Élément supplémentaire (1) selon l'une quelconque des revendications 5 à 6, **caractérisé en ce que**

   l'élément supplémentaire (1) comprend en outre au moins un deuxième sandwich (SW2) d'éléments de masquage (30, 40), le deuxième sandwich (SW2) comprenant un troisième niveau de sandwich (31) et un quatrième niveau de sandwich (41),
   un ou plusieurs élément(s) de masquage (30) s'étendant à plat dans le troisième niveau de sandwich (31) perpendiculaire à la direction de base (GR), et un ou plusieurs élément(s) de masquage (40) s'étendant à plat dans le quatrième niveau de sandwich (41) perpendiculaire à la direction de base (GR), le troisième niveau de sandwich (31) et le quatrième niveau de sandwich (41) étant superposés par rapport à la direction de base (GR), et les éléments de masquage (30, 40) du troisième niveau de sandwich (31) et du quatrième niveau de sandwich (41) se chevauchant au moins partiellement,

et **en ce que** le premier sandwich (SW1) d'éléments de masquage (10 ; 10a, 10b ; 20 ; 20a, 20b) et le deuxième sandwich (SW2) d'éléments de masquage (30, 40) sont superposés par rapport à la direction de base (GR), et les éléments de masquage (10 ;

10a, 10b ; 20 ; 20a, 20b ; 30, 40) du premier sandwich (SW1) et du deuxième sandwich (SW2) se chevauchent au moins partiellement,

l'élément supplémentaire (1) formant en particulier un canal d'échantillon (4a) ou une chambre d'échantillon (4) qui s'étend entre le premier sandwich (SW1) et le deuxième sandwich (SW2).

8. Élément supplémentaire (1) selon l'une quelconque des revendications 5 à 7, **caractérisé en ce que** l'élément supplémentaire (1) comprend un tube de verre cylindrique (7) dans lequel sont insérés les éléments de masquage (10 ; 10a, 10b ; 20 ; 20a, 20b ; 30, 40) du ou des sandwich(s) (SW1, SW2).

9. Élément supplémentaire (1) selon l'une quelconque des revendications 1 à 4, **caractérisé en ce que**

l'élément supplémentaire (1) présente deux sections d'extrémité (120, 121) opposées formées respectivement d'un cylindre métallique (122, 123), et présente une section de liaison (124) formée d'une plaque métallique (125) s'étendant perpendiculairement à la direction de base (GR),

la section de liaison (124) reliant les sections d'extrémité (120, 121),

la fenêtre de passage (2) étant formée dans la section de liaison (124), et la fenêtre de passage (2) divisant électriquement la plaque métallique (125) de la section de liaison (124) transversalement par rapport à la direction de base (GR),

un canal d'échantillon (4a) ou une chambre d'échantillon (4) s'étend dans la région de la fenêtre de passage (2) le long des axes de cylindre des cylindres métalliques (122, 123) à travers les sections d'extrémité (120, 121) et à travers la section de liaison (124),

et au moins une des sections d'extrémité (120, 121) présente au moins une fente supérieure (126) qui s'étend à partir du canal d'échantillon (4a) ou de la chambre d'échantillon (4) jusqu'à un côté extérieur de cylindre du cylindre métallique (122, 123) associé et qui divise électriquement le cylindre métallique (122, 123) de ladite section d'extrémité (120, 121) dans le sens circonférentiel, et au moins une des sections d'extrémité (120, 121) présente au moins une fente inférieure (127) qui s'étend à partir du canal d'échantillon (4a) ou de la chambre d'échantillon (4) jusqu'à un côté extérieur du cylindre métallique (122, 123) associé et qui divise électriquement le cylindre métallique (122, 123) de ladite section d'extrémité (120, 121) dans le sens circonférentiel, la fente supérieure (126) s'étendant au-dessus de la plaque métallique (125) et la fente inférieure (127) s'étendant au-dessous de la plaque métallique par rapport à la direction de base (GR),

la fente supérieure (126) et la fente inférieure (127) étant en particulier remplies avec un matériau diélectrique.

10. Élément supplémentaire (1) selon la revendication 9, **caractérisé en ce que**

un tube métallique (131) est agencé sur le cylindre métallique (122, 123) d'une section d'extrémité (120, 121) respective qui présente une fente supérieure (126) et/ou une fente inférieure (127), un interstice radial (128) entre le cylindre métallique (122, 123) et le tube métallique (131) étant rempli par un matériau diélectrique,

et le tube métallique (131) empiète sur la fente (126, 127) au niveau du côté extérieur de cylindre du cylindre métallique (122, 123).

11. Élément supplémentaire (1) selon l'une quelconque des revendications 9 ou 10, **caractérisé en ce que** l'élément supplémentaire (1) présente une fente centrale (132) supplémentaire qui s'étend au centre de l'élément supplémentaire (1) perpendiculairement à la direction de base (GR) et qui divise électriquement les deux cylindres métalliques (122, 123) et également la plaque métallique (125) en une moitié supérieure et une moitié inférieure, la fente centrale (132) coupant la chambre d'échantillon (4) ou le canal d'échantillon (4a), et la fente centrale (132) étant remplie avec un matériau diélectrique.

12. Élément supplémentaire (1) selon l'une quelconque des revendications 1 à 4, **caractérisé en ce que**

l'élément supplémentaire (1) présente deux sections d'extrémité (151, 152) opposées et formées respectivement d'un cylindre métallique (122, 123) et présente une section de liaison (124) formée avec quatre parties de plaque métallique (143 à 146) agencées en croix autour d'un canal d'échantillon (4a) ou d'une chambre d'échantillon (4) et orientées à 45° par rapport à la direction de base (GR),

la section de liaison (124) reliant les parties d'extrémité (151, 152) aux parties de plaque métallique (143 à 146), la fenêtre de passage (2) étant réalisée dans la section de liaison (124),

le canal d'échantillon (4a) ou la chambre d'échantillon (4) s'étend dans la région de la fenêtre de passage (2) à travers les sections d'extrémité (151, 152) et la section de liaison (124) le long des axes de cylindre des cylindres métalliques (122, 123),

et une première section d'extrémité (151) parmi les sections d'extrémité (151, 152) présente une première fente (153) s'étendant parallèlement à la direction de base (GR) et divisant électriquement le cylindre métallique (122) de ladite section d'extrémité (151) en une moitié droite (122b) et une moitié gauche (122a), et une deuxième section d'extrémité (152) parmi les sections d'extrémité (151, 152) présente une deuxième fente (154) s'étendant au centre à travers l'élément supplémentaire (1) perpendiculairement à la direction de base (GR) et divisant électriquement le cylindre métallique (123) de ladite section d'extrémité en une moitié supérieure (123a) et une moitié inférieure (123b),

la première fente (153) et la deuxième fente (154) étant en particulier remplies avec un matériau diélectrique, et la première fente (153) et la deuxième fente (154) ayant en particulier une largeur de fente différente et/ou étant remplies avec un matériau diélectrique différent.

13. Élément supplémentaire (1) selon l'une quelconque des revendications 1 à 4, **caractérisé en ce que**

l'élément supplémentaire (1) est formé d'un corps métallique cylindrique (160), le corps métallique (160) présentant une section centrale (163) et deux sections latérales (161, 162) de part et d'autre de la section centrale (163),

le corps métallique (160) présentant dans la section centrale (163) un évidement (167) qui s'étend à travers le corps métallique (160) le long de la direction de base (GR) et qui divise électriquement la section centrale (163) transversalement par rapport à la direction de base (GR), afin de former la fenêtre de passage (2),

l'élément supplémentaire (1) présente un canal d'échantillon (4a) ou une chambre d'échantillon (4) qui s'étend le long d'un axe cylindrique du corps métallique (160), le canal d'échantillon (4a) ou la chambre d'échantillon (4) coupant la fenêtre de passage (2),

et le corps métallique (160) présente des régions fendues (164 à 166) qui s'étendent à partir du canal d'échantillon (4a) ou de la chambre d'échantillon (4) jusqu'à un côté extérieur de corps métallique et qui divisent électriquement le corps métallique (160) dans la section centrale (163) et/ou dans une des sections latérales (161, 162),

un matériau diélectrique étant en particulier agencé dans les régions fendues (164 à 166) et/ou dans l'évidement (167).

14. Élément supplémentaire (1) selon la revendication 13, **caractérisé en ce que** le corps métallique (160) présente des régions fendues (164 à 166), avec

- une première région fendue (164) située dans une première section latérale (161) parmi les deux sections latérales (161, 162), la première région fendue (164) s'étendant au milieu à travers la première section latérale (161) parallèlement à la direction de base (GR),
- une deuxième région fendue (165) située dans une deuxième section latérale (162) parmi les deux sections latérales (161, 162), la deuxième région fendue (165) s'étendant au milieu à travers la deuxième section latérale (162) perpendiculairement à la direction de base (GR),
- et une troisième région fendue (166) située dans la section centrale (163), la troisième région fendue (166) s'étendant au milieu à travers la section centrale (163) perpendiculairement à la direction de base (GR).

15. Élément supplémentaire (1) selon l'une quelconque des revendications précédentes, **caractérisé en ce que** l'élément supplémentaire (1) présente un interstice extérieur essentiellement cylindrique. la forme extérieure correspondant en particulier à un tube à échantillon (7).

16. Élément supplémentaire (1) selon l'une quelconque des revendications précédentes, **caractérisé en ce que** l'élément supplémentaire (1) comprend un élément d'accord (100) avec lequel la fréquence de résonance RF du circuit oscillant électrique (208) peut être modifiée, une capacité totale contenue dans le circuit oscillant électrique (208) pouvant en particulier être modifiée avec l'élément d'accord (100).

17. Élément supplémentaire (1) selon l'une quelconque des revendications précédentes, **caractérisé en ce que** l'élément supplémentaire (1) comprend au moins un élément de blindage (134) qui bloque la pénétration d'un flux magnétique (B1) variable dans le temps dans au moins une partie, se raccordant à la fenêtre de passage (2), d'un canal d'échantillon (4a) ou d'une chambre d'échantillon (4) de l'élément supplémentaire (1),

l'élément supplémentaire (1) comprenant en particulier au moins deux éléments de blindage (134) qui bloquent la pénétration d'un flux magnétique variable dans le temps dans deux parties, se raccordant à la fenêtre de passage (2) sur des côtés opposés, du canal d'échantillon (4a) ou de la chambre d'échantillon (4) de l'élément supplémentaire (1).

**18.** Élément supplémentaire (1) selon l'une quelconque des revendications précédentes, **caractérisé en ce que**

l'élément supplémentaire (1) est réalisé de sorte qu'il est essentiellement transparent, le long d'une deuxième direction (ZR) s'étendant de manière orthogonale par rapport à la direction de base (GR), à un flux magnétique (B1) variable dans le temps, de sorte que le flux magnétique (B1) variable dans le temps est réduit de 20% au maximum grâce à l'élément supplémentaire (1) le long de la deuxième direction (ZR) dans un canal d'échantillonnage (4a) ou une chambre d'échantillon (4) de l'élément supplémentaire (1) dans la région de la fenêtre de passage (2),

l'élément supplémentaire (1) formant en particulier un interstice de passage (98) qui s'étend perpendiculairement à la direction de base (GR) et coupe le canal d'échantillon (4a) ou la chambre d'échantillon (5).

**19.** Élément supplémentaire (1) selon l'une quelconque des revendications précédentes, **caractérisé en ce que**

l'élément supplémentaire (1) forme une autre région de masquage et une autre fenêtre de passage (2a) par rapport à une autre vue de dessus le long d'une autre direction de base (WGR), l'autre région de masquage entourant l'autre fenêtre de passage (2a) avec ou sans interruptions,

l'autre direction de base (WGR) s'étendant perpendiculairement à la direction de base (GR),

l'élément supplémentaire (1) présentant un ou plusieurs autres élément(s) de masquage (155) qui est/sont électriquement conducteur(s) au moins dans la région d'une partie de leur courbe de bord respective ou de leur surface extérieure, la totalité des autres éléments de masquage (155) formant une ou plusieurs autre(s) boucle(s) conductrice(s) fermée(s) qui, dans ladite autre vue de dessus, entoure(nt) respectivement une autre surface de boucle conductrice, la totalité du masquage de la ou des autres surface(s) de boucle conductrice formant l'autre région de masquage qui présente une autre superficie $AW_{abdeck}$,

l'élément supplémentaire (1) n'étant pas électriquement conducteur dans la région de l'autre fenêtre de passage (2a),

et l'autre fenêtre de passage (2a) présentant une autre superficie $AW_{fenster}$,

avec $AW_{abdeck} \geq 2*AW_{fenster}$,

l'élément supplémentaire (1) comprenant au moins une autre structure capacitive (60a), de sorte que l'élément supplémentaire (1) forme un autre circuit oscillant électrique comprenant le ou les autres élément(s) de masquage (155), avec une résonance propre d'une autre fréquence de résonance RFW,

avec $5\ Mhz \leq RFW \leq 3000\ MHz$.

**20.** Dispositif de mesure (200), comprenant une tête d'échantillonnage RMN (201) et un élément supplémentaire (1) selon l'une quelconque des revendications précédentes,

l'élément supplémentaire (1) étant agencé dans un logement d'échantillon (51) de la tête d'échantillonnage RMN (201),

la tête d'échantillonnage (201) comprenant une bobine HF (50 ; 203) avec laquelle un champ B1 peut être généré dans le logement d'échantillon (51) le long d'une direction de faisceau,

et l'élément supplémentaire (1) dans le logement d'échantillon (51) étant orienté par rapport à la bobine HF (50 ; 203) de sorte que la direction de base (GR) de l'élément supplémentaire (1) et la direction de faisceau sont parallèles.

**21.** Dispositif de mesure (200) selon la revendication 20, **caractérisé en ce que** la tête d'échantillonnage (201) comprend une aide de guidage avec laquelle, lors de l'introduction de l'élément supplémentaire (1) dans le logement d'échantillon (51) de la tête d'échantillonnage RMN (201), l'élément supplémentaire (1) est orienté automatiquement par rapport à la tête d'échantillonnage RMN (201) de sorte que la direction de base (GR) de l'élément supplémentaire (1) et la direction de faisceau sont orientées de manière définie, en particulier de manière parallèle, l'une par rapport à l'autre.

**22.** Dispositif de mesure (200) selon l'une quelconque des revendications 20 à 21, **caractérisé en ce que**

l'élément supplémentaire (1) forme un canal d'échantillon (4a) ou une chambre d'échantillon (4) destiné(e) à un échantillon de mesure (209), le canal d'échantillon (4a) ou la chambre d'échantillon (4) présentant un diamètre $D_s$, et **en ce qu'**un corps cylindrique circulaire d'un diamètre maximal $D_{max}$ peut être introduit dans le logement d'échantillon de la tête d'échantillonnage RMN (201), $D_s$ et $D_{max}$ étant respectivement mesurés perpendiculairement à une direction transversale (QR), la direction transversale (QR) étant perpendiculaire à la direction de base (GR),
et $D_s \leq 0{,}6*D_{max}$,
de manière préférée $D_s \leq 0{,}4*D_{max}$.

**23.** Dispositif de mesure (200) selon l'une quelconque des revendications 20 à 22, **caractérisé en ce que**

la tête d'échantillonnage RMN (201) forme dans le logement d'échantillon (51) un volume actif (52) qui, mesuré dans le plan perpendiculaire à la direction de base (GR), présente une surface de section transversale $A_{aktiv}$, avec $A_{abdeck} \geq 0{,}2*A_{aktiv}$,
de manière préférée avec $A_{abdeck} \geq 0{,}3*A_{aktiv}$,
de manière particulièrement préférée avec $A_{abdeck} \geq 0{,}4*A_{aktiv}$.

**24.** Dispositif de mesure (200) selon l'une quelconque des revendications 20 à 23, **caractérisé en ce que**

la tête d'échantillonnage RMN (201) présente un dispositif d'accord (204a) avec lequel une fréquence de résonance de base BRF d'une résonance propre d'un circuit oscillant électrique de mesure (202) de la bobine HF (50 ; 203) peut être accordée dans une plage comprise entre UF et OF sans l'élément supplémentaire (1) dans le logement d'échantillon (51), UF étant la fréquence accordable la plus basse et OF étant la fréquence accordable la plus élevée et UF<BRF<OF,
la présence du ou des élément(s) de masquage (10 ; 10a, 10b ; 20 ; 20a, 20b ; 30, 40) de l'élément supplémentaire (1) dans le logement d'échantillon (51) de la tête d'échantillonnage RMN (201) augmente la fréquence de résonance du circuit oscillant de mesure (202) par rapport à la fréquence de résonance de base BRF à raison d'un décalage de fréquence FV grâce au déplacement du flux magnétique,
et, lorsque l'élément supplémentaire (1) est inséré dans le logement d'échantillon (51), couple en outre le circuit oscillant de mesure (202) au circuit oscillant électrique (208) que forme l'élément supplémentaire (1), ce qui entraîne une division de la résonance propre du circuit oscillant électrique de mesure (202) en un mode inférieur présentant une fréquence de résonance de mode MRF1 et un mode supérieur présentant une fréquence de résonance de mode MRF2, MRF1 étant réduite par rapport à la fréquence de résonance non couplée du circuit oscillant électrique de mesure (202) à raison d'un décalage de fréquence RF1 et MRF2 étant augmentée par rapport à la fréquence de résonance non couplée à raison d'un décalage de fréquence RF2,
avec MRF1=BRF+FV-RF1 et MRF2=BRF+FV+RF2,
et la tête d'échantillonnage RMN (201) et l'élément supplémentaire (1) sont formés de sorte que,
en particulier un couplage entre le circuit oscillant de mesure (202) et le circuit oscillant électrique (208) et en outre la fréquence de résonance RF du circuit oscillant électrique (208) de l'élément supplémentaire (1) sont conçus de sorte que,

OF-BRF > RF1-FV et
BRF-UF > FV-RF1.

**25.** Utilisation d'un dispositif de mesure 200) selon la revendication 24 pour une mesure RMN,

la tête d'échantillonnage RMN (201) étant agencée dans un champ B0 d'un aimant d'arrière-plan (221), le champ B0 s'étendant dans la région du logement d'échantillon (51) de la tête d'échantillonnage RMN (201) le long d'une direction transversale (QR), la direction transversale (QR) s'étendant perpendiculairement à la direction de base (GR),
un échantillon de mesure (209) étant agencé dans un canal d'échantillon (4a) ou une chambre d'échantillon (5) de l'élément supplémentaire (1) au moins dans la région de la fenêtre de passage (2), un volume VOL de l'échantillon de mesure (209) valant :

$$VOL \leq 100 \ \mu l,$$

de manière préférée $VOL \leq 40 \ \mu l$,

de manière particulièrement préférée VOL ≤ 10 µl,
de la manière la plus préférée VOL ≤ 5 µl,
et une fréquence de résonance de mode MRF1 d'un mode inférieur du circuit oscillant de mesure (202) étant accordée avec le dispositif d'accord (204a) à une fréquence de résonance nucléaire d'un noyau de mesure contenu dans l'échantillon de mesure (209).

Fig. 1

Fig. 2

(a)

(b)

Fig. 3

(a)          (b)

Fig. 4

Fig. 5

Fig. 6

Fig. 7

Fig. 8

Fig. 9

Fig. 10

Fig. 11

Fig. 12

Fig. 13

Fig. 14

Fig.15

Fig. 16

Fig. 17

Fig. 18

Fig. 19

Fig. 20

(a)

(b)

Fig. 21

(a)

(b)    (c)    (d)

Fig. 22

Fig. 23

Fig. 24

Fig. 25

**IN DER BESCHREIBUNG AUFGEFÜHRTE DOKUMENTE**

**In der Beschreibung aufgeführte Patentdokumente**

- US 20200217911 A1
- US 4680549 A
- EP 1707976 A1

**In der Beschreibung aufgeführte Nicht-Patentliteratur**

- **J. P. VALLÉE**. *Fundamentals of Cosmic Physics*, 1998, vol. 19, 319-422